# EUROPEAN PATENT APPLICATION

(11) **EP 4 412 007 A1**
(43) Date of publication of application: **07.08.2024**
(21) Application number: 22875368.7
(22) Date of filing: 18.02.2022
(51) Int. Cl.: H01S 5/183, H01S 5/36, H05B 33/12, H10K 50/00, H05B 33/22, H05B 33/24

(54) **SURFACE LIGHT-EMITTING ELEMENT AND LIGHT SOURCE DEVICE**

(30) Priority: 29.09.2021 JP 2021159421
(71) Applicant: Sony Group Corporation, Tokyo 108-0075 (JP)
(72) Inventor: HAMAGUCHI, Tatsushi, Tokyo 108-0075 (JP); KODA, Rintaro, Tokyo 108-0075 (JP); KEARNS, Jared Alexander, Tokyo 108-0075 (JP); HAYASHI, Kentaro, Tokyo 108-0075 (JP)
(74) Representative: D Young & Co LLP
(86) International application number: PCT/JP2022/006548
(87) International publication number: WO 2023/053484

(57) **Abstract**

Provided is a surface-emitting element in which a configuration can be simplified and an emission wavelength is not restricted by a substrate used at the time of manufacturing.

A surface-emitting element according to the present technology is a surface-emitting element including at least one light emitting element portion that includes at least one organic semiconductor layer and a concave mirror arranged on one side of the organic semiconductor layer. According to the surface-emitting element of the present technology, it is possible to provide a surface-emitting element in which the configuration can simplified and the emission wavelength is not restricted by the substrate used at the time of manufacturing.

## Description

### TECHNICAL FIELD

A technology according to the present disclosure (hereinafter, also referred to as "the present technology") relates to a surface-emitting element and a light source device.

### BACKGROUND ART

In the related art, a surface-emitting element that includes a light emitting layer including an inorganic semiconductor layer and a reflector has been known (see, for example, Patent Document 1).

### CITATION LIST

### PATENT DOCUMENT

Patent Document 1: International Publication No. 2018/083877

### SUMMARY OF THE INVENTION

### PROBLEMS TO BE SOLVED BY THE INVENTION

However, in the surface-emitting element of the related art, a configuration can be simplified, an emission wavelength is restricted by a substrate used at the time of manufacturing.

Therefore, a main object of the present technology is to provide a surface-emitting element in which a configuration can be simplified and an emission wavelength is not restricted by a substrate used at the time of manufacturing.

### SOLUTIONS TO PROBLEMS

The present technology provides a surface-emitting element including at least one light emitting element portion that includes
at least one organic semiconductor layer, and
a concave mirror arranged on one side of the organic semiconductor layer.

The light emitting element portion may further include a reflector arranged on the other side of the organic semiconductor layer.

An interval between the organic semiconductor layer and the concave mirror may be wider than an interval between the organic semiconductor layer and the reflector.

An interval between the organic semiconductor layer and the concave mirror may be narrower than an interval between the organic semiconductor layer and the reflector.

The at least one organic semiconductor layer may include a plurality of organic semiconductor layers having different emission wavelengths.

The at least one organic semiconductor layer may include a plurality of organic semiconductor layers having different volumes.

The at least one organic semiconductor layer may include a plurality of organic semiconductor layers arranged in an in-plane direction.

The at least one organic semiconductor layer may include a plurality of organic semiconductor layers arranged in a stacking direction.

The at least one light emitting element portion may include a plurality of light emitting element portions arranged in an array shape, and the organic semiconductor layers of at least two light emitting element portions among the plurality of light emitting element portions may have different emission wavelengths.

The at least one light emitting element portion may include a plurality of light emitting element portions arranged in an array shape, and the organic semiconductor layers of at least two light emitting element portions among the plurality of light emitting element portions may have different positions in a stacking direction.

The concave mirror may include a metal and/or a dielectric.

The concave mirror and/or the reflector may include a diffraction grating.

The concave mirror may have a structure in which a plurality of dielectric multilayer film reflectors corresponding to a plurality of wavelengths is stacked.

The light emitting element portion may further include an intermediate layer arranged between the organic semiconductor layer and the concave mirror.

The intermediate layer may contain a nitride, an oxide, resin, a semiconductor, or an insulator.

The intermediate layer may have a mesa structure.

The surface-emitting element may further include an active layer that is arranged between the organic semiconductor layer and the concave mirror and/or between the organic semiconductor layer and the reflector, and emits excitation light that excites the organic semiconductor layer.

The light emitting element portion may further include a transparent conductive film arranged between the reflector and the organic semiconductor layer and/or between the concave mirror and the organic semiconductor layer.

The at least one light emitting element portion may include a plurality of light emitting element portions arranged in an array shape.

The present technology also provides a light source device including the surface-emitting element and a driver that drives the light emitting element portion.

The present technology also provides a light source device including the surface-emitting element including the plurality of light emitting element portions, and drivers that individually drives the plurality of light emitting element portions.

### BRIEF DESCRIPTION OF DRAWINGS

Fig. 1 is a sectional view of a surface-emitting element according to Example 1 of the embodiment of the present technology.
Fig. 2 is a flowchart for describing an example of a method for manufacturing the surface-emitting element in Fig. 1.
Figs. 3A and 3B are sectional views for each process of the method for manufacturing the surface-emitting element in Fig. 1.
Figs. 4A and 4B are sectional views for each process of the method for manufacturing the surface-emitting element in Fig. 1.
Figs. 5A and 5B are sectional views for each process of the method for manufacturing the surface-emitting element in Fig. 1.
Fig. 6 is a sectional view for each process of the method for manufacturing the surface-emitting element in Fig. 1.
Fig. 7 is a diagram illustrating emission spectra of VCSEL, DFB laser, LED, and OLED in the related art.
Fig. 8 is a diagram illustrating that a resonant mode of the surface-emitting element according to an embodiment can be present in any wavelength range.
Fig. 9 is a sectional view of a surface-emitting element according to Example 2 of the embodiment of the present technology.
Fig. 10 is a sectional view of a surface-emitting element according to Example 3 of the embodiment of the present technology.
Fig. 11 is a sectional view of a surface-emitting element according to Example 4 of the embodiment of the present technology.
Fig. 12 is a flowchart for describing an example of a method for manufacturing the surface-emitting element in Fig. 11.
Figs. 13A and 13B are sectional views for each process of the method for manufacturing the surface-emitting element in Fig. 11.
Figs. 14A and 14B are sectional views for each process of the method for manufacturing the surface-emitting element in Fig. 11.
Figs. 15A and 15B are sectional views for each process of the method for manufacturing the surface-emitting element in Fig. 11.
Fig. 16 is a sectional view of a surface-emitting element according to Example 5 of the embodiment of the present technology.
Fig. 17 is a diagram illustrating a stacked structure of composite DBR.
Fig. 18 is a sectional view of a surface-emitting element according to Example 6 of the embodiment of the present technology.
Fig. 19 is a flowchart for describing an example of a method for manufacturing the surface-emitting element in Fig. 18.
Figs. 20A and 20B are sectional views for each process of the method for manufacturing the surface-emitting element in Fig. 18.
Figs. 21A and 21B are sectional views for each process of the method for manufacturing the surface-emitting element in Fig. 18.
Figs. 22A and 22B are sectional views for each process of the method for manufacturing the surface-emitting element in Fig. 18.
Figs. 23A and 23B are sectional views for each process of the method for manufacturing the surface-emitting element in Fig. 18.
Fig. 24 is a sectional view for each process of the method of manufacturing the surface-emitting element in Fig. 18.
Fig. 25 is a sectional view of a surface-emitting element according to Example 7 of the embodiment of the present technology.
Fig. 26 is a flowchart for describing an example of a method for manufacturing the surface-emitting element in Fig. 25.
Figs. 27A to 27C are sectional views for each process of the method for manufacturing the surface-emitting element in Fig. 25.
Figs. 28A and 28B are sectional views for each process of the method for manufacturing the surface-emitting element in Fig. 25.
Figs. 29A and 29B are sectional views for each process of the method for manufacturing the surface-emitting element in Fig. 25.
Fig. 30A is a plan view of a surface-emitting element according to Example 8 of the embodiment of the present technology. Fig. 30B is a sectional view of the surface-emitting element according to Example 8 of the embodiment of the present technology.
Fig. 31 is a flowchart for describing an example of a method for manufacturing the surface-emitting element in Fig. 30.
Figs. 32A and 32B are sectional views for each process of the method for manufacturing the surface-emitting element in Fig. 30.
Figs. 33A and 33B are sectional views for each process of the method for manufacturing the surface-emitting element in Fig. 30.
Fig. 34A is a plan view of a surface-emitting element according to Example 9 of the embodiment of the present technology. Fig. 34B is a sectional view of the surface-emitting element according to Example 9 of the embodiment of the present technology.
Fig. 35A is a plan view of a surface-emitting element according to Example 10 of the embodiment of the present technology. Fig. 35B is a sectional view of the surface-emitting element according to Example 10 of the embodiment of the present technology.
Fig. 36A is a plan view of a surface-emitting element according to Example 11 of the embodiment of the present technology. Fig. 36B is a sectional view of the surface-emitting element according to Example 11 of the embodiment of the present technology.
Fig. 37 is a sectional view of a surface-emitting element according to Example 12 of the embodiment of the present technology.
Fig. 38 is a flowchart for describing an example of a method for manufacturing the surface-emitting element in Fig. 37.
Figs. 39A and 39B are sectional views for each process of the method for manufacturing the surface-emitting element in Fig. 37.
Figs. 40A to 40C are sectional views for each process of the method for manufacturing the surface-emitting element in Fig. 37.
Figs. 41A and 41B are sectional views for each process of the method for manufacturing the surface-emitting element in Fig. 37.
Fig. 42 is a sectional view of a surface-emitting element according to Example 13 of the embodiment of the present technology.
Fig. 43 is a flowchart for describing a first example of a method for manufacturing the surface-emitting element in Fig. 42.
Figs. 44A and 44B are sectional views for each process of the first example of the method of manufacturing the surface-emitting element in Fig. 42.
Figs. 45A and 45B are sectional views for each process of the first example of the method of manufacturing the surface-emitting element in Fig. 42.
Fig. 46 is a sectional view for each process of the first example of the method of manufacturing the surface-emitting element in Fig. 42.
Fig. 47 is a flowchart for describing a second example of the method for manufacturing the surface-emitting element in Fig. 42.
Figs. 48A and 48B are sectional views for each process of the second example of the method of manufacturing the surface-emitting element in Fig. 42.
Fig. 49 is a flowchart for describing a third example of the method for manufacturing the surface-emitting element in Fig. 42.
Figs. 50A to 50C are sectional views for each process of the third example of the method for manufacturing the surface-emitting element in Fig. 42.
Fig. 51 is a sectional view for each process of the third example of the method of manufacturing the surface-emitting element in Fig. 42.
Fig. 52 is a sectional view of a surface-emitting element according to Example 14 of the embodiment of the present technology.
Fig. 53 is a sectional view of a surface-emitting element according to Example 15 of the embodiment of the present technology.
Fig. 54 is a flowchart for describing an example of the method for manufacturing the surface-emitting element in Fig. 53.
Figs. 55A and 55B are sectional views for each process of the method for manufacturing the surface-emitting element in Fig. 53.
Fig. 56 is a sectional view for each process of the method of manufacturing the surface-emitting element in Fig. 53.
Fig. 57 is a sectional view of a surface-emitting element according to Example 16 of the embodiment of the present technology.
Fig. 58 is a sectional view of a surface-emitting element according to Example 17 of the embodiment of the present technology.
Fig. 59 is a flowchart for describing an example of a method for manufacturing the surface-emitting element in Fig. 58.
Figs. 60A and 60B are sectional views for each process of the method for manufacturing the surface-emitting element in Fig. 58.
Figs. 61A and 61B are sectional views for each process of the method for manufacturing the surface-emitting element in Fig. 58.
Fig. 62 is a sectional view of a surface-emitting element according to Example 18 of the embodiment of the present technology.
Fig. 63 is a sectional view of a surface-emitting element according to Example 19 of the embodiment of the present technology.
Fig. 64A is a plan view of a surface-emitting element according to Example 20 of the embodiment of the present technology. Fig. 64B is a sectional view of the surface-emitting element according to Example 20 of the embodiment of the present technology.
Fig. 65A is a plan view of a surface-emitting element according to Example 21 of the embodiment of the present technology. Fig. 65B is a sectional view of the surface-emitting element according to Example 21 of the embodiment of the present technology.
Fig. 66 is a sectional view of a surface-emitting element according to Example 22 of the embodiment of the present technology.
Fig. 67 is a flowchart for describing an example of a method for manufacturing the surface-emitting element in Fig. 66.
Figs. 68A to 68C are sectional views for each process of the method for manufacturing the surface-emitting element in Fig. 66.
Figs. 69A to 69C are sectional views for each process of the method for manufacturing the surface-emitting element in Fig. 66.
Fig. 70A is a plan view of a surface-emitting element according to Example 23 of the embodiment of the present technology. Fig. 70B is a sectional view of the surface-emitting element according to Example 23 of the embodiment of the present technology.
Fig. 71 is a flowchart for describing an example of a method for manufacturing the surface-emitting element in Fig. 70.
Figs. 72A and 72B are sectional views for each process of the method for manufacturing the surface-emitting element in Fig. 70.
Figs. 73A and 73B are sectional views for each process of the method for manufacturing the surface-emitting element in Fig. 70.
Figs. 74A and 74B are sectional views for each process of the method for manufacturing the surface-emitting element in Fig. 70.
Figs. 75A and 75B are sectional views for each process of the method for manufacturing the surface-emitting element in Fig. 70.
Figs. 76A and 76B are sectional views for each process of the method for manufacturing the surface-emitting element in Fig. 70.
Fig. 77A is a plan view of a surface-emitting element according to Example 24 of the embodiment of the present technology. Fig. 77B is a sectional view of the surface-emitting element according to Example 24 of the embodiment of the present technology.
Fig. 78A is a plan view of a surface-emitting element according to Example 25 of the embodiment of the present technology. Fig. 78B is a sectional view of the surface-emitting element according to Example 25 of the embodiment of the present technology.
Fig. 79A is a plan view of a surface-emitting element according to Example 26 of the embodiment of the present technology. Fig. 79B is a sectional view of the surface-emitting element according to Example 26 of the embodiment of the present technology.
Fig. 80A is a plan view of a surface-emitting element according to Example 27 of the embodiment of the present technology. Fig. 80B is a sectional view of the surface-emitting element according to Example 27 of the embodiment of the present technology.
Fig. 81A is a plan view of a surface-emitting element according to Example 28 of the embodiment of the present technology. Fig. 81B is a sectional view of the surface-emitting element according to Example 28 of the embodiment of the present technology.
Fig. 82 is a sectional view of a surface-emitting element according to Example 29 of the embodiment of the present technology.
Fig. 83 is a flowchart for describing an example of a method for manufacturing the surface-emitting element in Fig. 82.
Figs. 84A and 84B are sectional views for each process of the method for manufacturing the surface-emitting element in Fig. 82.
Figs. 85A and 85B are sectional views for each process of the method for manufacturing the surface-emitting element in Fig. 82.
Figs. 86A and 86B are sectional views for each process of the method for manufacturing the surface-emitting element in Fig. 82.
Fig. 87A is a sectional view of a surface-emitting element according to Example 30 of the embodiment of the present technology. Fig. 87B is a schematic plan view of the surface-emitting element according to Example 30 of the embodiment of the present technology.
Figs. 88A to 88H are diagrams illustrating specific examples of a shape of an organic semiconductor layer in plan view.
Figs. 89A to 89I are diagrams illustrating specific examples of the shape of the organic semiconductor layer in plan view.
Figs. 90A to 90H are diagrams illustrating specific examples of a sectional shape of the organic semiconductor layer.
Fig. 91 is a sectional view of a surface-emitting element according to a modification.
Fig. 92 is a diagram illustrating an example in which a light source device having the surface-emitting element according to the present technology is applied to a distance measuring device.
Fig. 93 is a block diagram illustrating an example of a schematic configuration of a vehicle control system.
Fig. 94 is an explanatory diagram illustrating an example of an installation position of the distance measuring device.

### MODE FOR CARRYING OUT THE INVENTION

Hereinafter, a preferred embodiment of the present technology will be described in detail with reference to the accompanying drawings. Note that, in the present specification and the drawings, components having substantially the same functional configurations are denoted by the same reference signs, and redundant descriptions are omitted. The embodiment to be described below provide a representative embodiment of the present technology, and the scope of the present technology is not to be narrowly interpreted according to the embodiment. In the present specification, even in a case where it is described that a surface-emitting element and a light source device according to the present technology obtains a plurality of effects, it suffices that the surface-emitting element and the light source device according to the present technology obtains at least one effect. The effects described in the present specification are merely examples and are not limited, and other effects may be provided.

Furthermore, the description will be given in the following order.
0. Introduction
1. Surface-emitting Element according to Example 1 of Embodiment of Present Technology
2. Surface-emitting Element according to Example 2 of Embodiment of Present Technology
3. Surface-emitting Element according to Example 3 of Embodiment of Present Technology
4. Surface-emitting Element according to Example 4 of Embodiment of Present Technology
5. Surface-emitting Element according to Example 5 of Embodiment of Present Technology
6. Surface-emitting Element according to Example 6 of Embodiment of Present Technology
7. Surface-emitting Element according to Example 7 of Embodiment of Present Technology
8. Surface-emitting Element according to Example 8 of Embodiment of Present Technology
9. Surface-emitting Element according to Example 9 of Embodiment of Present Technology
10. Surface-emitting Element according to Example 10 of Embodiment of Present Technology
11. Surface-emitting Element according to Example 11 of Embodiment of Present Technology
12. Surface-emitting Element according to Example 12 of Embodiment of Present Technology
13. Surface-emitting Element according to Example 13 of Embodiment of Present Technology
14. Surface-emitting Element according to Example 14 of Embodiment of Present Technology
15. Surface-emitting Element according to Example 15 of Embodiment of Present Technology
16. Surface-emitting Element according to Example 16 of Embodiment of Present Technology
17. Surface-emitting Element according to Example 17 of Embodiment of Present Technology
18. Surface-emitting Element according to Example 18 of Embodiment of Present Technology
19. Surface-emitting Element according to Example 19 of Embodiment of Present Technology
20. Surface-emitting Element according to Example 20 of Embodiment of Present Technology
21. Surface-emitting Element according to Example 21 of Embodiment of Present Technology
22. Surface-emitting Element according to Example 22 of Embodiment of Present Technology
23. Surface-emitting Element according to Example 23 of Embodiment of Present Technology
24. Surface-emitting Element according to Example 24 of Embodiment of Present Technology
25. Surface-emitting Element according to Example 25 of Embodiment of Present Technology
26. Surface-emitting Element according to Example 26 of Embodiment of Present Technology
27. Surface-emitting Element according to Example 27 of Embodiment of Present Technology
28. Surface-emitting Element according to Example 28 of Embodiment of Present Technology
29. Surface-emitting Element according to Example 29 of Embodiment of Present Technology
30. Surface-emitting Element according to Example 30 of Embodiment of Present Technology
31. Modification of present technology
32. Application Example to Electronic Device
33. Example in which Light Source Device having Surface-Emitting Element is applied to Distance Measuring Device
34. Example in which Distance Measuring Device is Mounted on Mobile Body

### 0. Introduction

In the related art, although various semiconductor lasers have been known, in particular, in a case where a base material of an inorganic semiconductor laser as a light emitting element (inorganic light emitting element) using an inorganic semiconductor is not a single crystal, it is difficult to fabricate the inorganic semiconductor laser due to deterioration in electrical and optical characteristics and the like caused by crystal defects. Thus, in the inorganic semiconductor laser, it is common to select a substrate having a suitable grating constant for every emission wavelength and form a semiconductor laser having a desired emission wavelength with a single crystal. That is, there is a restriction that the emission wavelength is defined by the substrate.

On the other hand, an organic semiconductor laser as a light emitting element (organic light emitting element) using an organic semiconductor can emit light and oscillate at various wavelengths as represented by a dye laser. However, in the light emitting element using the organic semiconductor, although light emission by current injection has been achieved in an LED, laser oscillation by current injection has not been realized for many years. In 2018, the laser oscillation of the organic semiconductor laser by the current injection was confirmed for the first time from KYUSHU UNIVERSITY.

In a device structure of the organic semiconductor laser, light emitters are usually arranged in a flat manner mainly on a glass substrate or on, for example, a very limited plane on a semiconductor substrate such as a silicon substrate. For example, an approach in which a grating structure is formed on a substrate front surface and oscillation is caused by resonance in a substrate in-plane direction has been reported. Although this method is a simple and excellent method for confirming an initial operation of the organic semiconductor laser, there are some difficulties in mass production and practical application. For example, in a case where the resonance is caused in the substrate in-plane direction in the organic semiconductor laser, since light leaks in a lateral direction, optical crosstalk (mutual noise due to leakage of light) occurs between adjacent elements. In addition, since a size in the substrate in-plane direction increases, it is difficult to form a dense array. Moreover, although a Q-value of a resonator can be improved by increasing a total number of lines of a grating, that is, a threshold current of the laser can be reduced, at this time, there is a trade-off that the element becomes larger in the lateral direction. Furthermore, since an interval of the grating is required to be equal to or less than a wavelength, it is difficult to produce the grating. For example, it is necessary to use an exposure machine such as an EB exposure machine that has a poor throughput, is expensive, and is difficult to pattern a large area.

Furthermore, in the organic semiconductor laser, since a wavelength of light circulating through the resonator is limited to a specific wavelength, in a case where the organic semiconductor laser is combined with an organic semiconductor film having a wide light emission region, there is a problem that only light having a wavelength within a specific wavelength range can contribute to laser oscillation. Furthermore, there are many cases where the organic semiconductor deteriorates due to overheating, and as a configuration of the element, in a production process after the organic semiconductor film is formed, it has been recommended to set a maximum attainment temperature to 100°C or lower.

Therefore, the inventors have intensively studied in view of the above problems, have found that it is possible to theoretically fabricate a laser that resonates in a vertical direction (stacking direction) by combining an organic semiconductor layer and a concave mirror, and have developed a surface-emitting element according to an embodiment of the present technology as a surface-emitting element in which this finding is sublimated to a practical level. Hereinafter, preferred examples of the surface-emitting element according to the embodiment of the present technology will be described in detail.

### <1. Surface-emitting Element according to Example 1 of Embodiment of Present Technology>

Hereinafter, a surface-emitting element according to Example 1 of the embodiment of the present technology will be described with reference to the drawings.

### <<Configuration of Surface-emitting Element>>

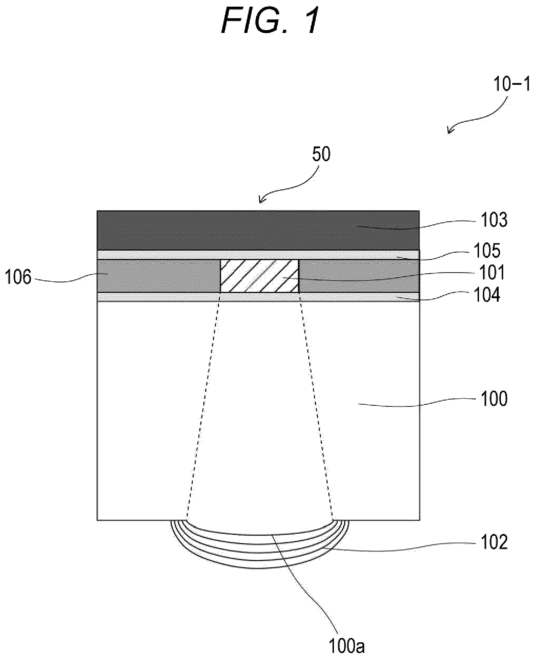

Fig. 1 is a sectional view of a surface-emitting element 10-1 according to Example 1 of the embodiment of the present technology. Hereinafter, for the sake of convenience, an upper part in the sectional view of Fig. 1 and the like will be described as an upper side, and a lower part in the sectional view of Fig. 1 and the like will be described as a lower side.

As will be specifically described below, the surface-emitting element 10-1 is a vertical-cavity surface-emitting laser (VCSEL) in which an organic semiconductor layer that emits light is sandwiched between first and second reflectors.

As an example, as illustrated in Fig. 1, the surface-emitting element 10-1 includes at least one light emitting element portion 50 that includes at least one organic semiconductor layer 101 and a concave mirror 102 arranged on one side (lower side) of the organic semiconductor layer 101. That is, in the surface-emitting element 10-1, the light emitting element portion 50 may be formed as a single surface-emitting laser, or may be formed as a surface-emitting laser array in which a plurality of light emitting element portions 50 is arranged in an array shape (for example, one-dimensional disposition or two-dimensional disposition).

As an example, the light emitting element portion 50 further includes a reflector 103 arranged on the other side (upper side) of the organic semiconductor layer 101. That is, the light emitting element portion 50 has a vertical resonator structure in which the organic semiconductor layer 101 is arranged between the concave mirror 102 and the reflector 103.

As an example, the light emitting element portion 50 further includes an intermediate layer 100 arranged between the organic semiconductor layer 101 and the concave mirror 102. A convex surface 100a (specifically, a convex curved surface) is provided on a surface on one side (lower side) of the intermediate layer 100, and the concave mirror 102 is provided along the convex surface 100a.

As an example, the light emitting element portion 50 further includes a first transparent conductive film 104 arranged between the concave mirror 102 and the organic semiconductor layer 101. More specifically, the first transparent conductive film 104 is arranged between the intermediate layer 100 and the organic semiconductor layer 101.

As an example, the light emitting element portion 50 further includes a second transparent conductive film 105 arranged between the reflector 103 and the organic semiconductor layer 101. That is, the organic semiconductor layer 101 is positioned between the first and second transparent conductive films 104 and 105.

As an example, the light emitting element portion 50 further includes a high resistance layer 106 surrounding the organic semiconductor layer 101 between the first and second transparent conductive films 104 and 105.

### (Reflector)

As an example, the reflector 103 functions as a first reflector of the surface-emitting element 10-1. As an example, the reflector 103 is a plane mirror. Note that, the reflector 103 may be a concave mirror.

The reflector 103 has a structure including, for example, a metal, an alloy, a dielectric, or a semiconductor.

In a case where the reflector 103 includes a conductor such as metal or alloy, the reflector can also function as an anode electrode. In this case, as an example, the reflector 103 is connected to an anode (positive electrode) of a laser driver. Note that, in a case where the reflector 103 includes a metal or an alloy, at least a part of the reflector 103 is preferably covered with a protective film (passivation film) made of, for example, SiO₂ or the like.

As an example of a case where the reflector 103 includes a metal or an alloy, for example, Ag, Al, Mg, Au, Rh, or the like can be used as a material.

As an example of a case where the reflector 103 includes a dielectric, for example, a dielectric multilayer film reflector having a pair of refractive index layers such as Ta₂O₅/SiO₂ and SiN/SiO₂ can be used. Note that, in a case where the reflector 103 includes a dielectric, the second transparent conductive film 105 can function as the anode electrode.

As an example of a case where the reflector 103 includes a semiconductor, for example, a semiconductor multilayer film reflector having a pair of refractive index layers such as AlInN/GaN, AlN/GaN, and AlAs/GaAs can be used. Note that, in a case where the reflector 103 includes a semiconductor, the second transparent conductive film 105 can also function as the anode electrode.

### (First Transparent Conductive Film)

As an example, the first transparent conductive film 104 can function as a cathode electrode. In this case, as an example, the first transparent conductive film 104 is connected to a cathode (negative electrode) of the laser driver. The first transparent conductive film 104 includes, for example, ITO, IZO, IGZO, ITiO, graphene, or the like.

### (Second Transparent Conductive Film)

The second transparent conductive film 105 functions as a buffer layer that enhances hole injection efficiency into the organic semiconductor layer 101 and prevents leakage. The second transparent conductive film 105 can function as the anode electrode instead of the reflector 103. In this case, as an example, the second transparent conductive film 105 is connected to an anode (positive electrode) of the laser driver. The second transparent conductive film 105 includes, for example, ITO, IZO, IGZO, ITiO, graphene, or the like.

### (Concave Mirror)

As an example, the concave mirror 102 functions as the second reflector of the surface-emitting element 10-1. Even though a resonator length is increased, a concave mirror having a positive power is used as the second reflector, and thus, light emitted from the organic semiconductor layer 101 and light through the organic semiconductor layer 101 can be condensed on the organic semiconductor layer 101. As a result, a gain necessary for laser oscillation can be obtained by a light amplifying action of the organic semiconductor layer 101.

A reflectance of the concave mirror 102 is set to be slightly lower than a reflectance of the reflector 103. That is, the concave mirror 102 is a reflector on an emission side.

As an example, the concave mirror 102 includes a dielectric or a semiconductor. Note that, the concave mirror 102 can also include a metal or an alloy. In this case, the reflector 103 preferably includes a dielectric or a semiconductor, and is a reflector on the emission side. Note that, in a case where the concave mirror 102 includes a metal or an alloy, at least a part of the concave mirror 102 is preferably covered with a protective film including, for example, SiO₂ or the like.

As an example of a case where the concave mirror 102 includes a dielectric, the concave mirror can be a dielectric multilayer film reflector. The dielectric multilayer film reflector includes, for example, Ta₂O₅/SiO₂, SiN/SiO₂, or the like.

It is known that a ratio of a stop bandwidth to a refractive index ratio of the pair of refractive index layers (for example, AlInN/GaN, AlN/GaN, AlAs/GaAs, SiN/SiO₂, or Ta₂O₅/SiO₂) constituting the multilayer film reflector sequentially increases in the order of AlInN/GaN, AlN/GaN, AlAs/GaAs, SiN/SiO₂, and Ta₂O₅/SiO₂. In particular, since the dielectric multilayer film reflector having a pair of Ta₂O₅/SiO₂, SiN/SiO₂, or the like has a large ratio, a desired reflectance can be obtained even though a film thickness slightly varies. That is, the dielectric multilayer film reflector is excellent in robustness with respect to film thickness control.

It is known that, among the pairs of refractive index layers (for example, AlInN/GaN, AlN/GaN, AlAs/GaAs, SiN/SiO₂, and Ta₂O₅/SiO₂) constituting the multilayer film reflector, in particular, a dielectric multilayer film reflector having a pair of Ta₂O₅/SiO₂, SiN/SiO₂, or the like can obtain a high reflectance with a small number of pairs. That is, the dielectric multilayer film reflector can be manufactured in a short time and can be thinned while obtaining a high reflectance.

As an example of a case where the concave mirror includes a semiconductor, the concave mirror 102 can be a semiconductor multilayer film reflector having a pair of refractive index layers such as AlInN/GaN, AlN/GaN, or AlAs/GaAs.

Note that, in a case where the reflector 103 includes, for example, a dielectric or a semiconductor to become a reflector on the emission side, the concave mirror 102 can also include a metal or an alloy. In this case, for example, a metal material such as Ag, Al, Mg, Au, or Rh can be used for concave mirror 102.

### (Organic Semiconductor Layer)

A positional relationship between the organic semiconductor layer 101 and the concave mirror 102 is set such that the whole organic semiconductor layer 101 falls within a condensing range of light from the concave mirror 102. The organic semiconductor layer 101 has, for example, a rectangular sectional shape, but may have another shape. The organic semiconductor layer 101 has, for example, a circular shape, a polygonal shape, or the like in plan view, but may have another shape.

The organic semiconductor layer 101 is a layer that emits light by recombination of holes supplied from the anode electrode and electrons supplied from the cathode electrode.

An organic semiconductor material generally used for an organic light emitting diode (OLED) can be used for the organic semiconductor layer 101. As an example, the organic semiconductor layer 101 has a structure in which a hole transport layer, a light emitting layer, and an electron transport layer are stacked in this order from the second transparent conductive film 105 side to the first transparent conductive film 104 side. Note that, the organic semiconductor layer 101 may have a structure in which a hole transport layer, a light emitting layer, and an electron transport layer are stacked in this order from the first transparent conductive film 104 side to the second transparent conductive film 105 side. In this case, the first transparent conductive film 104 side is an anode side, and the second transparent conductive film 105 side is a cathode side.

The light emitting layer emits light having a predetermined wavelength (emission wavelength λ) in accordance with a material of the light emitting layer by the recombination of the electrons and the holes. The light emitting layer emits, for example, any of red light, green light, and blue light.

A lateral width (width in an in-plane direction) of the organic semiconductor layer 101 can be, for example, 1 um or more and less than 4 µm, or can be, for example, 4 um or more. Here, the lateral width of the organic semiconductor layer 101 is, for example, 1 to 4 µm.

A thickness of the light emitting layer can be, for example, less than 20 nm, can be, for example, 20 nm or more and less than 300 nm, can be, for example, 30 nm or more and less than 300 nm, or can be 300 nm or more.

Examples of the material of the light emitting layer include BSBCz(4,4'-bis[(N-carbazole) styryl]biphenyl, a polyfluorene polymer derivative, a (poly)paraphenylene vinylene derivative, a polyphenylene derivative, a polyvinylcarbazole derivative, a polythiophene derivative, a perylene dye, a coumarin dye, a rhodamine dye, and materials obtained by doping these polymers with an organic EL material. Note that, the light emitting layer may also serve as a hole transport layer and/or an electron transport layer.

The hole transport layer is provided for enhancing hole transport efficiency to the light emitting layer. The electron transport layer is provided for enhancing electron transport efficiency to the light emitting layer.

A thickness of each of the hole transport layer and the electron transport layer can be, for example, 100 nm, thinner than 100 nm, or thicker than 100 nm.

Note that, the organic semiconductor layer 101 may include only the light emitting layer. In this case, the second transparent conductive film 105 can also substantially function as the hole transport layer, and the first transparent conductive film 104 can also substantially function as the electron transport layer.

### (Intermediate Layer)

The intermediate layer 100 is formed as a single layer as an example, but may be formed as a plurality of layers.

The intermediate layer 100 includes, for example, a nitride (for example, SiN or SiON), an oxide (for example, SiO₂, AlOx, or Al₂O₃), a semiconductor (for example, GaN, AlN, GaAs, or InP), silicon, diamond, resin, or the like.

A thickness of the intermediate layer 100 can be, for example, less than 10 um, 10 um or more and less than 20 um, 20 um or more and less than 100 um, or 100 um or more.

Here, as an example, the thickness of the intermediate layer 100 and/or the power of the concave mirror 102 are set such that a condensing position (beam waist position) of the light reflected by the concave mirror 102 is positioned in the organic semiconductor layer 101 or on the reflector 103 side (upper side) of the organic semiconductor layer 101.

The intermediate layer 100 preferably has high heat dissipation in order to suppress transfer of heat generated in a concave mirror forming process at the time of driving and manufacturing the surface-emitting element 10-1 to be described later to the organic semiconductor layer 101.

It is known that the longer the resonator length, the lower a thermal resistance of the element. That is, from the viewpoint of heat dissipation, the thicker the intermediate layer, the lower the thermal resistance of the element and the higher the heat dissipation. For example, GaN (thermal conductivity: 130 W/mK) is used for the intermediate layer 100, and thus, the heat dissipation can be remarkably enhanced. Furthermore, similarly, in order to enhance the heat dissipation, a diamond substrate (thermal conductivity: 220 W/mK), a silicon substrate (thermal conductivity: 148 W/mK), a sapphire substrate (thermal conductivity: 46 W/mK), or the like may be used for the intermediate layer 100.

An interval between the organic semiconductor layer 101 and the concave mirror 102 is wider than an interval (including 0) between the organic semiconductor layer 101 and the reflector 103. That is, a total thickness of the first transparent conductive film 104 and the intermediate layer 100 is larger than a thickness of the second transparent conductive film 105. As described above, in the surface-emitting element 10-1, the interval between the organic semiconductor layer 101 and the concave mirror 102 can be increased by disposing the organic semiconductor layer 101 at a position close to the reflector 103 between the concave mirror 102 and the reflector 103, and an influence of the heat generated in the concave mirror forming process on the organic semiconductor layer 101 can be reduced.

### (High Resistance Layer)

The high resistance layer 106 is a layer having a higher electric resistance than the organic semiconductor layer 101, and functions as a current confinement portion that confines a current in the organic semiconductor layer 101. The high resistance layer 106 includes, for example, an insulator such as SiO₂, SiN, SiON, an epoxy resin, or polyimide, or an intrinsic semiconductor such as silicon or germanium. Note that, the high resistance layer 106 can also function as an optical confinement portion that performs optical confinement to the organic semiconductor layer 101 by using a material having a refractive index lower than that of the organic semiconductor layer 101.

### <<Operation of Surface-emitting Element>>

Hereinafter, an operation of the surface-emitting element 10-1 will be described.

In the surface-emitting element 10-1, when a drive voltage is applied between the anode electrode and the cathode electrode by the laser driver, a current flowing into the reflector 103 from the anode side of the laser driver is injected into the organic semiconductor layer 101 via the second transparent conductive film 105. At this time, when the organic semiconductor layer 101 is excited by the current and emits light and the light reciprocates between the concave mirror 102 and the reflector 103 while being amplified by the organic semiconductor layer 101 (at this time, the light is reflected while being condensed near the organic semiconductor layer 101 by the concave mirror 102 and is reflected as parallel light or weak diffusion light toward the organic semiconductor layer 101 by the reflector 103), that is, resonates in a stacking direction, and is emitted as laser light from the concave mirror 102 when an oscillation condition is satisfied. The current injected into the organic semiconductor layer 101 flows out from the cathode electrode to the cathode side of the laser driver.

Note that, for example, even in a case where the surface-emitting element 10-1 is continuously driven for a long time, a temperature rise of the element can be suppressed by a heat dissipation function of the intermediate layer 100, and a stable operation can be performed.

### <<Method for Manufacturing Surface-emitting Element>>

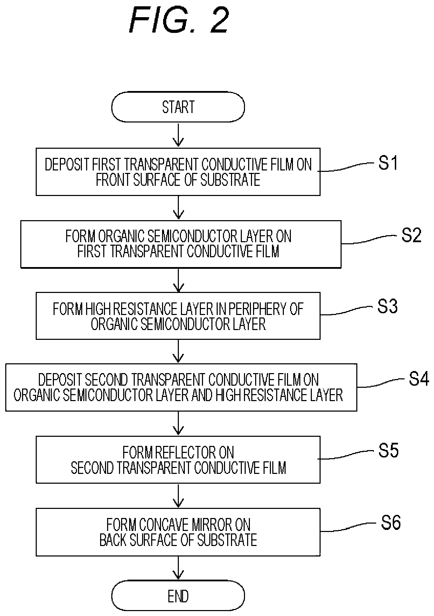

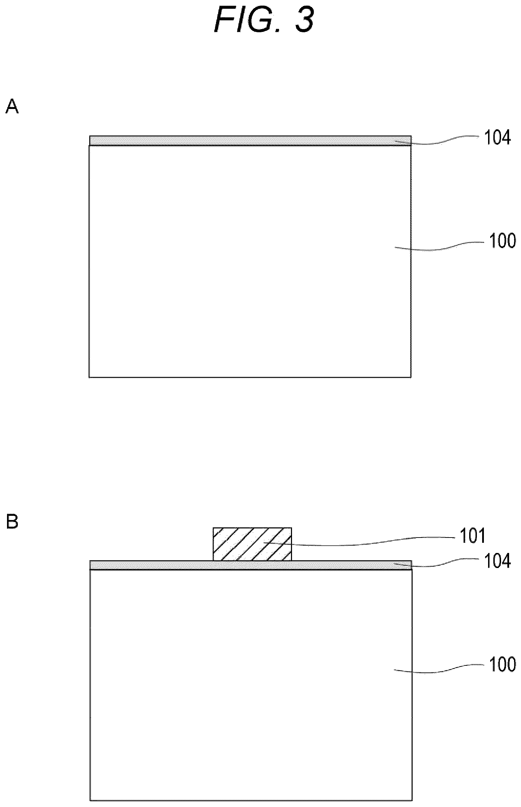

Hereinafter, a method for manufacturing the surface-emitting element 10-1 will be described with reference to a flowchart (steps S1 to S6) in Fig. 2 and sectional views of Figs. 3A to 6. Here, as an example, a plurality of surface-emitting elements 10-1 is simultaneously generated on one wafer (for example, GaN substrate) to become a base material of the intermediate layer 100. Subsequently, the plurality of surface-emitting elements 10-1 integrated in series is separated from each other to obtain chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-1 is two-dimensionally arranged on one wafer (for example, GaN substrate) to become the base material of the intermediate layer 100 and separating a plurality of integrated surface-emitting element arrays integrated in series from each other.

In first step S1, the first transparent conductive film 104 is stacked on the front surface (upper surface) of the substrate (wafer) to become the intermediate layer 100. Specifically, the first transparent conductive film 104 is deposited on the front surface of the wafer (for example, GaN substrate) to become the intermediate layer 100 by, for example, a vacuum vapor deposition method, a sputtering method, a chemical vapor deposition (CVD) method, or the like (see Fig. 3A).

In next step S2, the organic semiconductor layer 101 is formed on the first transparent conductive film 104. Specifically, first, an organic semiconductor film to become the organic semiconductor layer 101 is solidly deposited on the first transparent conductive film 104 by, for example, vacuum vapor deposition, coating, or the like. Subsequently, a resist pattern covering a portion of the organic semiconductor film to become the organic semiconductor layer 101 includes, for example, a metal material, patterning is performed by etching the organic semiconductor film by using the resist pattern as a mask, and the organic semiconductor layer 101 is formed (see Fig. 3B).

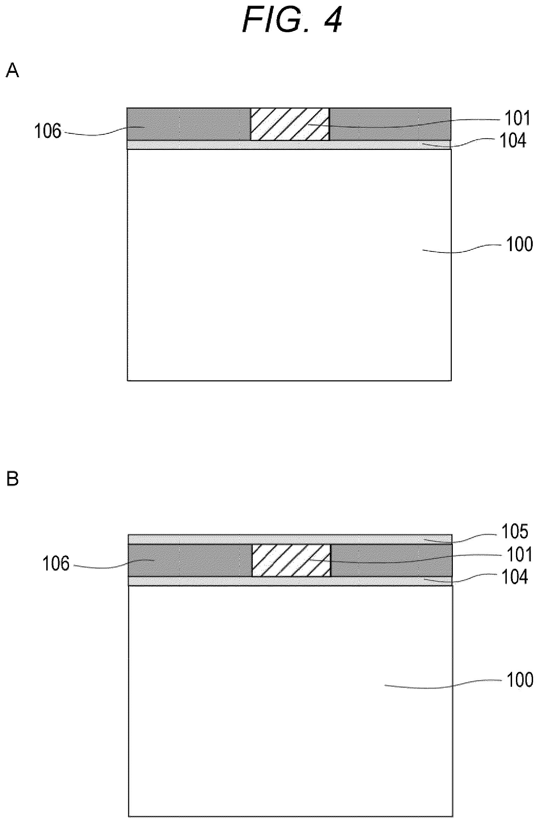

In next step S3, the high resistance layer 106 is formed in a periphery of the organic semiconductor layer 101. Specifically, a high resistance material to become the high resistance layer 106 is deposited to cover the organic semiconductor layer 101 and the first transparent conductive film 104. Subsequently, a resist pattern opened at a position corresponding to a portion covering the organic semiconductor 101 including the above material is formed, and then the material is etched by using the resist pattern as a mask to expose the organic semiconductor layer 101 (see Fig. 4A).

In next step S4, the second transparent conductive film 105 is deposited on the organic semiconductor layer 101 and the high resistance layer 106. Specifically, the second transparent conductive film 105 is deposited on the organic semiconductor layer 101 and the high resistance layer 106 by, for example, a vacuum vapor deposition method, sputtering, or the like (see Fig. 4B).

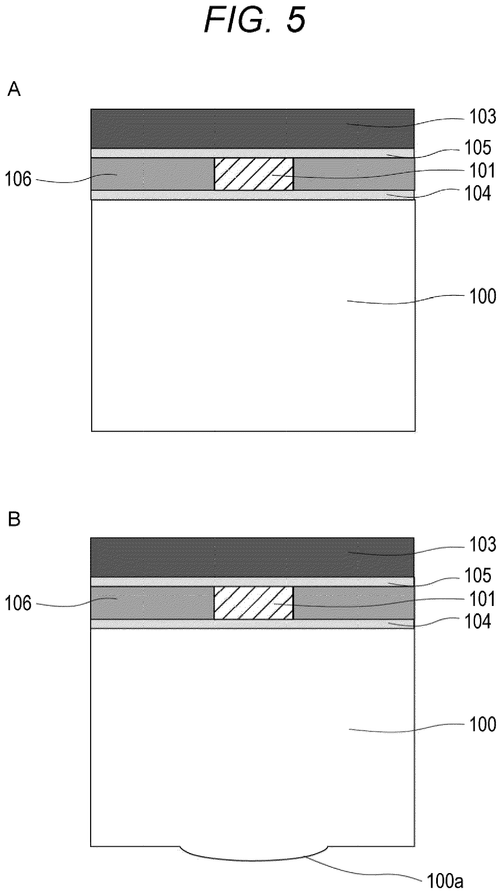

In next step S5, the reflector 103 is formed on the second transparent conductive film 105. Specifically, the material of the reflector 103 is deposited on the second transparent conductive film 105 by, for example, a vacuum vapor deposition method, a sputtering method, a CVD method, or the like (see Fig. 5A).

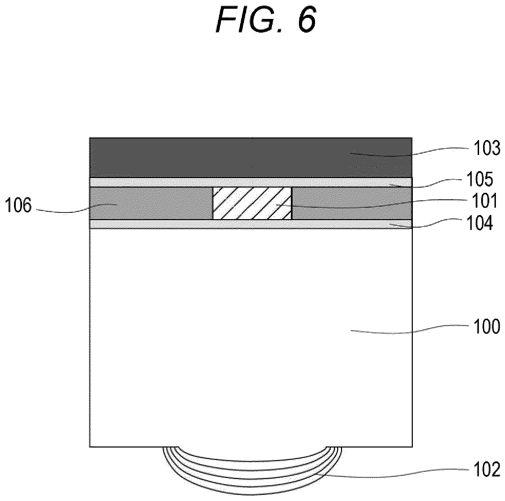

In final step S6, the concave mirror 102 is formed on a back surface (lower surface) of the substrate (wafer) to become the intermediate layer 100. Specifically, first, the back surface of the substrate to become the intermediate layer 100 is polished to be thinned, and then the back surface is etched (for example, dry-etched) to form the convex surface 100a (see Fig. 5B). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 6). Note that, since heat generated at the time of forming the concave mirror 102 (particularly, heat generated at the time of forming the convex surface 100a and heat generated concomitantly therewith) is quickly released to an outside via the intermediate layer 100, the temperature of the organic semiconductor layer 101 can be maintained at, for example, 100°C or lower, and deterioration of the organic semiconductor layer 101 due to heat can be suppressed.

In the method for manufacturing the surface-emitting element 10-1 described above, the occurrence of cracks and/or the prolongation of a film deposition time can be suppressed by particularly using the sputtering method in a case where a material is deposited. This means that a degree of freedom in selecting the material increases, and for example, AlN or the like including polycrystal or single crystal having high thermal conductivity can be used as the material of the intermediate layer 100.

### <<Effects of Surface-emitting Element>>

Hereinafter, effects of the surface-emitting element 10-1 according to Example 1 of the embodiment of the present technology will be described.

The surface-emitting element 10-1 includes at least one light emitting element portion 50 including at least one organic semiconductor layer 101 and the concave mirror 102 arranged on one side of the organic semiconductor layer 101.

In this case, the emission wavelength of the organic semiconductor layer 101 can be set regardless of the substrate used at the time of manufacturing. On the other hand, in the inorganic semiconductor laser of the related art in which the grating-matching inorganic semiconductor layer is stacked on the substrate, the emission wavelength of the inorganic semiconductor layer is restricted by the substrate.

Furthermore, in the organic semiconductor laser of the related art that performs laser oscillation by causing light to circulate in the in-plane direction, it is necessary to provide the grating structure, and the configuration is complicated.

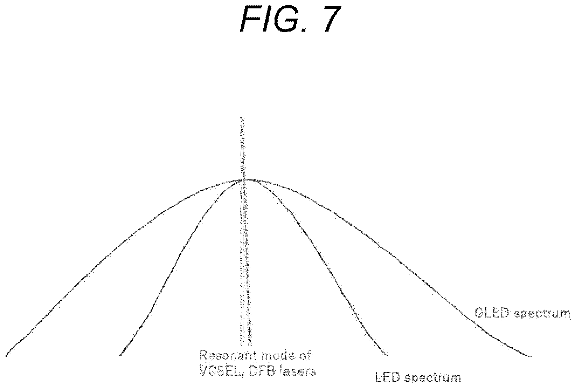

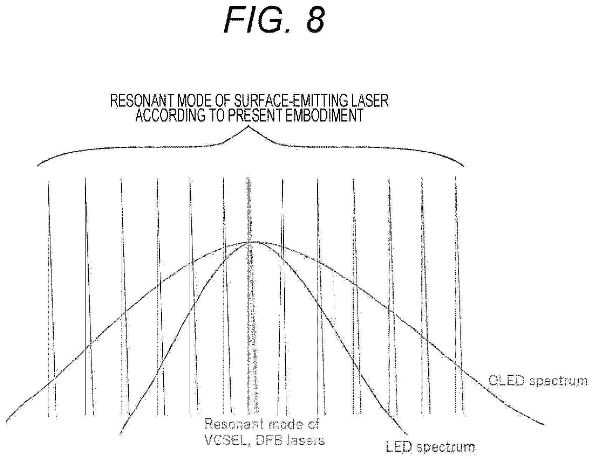

To give further details, for example, the inorganic semiconductor laser of the related art such as a VCSEL or DFB laser illustrated in Fig. 7 has a resonant mode having a steep spectrum waveform with, as a center, the emission wavelength restricted by the substrate, and the light emitting diode of the related art such as an LED or OLED has a broad spectrum waveform with, as the center, the emission wavelength restricted by the substrate. On the other hand, for example, as illustrated in Fig. 8, the surface-emitting element according to the present embodiment is very advantageous in that ae resonant mode having a steep spectrum with, as a center, any emission wavelength not restricted by the substrate can be voluntarily selected.

As a result, according to the surface-emitting element 10-1 according to Example 1, it is possible to provide a surface-emitting element in which the configuration can be simplified and the emission wavelength is not restricted by the substrate used at the time of manufacturing. That is, the surface-emitting element 10-1 has very advantageous characteristics in terms of a device structure that has a high degree of freedom in design and is easy to manufacture, and is an extremely promising innovative device that can increase a market value of the surface-emitting element as a light emitting device at once.

The light emitting element portion 50 further includes the reflector 103 arranged on the other side of the organic semiconductor layer 101. Therefore, the surface-emitting element 10-1 can function as the surface-emitting laser.

The interval between the organic semiconductor layer 101 and the concave mirror 102 is preferably wider than the interval between the organic semiconductor layer 101 and the reflector 103.

The concave mirror 102 preferably includes a metal or a dielectric. Therefore, a high reflectance can be obtained even with a thin film thickness.

Preferably, the light emitting element portion 50 further includes the intermediate layer 100 arranged between the organic semiconductor layer 101 and the concave mirror 102. Therefore, the intermediate layer 100 can serve as an exhaust heat path at the time of manufacturing the element and at the time of driving the element.

The intermediate layer 100 preferably includes a nitride, an oxide, resin, or a semiconductor. That is, the surface-emitting element 10-1 has a high degree of freedom in selecting the substrate, and it is not necessary to use an expensive semiconductor substrate such as a GaN substrate dispersed even by, for example, the inorganic semiconductor laser.

Preferably, the light emitting element portion 50 further includes the second transparent conductive film 105 arranged between the reflector 103 and the organic semiconductor layer 101. Therefore, the injection efficiency of carriers (for example, holes) into the organic semiconductor layer 101 can be enhanced.

The light emitting element portion 50 further includes the first transparent conductive film 104 arranged between the concave mirror 102 and the organic semiconductor layer 101. Therefore, the first transparent conductive film 104 can function as the electrode, and in addition, the injection efficiency of the carriers (for example, electrons) into the organic semiconductor layer 101 can be enhanced.

At least one light emitting element portion 50 may be the plurality of light emitting element portions 50 arranged in the array shape. In this case, the surface-emitting laser array in which the plurality of light emitting element portions 50 is arranged in the array shape can be formed.

Incidentally, the concave mirror has characteristics that the resonator can be extended not in the in-plane direction of the substrate but in a direction perpendicular to the substrate. Thus, in the surface-emitting element 10-1, the following specific effects (1) to (7) that cannot be realized by the organic semiconductor laser of the related art can be obtained.

(1) Since the surface-emitting element 10-1 has no resonance in the substrate in-plane direction, optical crosstalk (mutual noise due to leakage of light) does not occur or hardly occurs.
(2) A size of the surface-emitting element 10-1 in the substrate in-plane direction can be reduced by setting a resonance direction to a vertical direction, and the light emitting element portions can be arranged in the array shape with a high density.
(3) In the surface-emitting element 10-1, improvement of the Q-value, that is, reduction of the threshold current of the laser, and the like can be realized by forming a reflector with a high reflectance, and it is not necessary to increase the element in a lateral direction.
(4) The surface-emitting element 10-1 does not require a fine pattern like a grating structure, does not require a complicated exposure process, and has a simple production process.
(5)The surface-emitting element 10-1 does not generate a diffraction loss even though the resonator is long (for example, 20 um or more). Since light rays having various wavelengths can be circulated by adopting a long resonator structure, in a case where the organic semiconductor laser is combined with an organic semiconductor film having a wide light emission region, light rays suitable for various wavelength ranges can be effectively utilized and can contribute to laser oscillation.
(6) There are many cases where the organic semiconductor deteriorates due to overheating, and, in the element production process after the organic semiconductor film is formed, it is necessary to set the maximum attainment temperature to 100°C or lower. In the surface-emitting element 10-1, this problem can be solved by devising an order of a manufacturing process, and since the position of the concave mirror 102 is separated from the organic semiconductor layer 101, the transfer of the heat given to the concave mirror forming process to the organic semiconductor layer 101 can be suppressed.
(7) In the surface-emitting element 10-1, since the intermediate layer 100 can be thickened and the exhaust heat path can be lengthened, overheating during element driving can be suppressed, and a larger current and a stable operation (longer lifespan) for a long period of time can be performed.

### <2. Surface-emitting Element according to Example 2 of Embodiment of Present Technology>

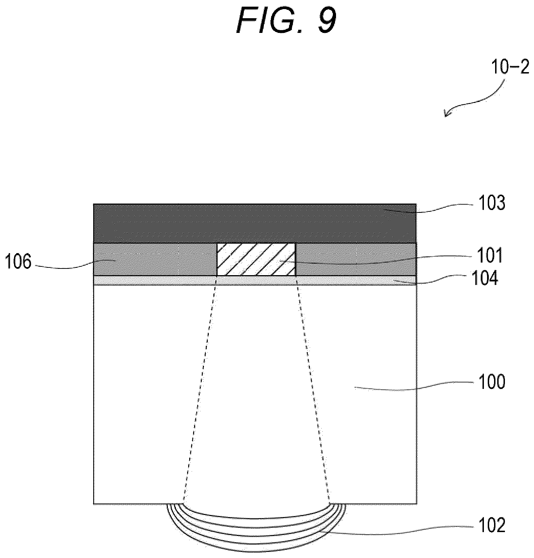

Hereinafter, a surface-emitting element according to Example 2 of the embodiment of the present technology will be described with reference to the drawings. Fig. 9 is a sectional view of a surface-emitting element 10-2 according to Example 2 of the embodiment of the present technology.

As an example, as illustrated in Fig. 9, the surface-emitting element 10-2 has a configuration similar to the surface-emitting element 10-1 according to Example 1 except that the second transparent conductive film 105 is not included.

The surface-emitting element 10-2 also performs an operation similar to the surface-emitting element 10-1, and can be manufactured by a similar manufacturing method.

Since the surface-emitting element 10-2 does not have the second transparent conductive film 105, the injection efficiency of the carriers (for example, holes) into the organic semiconductor layer 101 is inferior to the surface-emitting element 10-1 according to Example 1, but the layer configuration can be simplified and the manufacturing process can be simplified.

### <3. Surface-emitting Element according to Example 3 of Embodiment of Present Technology>

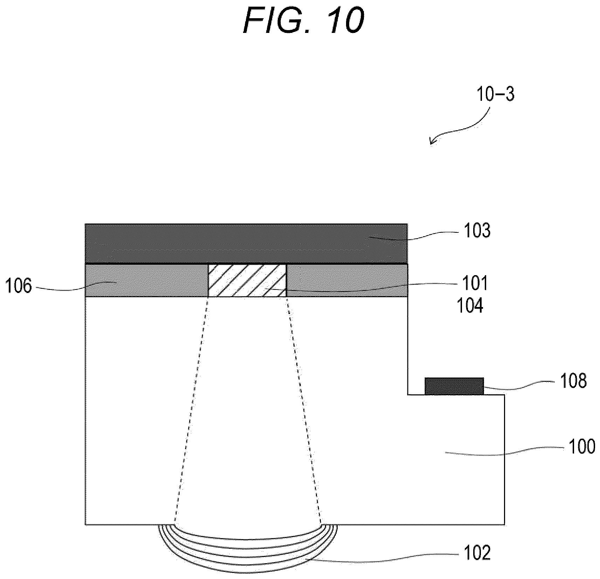

Hereinafter, a surface-emitting element according to Example 3 of the embodiment of the present technology will be described with reference to the drawings. Fig. 10 is a sectional view of a surface-emitting element 10-3 according to Example 3 of the embodiment of the present technology.

As an example, as illustrated in Fig. 10, the surface-emitting element 10-3 has a configuration substantially similar to the surface-emitting element 10-1 according to Example 1 except that the first and second transparent conductive films 104 and 105 are not included.

In the surface-emitting element 10-3, a stepped portion is provided in the intermediate layer 100, and an electrode member 108 as the cathode electrode is provided on the stepped portion. The intermediate layer 100 includes a material having conductivity (for example, a semiconductor or the like).

In the surface-emitting element 10-3, a current flowing from the reflector 103 as the anode electrode and injected into the organic semiconductor layer 101 flows out from the electrode member 108 as the cathode electrode via the intermediate layer 100. That is, a current path is present in the intermediate layer 100.

The surface-emitting element 10-3 also performs an operation substantially similar to the surface-emitting element 10-1, and can be manufactured by a substantially similar manufacturing method.

Since the surface-emitting element 10-3 does not have the first and second transparent conductive films 104 and 105, the injection efficiency of the carriers (for example, holes and electrons) into the organic semiconductor layer 101 is inferior to the surface-emitting element 10-1 according to Example 1, but the layer configuration can be simplified and the manufacturing process can be simplified.

### <4. Surface-emitting Element according to Example 4 of Embodiment of Present Technology>

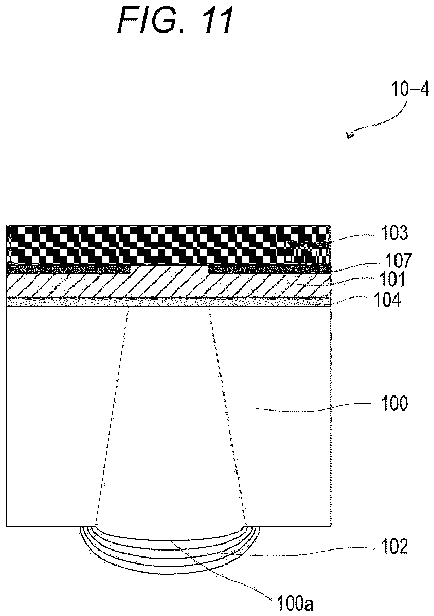

Hereinafter, a surface-emitting element according to Example 4 of the embodiment of the present technology will be described with reference to the drawings. Fig. 11 is a sectional view of a surface-emitting element 10-4 according to Example 4 of the embodiment of the present technology.

### <<Configuration of Surface-emitting Element>>

As illustrated in Fig. 11, the surface-emitting element 10-4 has a configuration substantially similar to the surface-emitting element 10-1 according to Example 1 except that the second transparent conductive film 105 and the high resistance layer 106 are not included and the organic semiconductor layer 101 is solidly provided on the first transparent conductive film 104 and a current block layer 107 is provided in a peripheral portion thereof.

The current block layer 107 is provided in a frame shape (for example, annular shape) to surround at least a part (for example, upper portion) in a thickness direction of a central portion of the organic semiconductor layer 101. The current block layer 107 is a layer having a higher electric resistance than the organic semiconductor layer 101 (a layer having lower carrier conductivity), and is formed by, for example, injecting high-concentration ions (for example, B⁺⁺, H⁺⁺, and the like).

### <<Method for Manufacturing Surface-emitting Element>>

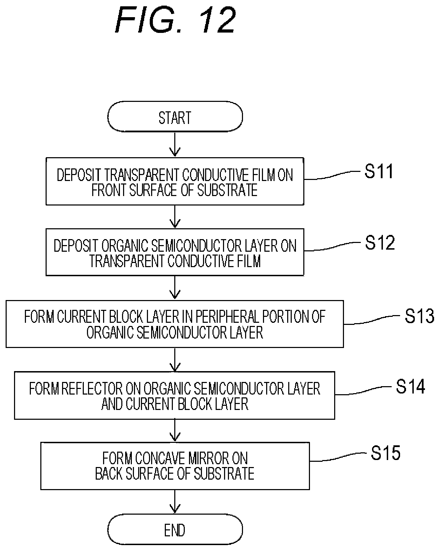

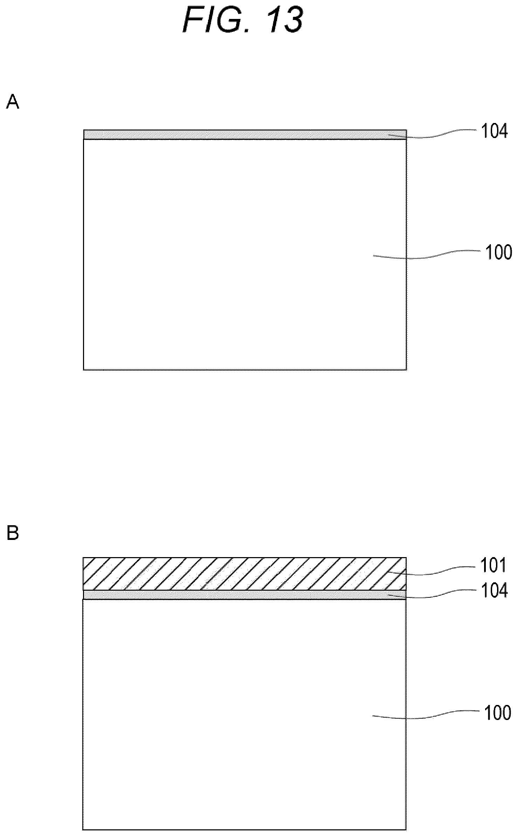

Hereinafter, a method for manufacturing the surface-emitting element 10-4 will be described with reference to a flowchart (steps S11 to S15) in Fig. 12 and sectional views of Figs. 13A to 15B. Here, as an example, a plurality of surface-emitting elements 10-4 is simultaneously generated on one wafer (for example, GaN substrate) to become the base material of the intermediate layer 100. Subsequently, the plurality of surface-emitting elements 10-4 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-4 is two-dimensionally arranged on one wafer (for example, GaN substrate) to become the base material of the intermediate layer 100 and separating a plurality of integrated surface-emitting element arrays integrated in series from each other.

In first step S11, the first transparent conductive film 104 is stacked on the front surface (upper surface) of the substrate (wafer) to become the intermediate layer 100. Specifically, the first transparent conductive film 104 is deposited on the front surface of the wafer (for example, GaN substrate) to become the intermediate layer 100 by, for example, a vacuum vapor deposition method, a sputtering method, a CVD method, or the like (see Fig. 13A) .

In next step S12, the organic semiconductor layer 101 is deposited on the first transparent conductive film 104. Specifically, an organic semiconductor film to become the organic semiconductor layer 101 is solidly deposited on the first transparent conductive film 104 by, for example, vacuum deposition, coating, or the like (see Fig. 13B).

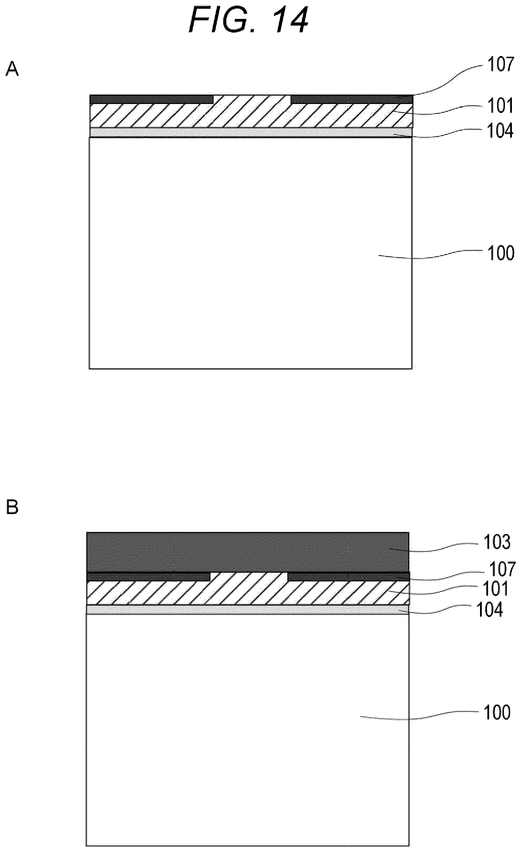

In next step S13, the current block layer 107 is formed in the peripheral portion of the organic semiconductor layer 101. Specifically, a resist pattern covering the central portion of the organic semiconductor layer 101 is formed, and high-concentration ions (for example, B⁺⁺, H⁺⁺, and the like), for example, are injected into the peripheral portion of the organic semiconductor layer 101 by using the resist pattern as a mask (see Fig. 14A). An injection depth of ions at this time is up to an upper portion of the organic semiconductor layer 101. This is to prevent the ions from reaching the first transparent conductive film 104.

In next step S14, the reflector 103 is formed on the organic semiconductor layer 101 and the current block layer 107. Specifically, the material of the reflector 103 is deposited on the organic semiconductor layer 101 and the current block layer 107 by, for example, a vacuum vapor deposition method, a sputtering method, a CVD method, or the like (see Fig. 14B).

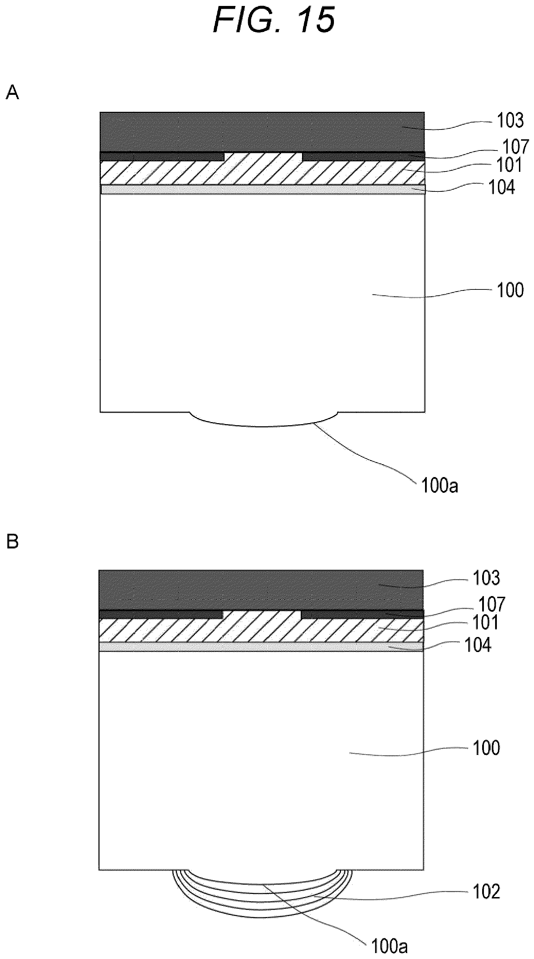

In final step S15, the concave mirror 102 is formed on the back surface (lower surface) of the substrate (wafer). Specifically, first, the back surface of the substrate to become the intermediate layer 100 is polished to be thinned, and then the back surface is etched (for example, dry-etched) to form the convex surface 100a (see Fig. 15A). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 15B). Note that, since heat generated at the time of forming the concave mirror 102 is quickly released to the outside via the intermediate layer 100, the temperature of the organic semiconductor layer 101 can be maintained at, for example, 100°C or lower, and deterioration of the organic semiconductor layer 101 due to heat can be suppressed.

The surface-emitting element 10-4 also performs an operation substantially similar to the surface-emitting element 10-1.

Since the surface-emitting element 10-4 does not have the second transparent conductive film 105, the injection efficiency of the carriers (for example, holes) into the organic semiconductor layer 101 is inferior to the surface-emitting element 10-1 according to Example 1, but the layer configuration can be simplified and the manufacturing process can be simplified.

### <5. Surface-emitting Element according to Example 5 of Embodiment of Present Technology>

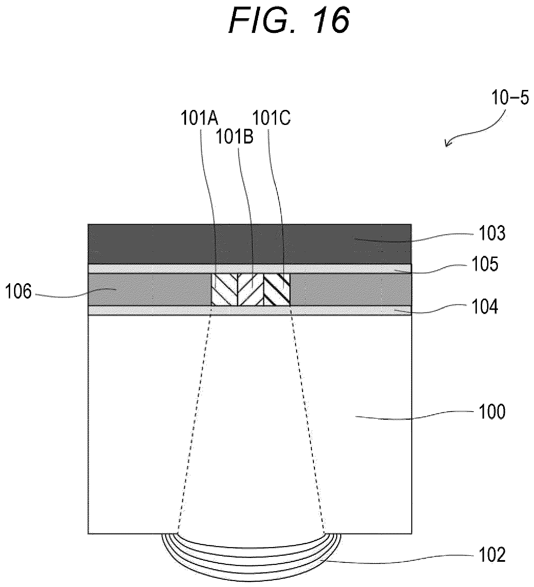

Hereinafter, a surface-emitting element according to Example 5 of the embodiment of the present technology will be described with reference to the drawings. Fig. 16 is a sectional view of a surface-emitting element 10-5 according to Example 5 of the embodiment of the present technology.

As an example, as illustrated in Fig. 16, the surface-emitting element 10-5 has a configuration substantially similar to the surface-emitting element 10-1 according to Example 1 except that a plurality of (for example, three) organic semiconductor layers 101 (for example, first to third organic semiconductor layers 101A, 101B, and 101C) having different emission wavelengths is included and that each of the concave mirror 102 and the reflector 103 has a structure in which a plurality of multilayer film reflectors corresponding to a plurality of wavelengths (for example, red, green, and blue) is stacked.

As an example, the first to third organic semiconductor layers 101A, 101B, and 101C are arranged side by side in the in-plane direction (specifically, such that the first and third organic semiconductor layers 101A and 101C sandwich the second organic semiconductor layer 101B in the in-plane direction). The first organic semiconductor layer 101A is, for example, an organic semiconductor layer that emits red light (has an emission wavelength in a red band). The second organic semiconductor layer 101B is, for example, an organic semiconductor layer that emits green light (has an emission wavelength in a green band). The third organic semiconductor layer 101C is, for example, an organic semiconductor layer that emits blue light (has an emission wavelength in a blue band).

As an example, each of the concave mirror 102 and the reflector 103 is formed into a wide band to correspond to all of red light, green light, and blue light. That is, each of the concave mirror 102 and the reflector 103 can reflect each of red light, green light, and blue light with a high reflectance.

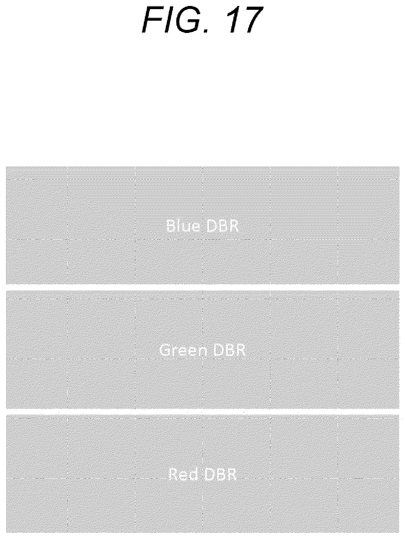

More specifically, as an example, as illustrated in Fig. 17, the concave mirror 102 has a stacked structure in which a multilayer film reflector (Blue DBR) corresponding to blue light (reflecting blue light with a high reflectance), a multilayer film reflector (Green DBR) corresponding to green light (reflecting green light with a high reflectance), and a multilayer film reflector (Red DBR) corresponding to red light (reflecting red light with a high reflectance) are stacked in this order from the intermediate layer 100 side (upper side).

Similarly, the reflector 103 also has, as an example, a stacked structure in which a multilayer reflector (Blue DBR) corresponding to blue light (reflecting blue light with a high reflectance), a multilayer reflector (Green DBR) corresponding to green light (reflecting green light with a high reflectance), and a multilayer reflector (Red DBR) corresponding to red light (reflecting red light with a high reflectance) are stacked in this order from the intermediate layer 100 side (lower side).

A plurality of (for example, three) DBRs in each of the concave mirror 102 and the reflector 103 is arranged in consideration of entering a mirror deeper as light on a long wavelength side enters a mirror (conversely, light on a short wavelength side enters a mirror shallower).

In the surface-emitting element 10-5, when a drive voltage is applied between the anode electrode and the cathode electrode by the laser driver, a current flowing from the anode electrode is substantially simultaneously injected into the first to third organic semiconductor layers 101A, 101B, and 101C via the second transparent conductive film 105, and the organic semiconductor layers emit light substantially simultaneously. The light emitted from each organic semiconductor layer 101 reciprocates between the corresponding DBR of the concave mirror 102 and the corresponding DBR of the reflector 103 while being amplified by the organic semiconductor layer, and is emitted as the laser light from the concave mirror 102 to the outside when the oscillation condition is satisfied. Finally, white light obtained by combining red light, green light, and blue light is emitted from the surface-emitting element 10-5.

The surface-emitting element 10-5 can be manufactured by a manufacturing method similar to the surface-emitting element 10-1 according to Example 1 except that the first to third organic semiconductor layers 101A, 101B, and 101C are individually formed.

In the surface-emitting element 10-5, effects similar to the surface-emitting element 10-1 according to Example 1 can be obtained, and since the emission wavelength of each organic semiconductor layer is not restricted by the substrate, it is possible to dispose the plurality of organic semiconductor layers having different emission wavelengths on the same substrate (intermediate layer 100), cause the organic semiconductor layers to substantially simultaneously emit light rays to perform laser oscillation, and simultaneously emit laser light rays of a plurality of colors (for example, three colors). As described above, in the surface-emitting element 10-5, the plurality of organic semiconductor layers (for example, organic semiconductor layers corresponding to R, G, and B) having different emission wavelengths can be integrated in a monolithic manner, and application to various technical fields is expected.

### <6. Surface-emitting Element according to Example 6 of Embodiment of Present Technology>

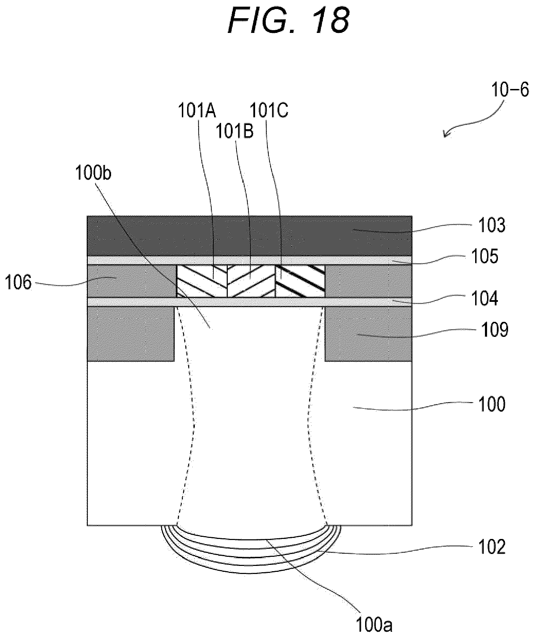

Hereinafter, a surface-emitting element according to Example 6 of the embodiment of the present technology will be described with reference to the drawings. Fig. 18 is a sectional view of a surface-emitting element 10-6 according to Example 6 of the embodiment of the present technology.

As an example, as illustrated in Fig. 18, the surface-emitting element 10-6 has a configuration substantially similar to the surface-emitting element 10-5 according to Example 5 except that the plurality of organic semiconductor layers 101 includes at least two organic semiconductor layers 101 having different volumes and a low refractive index layer 109 is provided.

In the surface-emitting element 10-6, as an example, the volumes of the first and third organic semiconductor layers 101A and 101C are substantially the same, and the volume of the second organic semiconductor layer 101B is smaller than the volumes of the first and third organic semiconductor layers 101A and 101C. A volume difference is provided in this manner, and thus, a threshold current, an output, and the like of laser oscillation of each organic semiconductor layer can be controlled. Therefore, for example, it is possible to set the threshold current of the laser oscillation obtained from the plurality of organic semiconductor layers to be more uniform or to set the balance of the intensity of the emitted light to be uniform.

Incidentally, the thickness of the intermediate layer 100 and/or the power of the concave mirror 102 are set, and thus, the condensing position (beam waist position) of the light reflected by the concave mirror 102 can be positioned in the intermediate layer 100 (for example, near the central position of the intermediate layer 100 in an up-down direction). In this case, since the light from the concave mirror 102 travels while spreading after being condensed in the intermediate layer 100, an irradiation range for the organic semiconductor layer 101 can be expanded.

In the surface-emitting element 10-6, a width of the plurality of (for example, three) organic semiconductor layers 101 (for example, first to third organic semiconductor layers 101A, 101B, and 101C) in the in-plane direction is widened in accordance with such a configuration for widening the irradiation range. Here, a total lateral width of the first to third organic semiconductor layers 101A, 101B, and 101C is, for example, 5 to 20 µm.

Moreover, in the surface-emitting element 10-6, a frame-shaped (for example, annular) low refractive index layer 109 having a refractive index lower than the intermediate layer 100 is provided in a periphery of an upper portion of the intermediate layer 100 (at a position corresponding to the high resistance layer 106). Therefore, light that is reflected by the concave mirror 102 and once condensed and then travels while spreading can be confined inside the low refractive index layer 109 and can be efficiently incident on the first to third organic semiconductor layers 101A, 101B, and 101C. The low refractive index layer 109 includes, for example, benzocyclobutene (BCB), an oxide such as or SiO₂, or resin such as epoxy, silicone, or polyimide.

### <<Method for Manufacturing Surface-emitting Element>>

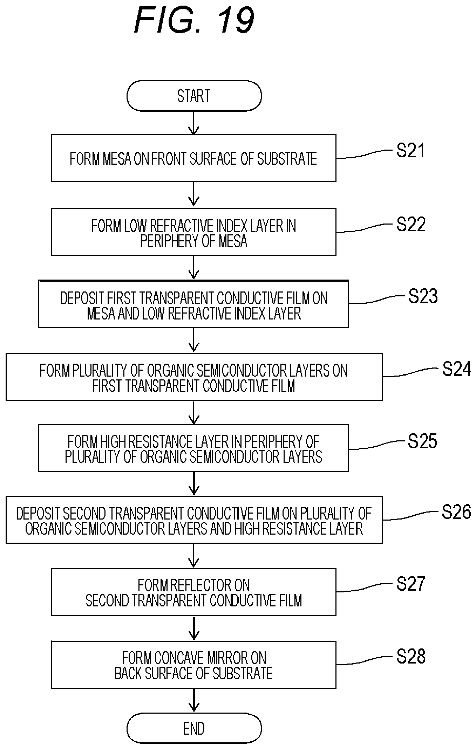

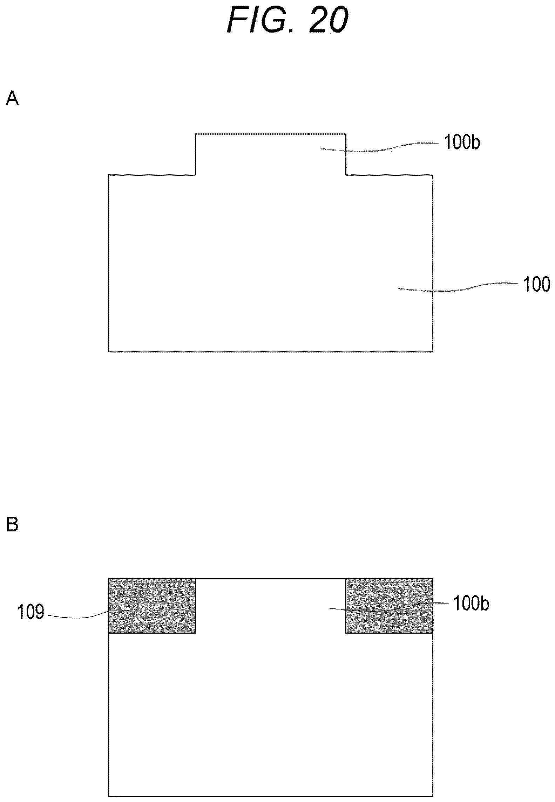

Hereinafter, a method for manufacturing the surface-emitting element 10-6 will be described with reference to the flowchart (steps S21 to S28) in Fig. 19 and the sectional views of Figs. 20A to 24. Here, as an example, a plurality of surface-emitting elements 10-6 is simultaneously generated on one wafer (for example, GaN substrate) to become the base material of the intermediate layer 100. Subsequently, the plurality of surface-emitting elements 10-6 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-6 is two-dimensionally arranged on one wafer (for example, GaN substrate) to become the base material of the intermediate layer 100 and separating a plurality of integrated surface-emitting element arrays integrated in series from each other.

In first step S21, a mesa 100b is formed on the front surface (upper surface) of the substrate (wafer) to become the intermediate layer 100. Specifically, a resist pattern covering a position where the mesa 100b is to be formed on the front surface of the wafer (for example, GaN substrate) to become the intermediate layer 100 is formed, and the wafer is etched by using the resist pattern as a mask to form the mesa 100b (see Fig. 20A) .

In next step S22, the low refractive index layer 109 is formed in a periphery of the mesa 100b. Specifically, the periphery of the mesa 100b is embedded with BCB to form the frame-shaped low refractive index layer 109 surrounding the mesa 100b (see Fig. 20B).

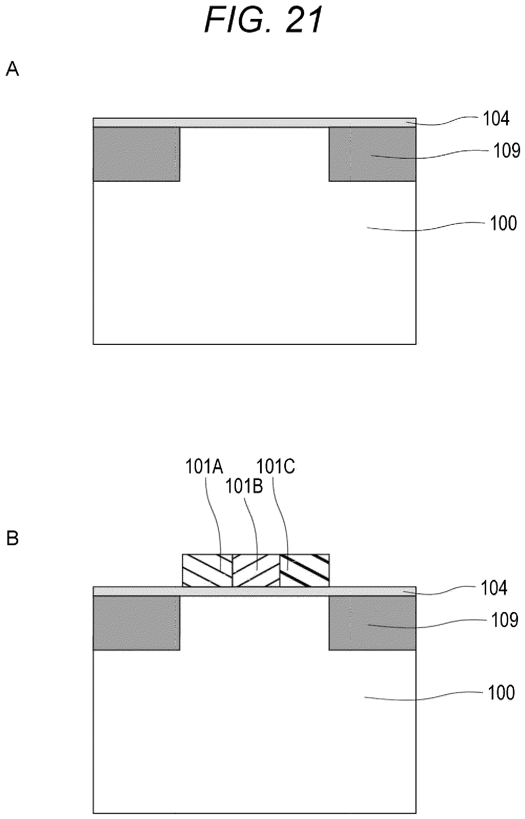

In next step S23, the first transparent conductive film 104 is deposited on the mesa 100b and the low refractive index layer 109. Specifically, the first transparent conductive film 104 is deposited on the mesa 100b and the low refractive index layer 109 by, for example, a vacuum vapor deposition method, a sputtering method, a chemical vapor deposition (CVD) method, a coating method combining spin coating, baking, or the like (see Fig. 21A).

In next step S24, the plurality of (for example, three) organic semiconductor layers 101 (for example, first to third organic semiconductor layers 101A, 101B, and 101C) is formed on the first transparent conductive film 104 (see Fig. 21B). Specifically, first, an organic semiconductor film to become the first organic semiconductor layer 101A is solidly deposited on the first transparent conductive film 104 by, for example, vacuum deposition, coating, or the like. Subsequently, a resist pattern covering a portion of the organic semiconductor film to become the first organic semiconductor layer 101A includes, for example, a metal material. Subsequently, patterning is performed by etching the organic semiconductor film by using the resist pattern as a mask to form the first organic semiconductor layer 101A. Subsequently, after the resist pattern is removed, an organic semiconductor film to become the second organic semiconductor layer 101B is solidly deposited by, for example, vacuum deposition, coating, or the like. Subsequently, a resist pattern covering a portion of the organic semiconductor film to become the second organic semiconductor layer 101B includes, for example, a metal material. Subsequently, patterning is performed by etching the organic semiconductor film by using the resist pattern as a mask to form the second organic semiconductor layer 101B. Subsequently, after the resist pattern is removed, an organic semiconductor film to become the third organic semiconductor layer 101B is solidly deposited by, for example, vacuum deposition, coating, or the like. Subsequently, a resist pattern covering a portion of the organic semiconductor film to become the third organic semiconductor layer 101C includes, for example, a metal material. Subsequently, patterning is performed by etching the organic semiconductor film by using the resist pattern as a mask to form the third organic semiconductor layer 101C, and then the resist pattern is removed. Thereafter, the upper surfaces of the first to third organic semiconductor layers 101A, 101B, and 101C are polished and planarized as necessary. Note that, the first to third organic semiconductor layers 101A, 101B, and 101C may be patterned by using a metal mask.

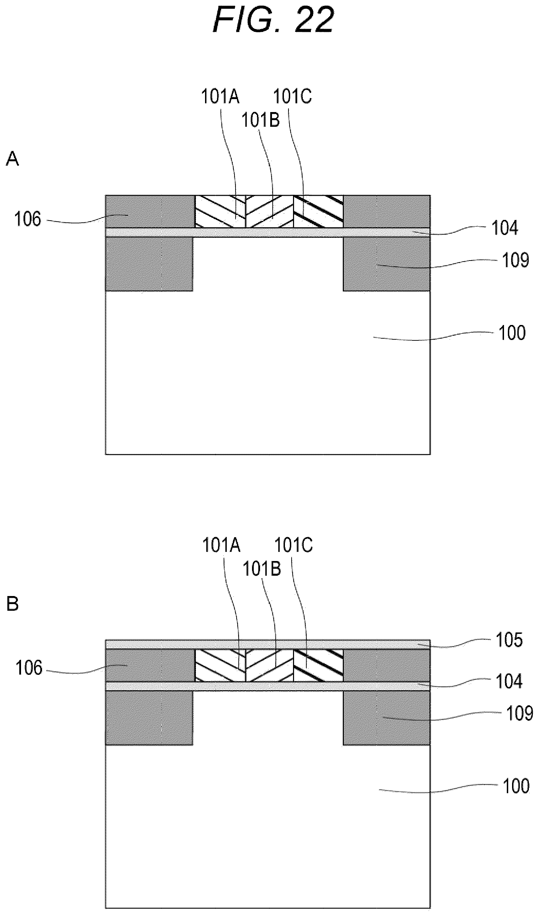

In next step S25, the high resistance layer 106 is formed in a periphery of the plurality of organic semiconductor layers 101 (see Fig. 22A). Specifically, first, a high resistance material to become the high resistance layer 106 is deposited to cover the plurality of organic semiconductor layers 101 and the first transparent conductive film 104, and then a resist pattern opened at a position corresponding to a portion covering the plurality of organic semiconductors 101 including the high resistance material is formed on the high resistance material. Subsequently, a portion covering the plurality of organic semiconductor layers 101 including the high-resistance material is removed by etching by using the resist pattern as a mask to expose the plurality of organic semiconductor layers 101.

In next step S26, the second transparent conductive film 105 is deposited on the plurality of organic semiconductor layers 101 and the high resistance layer 106. Specifically, the second transparent conductive film 105 is deposited on the plurality of organic semiconductor layers 101 and the high resistance layer 106 by, for example, a vacuum vapor deposition method, sputtering, or the like (see Fig. 22B).

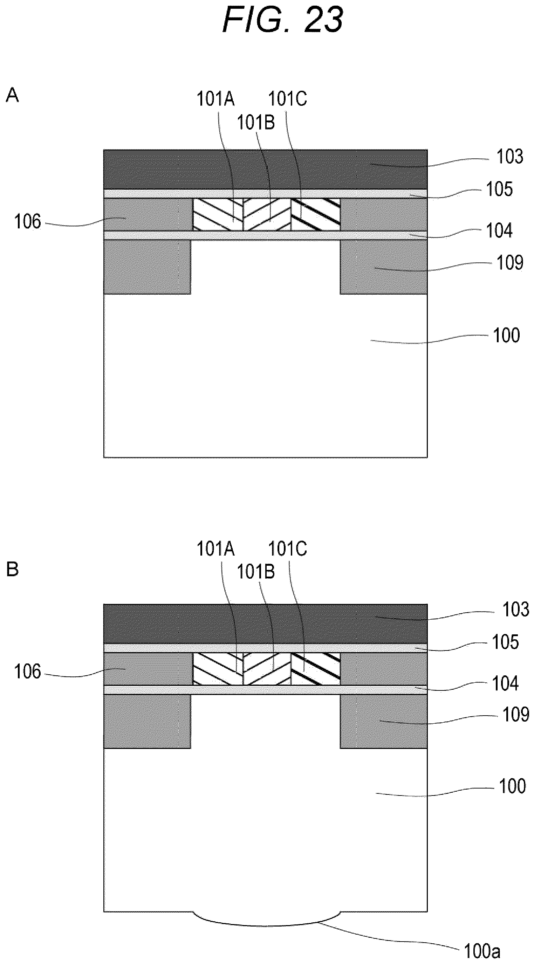

In next step S27, the reflector 103 is formed on the second transparent conductive film 105. Specifically, the material of the reflector 103 is deposited on the second transparent conductive film 105 by, for example, a vacuum vapor deposition method, a sputtering method, a CVD method, or the like (see Fig. 23A) .

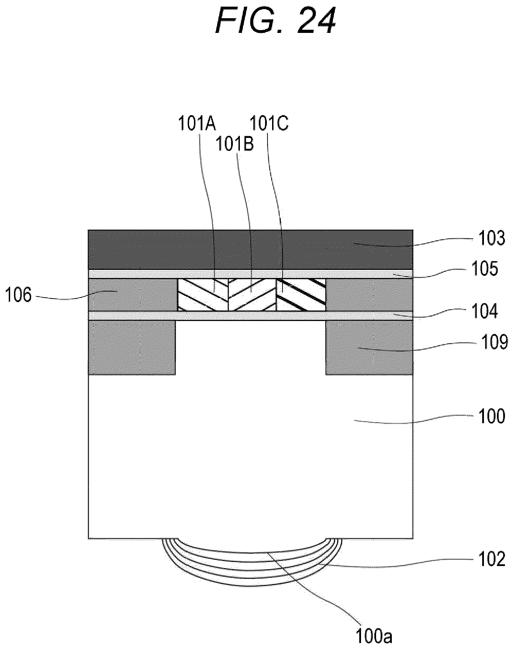

In final step S28, the concave mirror 102 is formed on the back surface (lower surface) of the substrate (wafer). Specifically, first, the back surface of the substrate to become the intermediate layer 100 is polished to be thinned, and then the back surface is etched (for example, dry-etched) to form the convex surface 100a (see Fig. 23B). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 24). Note that, since heat generated at the time of forming the concave mirror 102 is relatively quickly released to the outside via the intermediate layer 100, the temperature of the organic semiconductor layer 101 can be more easily maintained at, for example, 100°C or lower, and deterioration of the organic semiconductor layer 101 due to heat can be suppressed.

According to the surface-emitting element 10-6, effects similar to the surface-emitting element 10-5 according to Example 5 can be obtained, and since the plurality of organic semiconductor layers 101 having a large width in the in-plane direction is caused to emit light to perform laser oscillation, laser light having a large light diameter can be emitted. Furthermore, according to the surface-emitting element 10-6, since the intermediate layer 100 has the mesa 100b and the plurality of organic semiconductor layers 101 is arranged on the mesa 100b, for example, in a case where the light emitting element portions 50 are arranged in the array shape, high-density disposition can be performed.

### <7. Surface-emitting Element according to Example 7 of Embodiment of Present Technology>

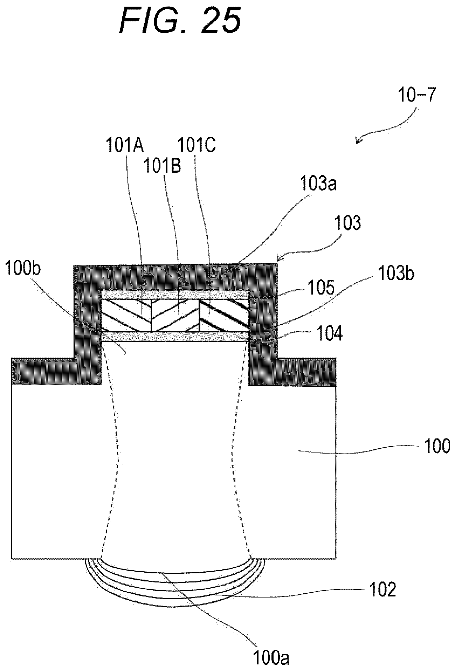

Hereinafter, a surface-emitting element according to Example 7 of the embodiment of the present technology will be described with reference to the drawings. Fig. 25 is a sectional view of a surface-emitting element 10-7 according to Example 7 of the embodiment of the present technology.

As an example, as illustrated in Fig. 25, the surface-emitting element 10-7 has a configuration substantially similar to the surface-emitting element 10-6 according to Example 6 except that the high resistance layer 106 and the low refractive index layer 109 are not provided.

In the surface-emitting element 10-7, the reflector 103 is provided to cover the mesa 100b, the first to third organic semiconductor layers 101A, 101B, and 101C, and the first and second transparent conductive films 104 and 105.

In the surface-emitting element 10-7, the reflector 103 includes a plane mirror portion 103a positioned on the plurality of organic semiconductor layers 101 and an optical confinement portion 103b surrounding the plurality of organic semiconductor layers 101. Here, the reflector 103 includes a material having a refractive index lower than the intermediate layer 100.

The surface-emitting element 10-7 also performs an operation similar to the surface-emitting element 10-6 according to Example 6.

### <<Method for Manufacturing Surface-emitting Element>>

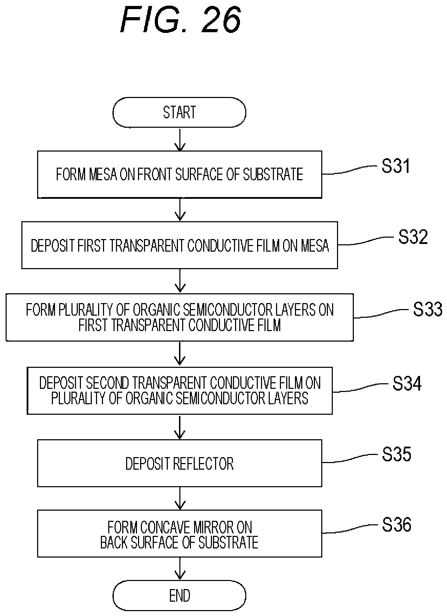

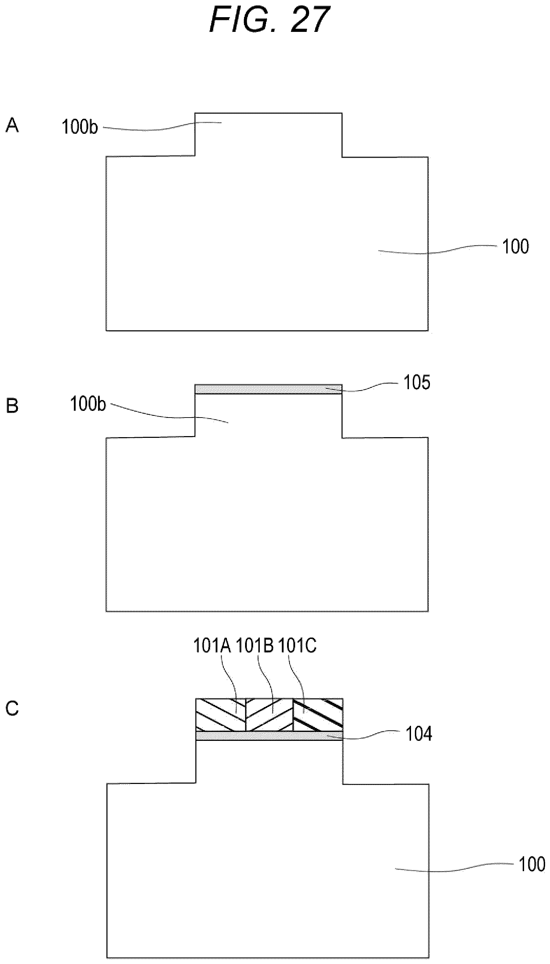

Hereinafter, a method for manufacturing the surface-emitting element 10-7 will be described with reference to the flowchart (steps S31 to S36) in Fig. 26 and the sectional views of Figs. 27A to 29B. Here, as an example, a plurality of surface-emitting elements 10-7 is simultaneously generated on one wafer (for example, GaN substrate) to become the base material of the intermediate layer 100. Subsequently, the plurality of surface-emitting elements 10-7 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-7 is two-dimensionally arranged on one wafer (for example, GaN substrate) to become the base material of the intermediate layer 100 and separating a plurality of integrated surface-emitting element arrays integrated in series from each other.

In first step S31, the mesa 100b is formed on the front surface (upper surface) of the substrate (wafer) to become the intermediate layer 100. Specifically, a resist pattern covering a position where the mesa 100b is to be formed on the front surface of the wafer (for example, GaN substrate) to become the intermediate layer 100 is formed, and the wafer is etched by using the resist pattern as a mask to form the mesa 100b (see Fig. 27A) .

In next step S32, the first transparent conductive film 104 is deposited on the mesa 100b. Specifically, the first transparent conductive film 104 is deposited on the mesa 100b by, for example, a vacuum vapor deposition method, a sputtering method, a chemical vapor deposition (CVD) method, or the like (see Fig. 27B).

In next step S33, the plurality of (for example, three) organic semiconductor layers 101 (for example, first to third organic semiconductor layers 101A, 101B, and 101C) is formed on the first transparent conductive film 104 (see Fig. 27C). Specifically, the plurality of organic semiconductor layers 101 is formed on the first transparent conductive film 104 in the same manner as in step S24 of the flowchart of Fig. 19.

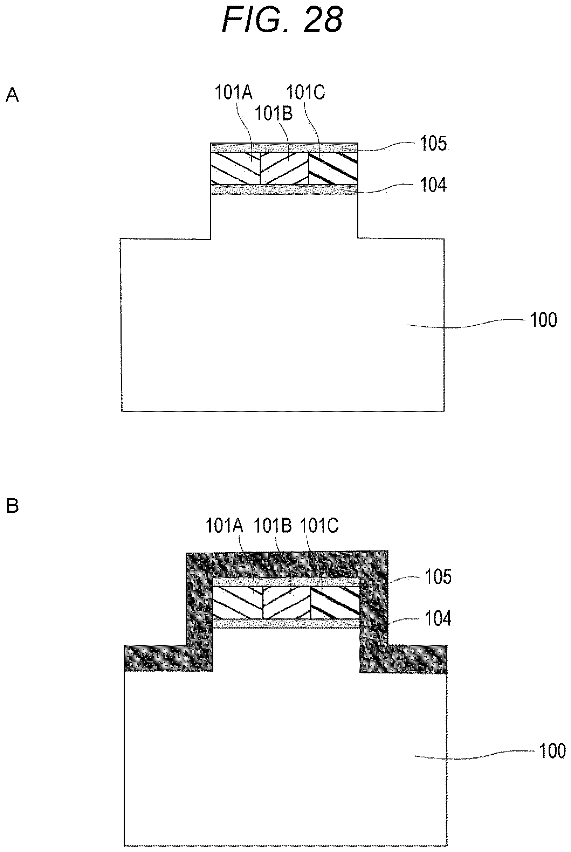

In next step S34, the second transparent conductive film 105 is deposited on the plurality of organic semiconductor layers 101. Specifically, the second transparent conductive film 105 is deposited on the plurality of organic semiconductor layers 101 by, for example, a vacuum vapor deposition method, sputtering, or the like (see Fig. 28A).

In next step S35, the reflector 103 is deposited. Specifically, the material of the reflector 103 is deposited by, for example, a vacuum vapor deposition method, a sputtering method, a CVD method, or the like to cover the second transparent conductive film 105, the plurality of organic semiconductor layers 101, and the mesa 100b (see Fig. 28B). As a result, the mesa 100b and the reflector 103 having a shape following the layer stacked on the mesa 100b are formed.

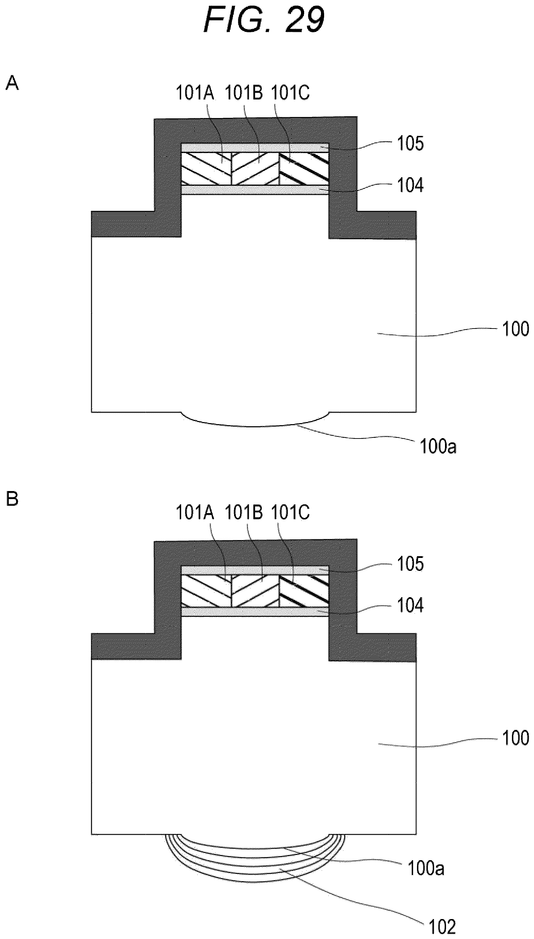

In final step S36, the concave mirror 102 is formed on the back surface (lower surface) of the substrate (wafer). Specifically, first, the back surface of the substrate to become the intermediate layer 100 is polished to be thinned, and then the back surface is etched (for example, dry-etched) to form the convex surface 100a (see Fig. 29A). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 29B). Note that, since heat generated at the time of forming the concave mirror 102 is quickly released to the outside via the intermediate layer 100, the temperature of each organic semiconductor layer 101 can be maintained at, for example, 100°C or lower, and deterioration of the organic semiconductor layer 101 due to heat can be suppressed.

According to the surface-emitting element 10-7, effects similar to the surface-emitting element 10-6 according to Example 6 can be obtained, the number of components can be greatly reduced, and the manufacturing process can be greatly simplified.

### <8. Surface-emitting Element according to Example 8 of Embodiment of Present Technology>

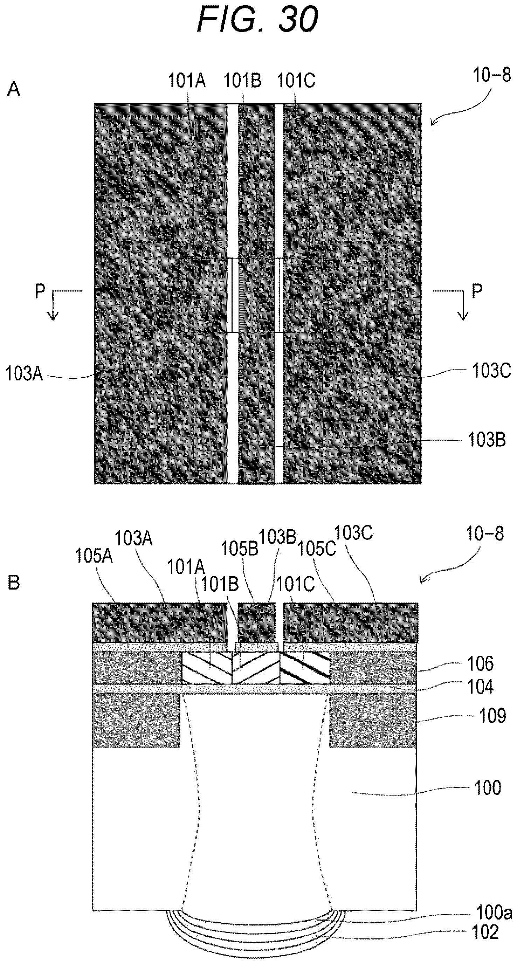

Hereinafter, a surface-emitting element according to Example 8 of the embodiment of the present technology will be described with reference to the drawings. Fig. 30A is a plan view of a surface-emitting element 10-8 according to Example 8 of the embodiment of the present technology. Fig. 30B is a sectional view of the surface-emitting element 10-8 according to Example 8 of the embodiment of the present technology. Fig. 30B is a sectional view taken along line P-P in Fig. 30A.

As illustrated in Figs. 30A and 30B, the surface-emitting element 10-8 has a configuration similar to the surface-emitting element 10-6 according to Example 6 except that drive voltages can be individually applied to the plurality of (for example, three) organic semiconductor layers 101.

The surface-emitting element 10-8 includes a plurality of reflectors 103 (for example, first to third reflectors 103A, 103B, and 103C) corresponding to the plurality of organic semiconductor layers 101 (for example, first to third organic semiconductor layers 101A, 101B, and 101C) and insulated from each other.

The surface-emitting element 10-8 includes a plurality of second transparent conductive films 105 (for example, second transparent conductive films 105A, 105B, and 105C) corresponding to the plurality of organic semiconductor layers 101 (for example, first to third organic semiconductor layers 101A, 101B, and 101C) and insulated from each other.

The first transparent conductive film 104 is a cathode electrode (common electrode) common to the plurality of organic semiconductor layers 101.

In the surface-emitting element 10-8, at least one of the plurality of organic semiconductor layers 101 can be caused to selectively emit light by selectively applying the drive voltage between at least one of the plurality of reflectors 103 and the first transparent conductive film 104, and thus, laser light of at least one color among a plurality of colors (for example, three colors) can be selectively emitted.

### <<Method for Manufacturing Surface-emitting Element>>

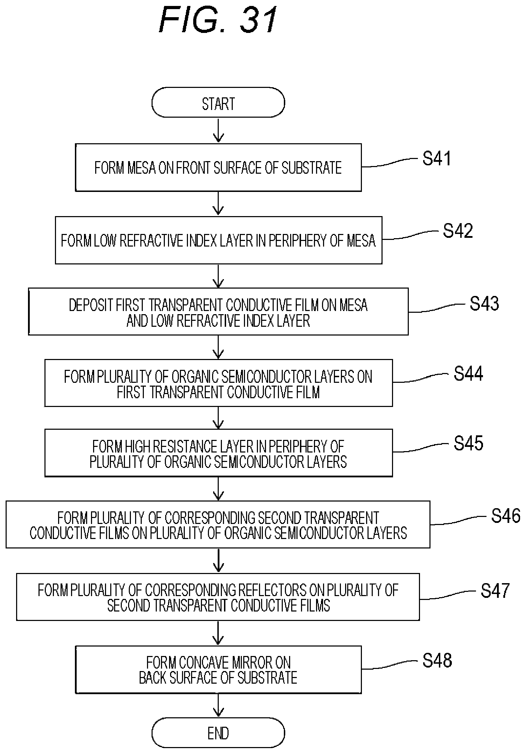

Hereinafter, a method for manufacturing the surface-emitting element 10-8 will be described with reference to the flowchart (steps S41 to S48) in Fig. 31 and the sectional views of Figs. 20A to 22A, and Figs. 32A to 33B. Here, as an example, a plurality of surface-emitting elements 10-8 is simultaneously generated on one wafer (for example, GaN substrate) to become the base material of the intermediate layer 100. Subsequently, the plurality of surface-emitting elements 10-8 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-8 is two-dimensionally arranged on one wafer (for example, GaN substrate) to become the base material of the intermediate layer 100 and separating a plurality of integrated surface-emitting element arrays integrated in series from each other.

In first step S41, the mesa 100b is formed on the front surface (upper surface) of the substrate (wafer) to become the intermediate layer 100. Specifically, a resist pattern covering a position where the mesa 100b is to be formed on the front surface of the wafer (for example, GaN substrate) to become the intermediate layer 100 is formed, and the wafer is etched by using the resist pattern as a mask to form the mesa 100b (see Fig. 20A) .

In next step S42, the low refractive index layer 109 is formed in the periphery of the mesa 100b. Specifically, the periphery of the mesa 100b is embedded with BCB to form the frame-shaped low refractive index layer 109 surrounding the mesa 100b (see Fig. 20B).

In next step S43, the first transparent conductive film 104 is deposited on the mesa 100b and the low refractive index layer 109. Specifically, the first transparent conductive film 104 is deposited on the mesa 100b and the low refractive index layer 109 by, for example, a vacuum vapor deposition method, a sputtering method, a chemical vapor deposition (CVD) method, or the like (see Fig. 21A).

In next step S44, the plurality of (for example, three) organic semiconductor layers 101 (for example, first to third organic semiconductor layers 101A, 101B, and 101C) is formed on the first transparent conductive film 104 (see Fig. 21B). Specifically, the plurality of organic semiconductor layers 101 is formed on the first transparent conductive film 104 in the same manner as in step S24 of the flowchart of Fig. 19.

In next step S45, the high resistance layer 106 is formed in the periphery of the plurality of organic semiconductor layers 101 (see Fig. 22A). Specifically, first, a high resistance material to become the high resistance layer 106 is deposited to cover the plurality of organic semiconductor layers 101 and the first transparent conductive film 104, and then a resist pattern opened at a position corresponding to a portion covering the plurality of organic semiconductors 101 including the high resistance material is formed on the high resistance material. Subsequently, a portion covering the plurality of organic semiconductor layers 101 including the high resistance material is removed by using the resist pattern as a mask to expose the plurality of organic semiconductor layers 101.

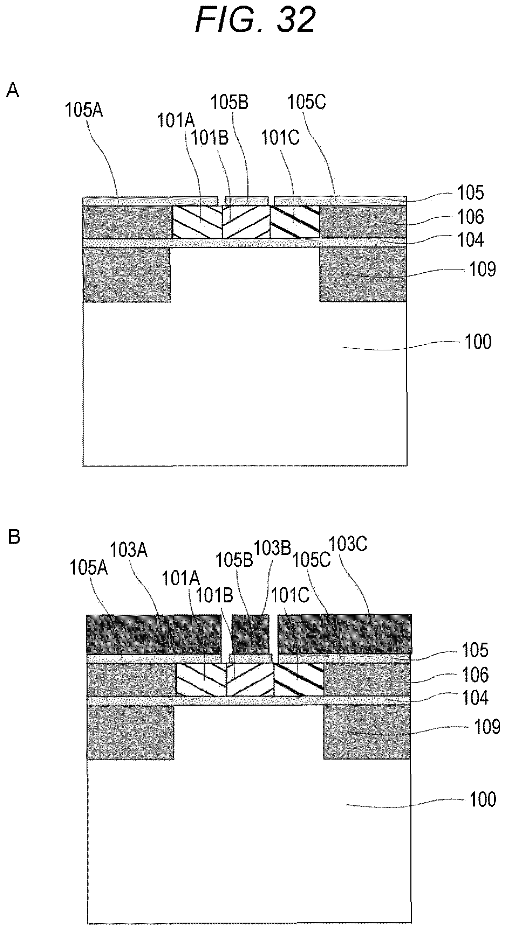

In next step S46, the plurality of corresponding second transparent conductive films 105 is formed on the plurality of organic semiconductor layers 101 (see Fig. 32A). Specifically, first, the material of the second transparent conductive film 105 is solidly deposited on the plurality of organic semiconductor layers 101 by, for example, a vacuum vapor deposition method, sputtering, or the like. Subsequently, a resist pattern is formed on a solid film including the material of the second transparent conductive film 105 to cover a portion of the solid film where the plurality of second transparent conductive films 105 is to be formed. Subsequently, the solid film is etched by using the resist pattern as a mask to form the plurality of second transparent conductive films 105. Thereafter, the resist pattern is removed.

In next step S47, the plurality of corresponding reflectors 103 is formed on the plurality of second transparent conductive films 105 (see Fig. 32B). Specifically, first, the material of the reflector 103 is solidly deposited on the second transparent conductive film 105 by, for example, a vacuum vapor deposition method, a sputtering method, a CVD method, or the like. Subsequently, a resist pattern is formed on the solid film including the material of the reflector 103 to cover a portion of the solid film where the plurality of reflectors 103 is to be formed. Subsequently, the solid film is etched by using the resist pattern as a mask to form the plurality of reflectors 103.

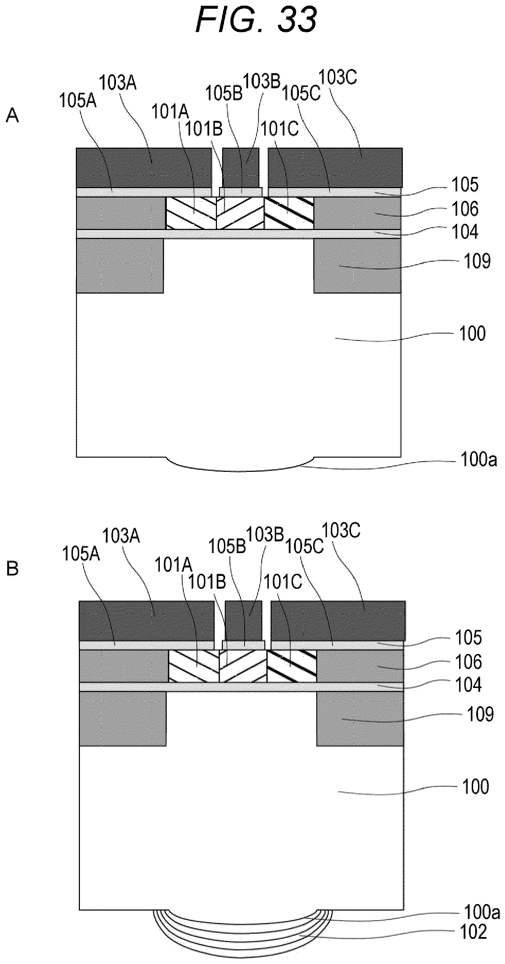

In final step S48, the concave mirror 102 is formed on the back surface (lower surface) of the substrate (wafer). Specifically, first, the back surface of the substrate to become the intermediate layer 100 is polished to be thinned, and then the back surface is etched (for example, dry-etched) to form the convex surface 100a (see Fig. 33A). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 33B). Note that, since heat generated at the time of forming the concave mirror 102 is quickly released to the outside via the intermediate layer 100, the temperature of each organic semiconductor layer 101 can be maintained at, for example, 100°C or lower, and deterioration of the organic semiconductor layer 101 due to heat can be suppressed.

According to the surface-emitting element 10-8, effects similar to the surface-emitting element 10-6 according to Example 6 can be obtained, and since voltages can be individually applied to the plurality of organic semiconductor layers 101, light of desired color (for example, any one of red light, green light, and blue light, or combined light of at least two light rays) can be emitted. Furthermore, in the surface-emitting element 10-8, the color of the emitted light that is the combined light can be adjusted by setting the drive voltages applied to the plurality of organic semiconductor layers 101 to be different.

### <9. Surface-emitting Element according to Example 9 of Embodiment of Present Technology>

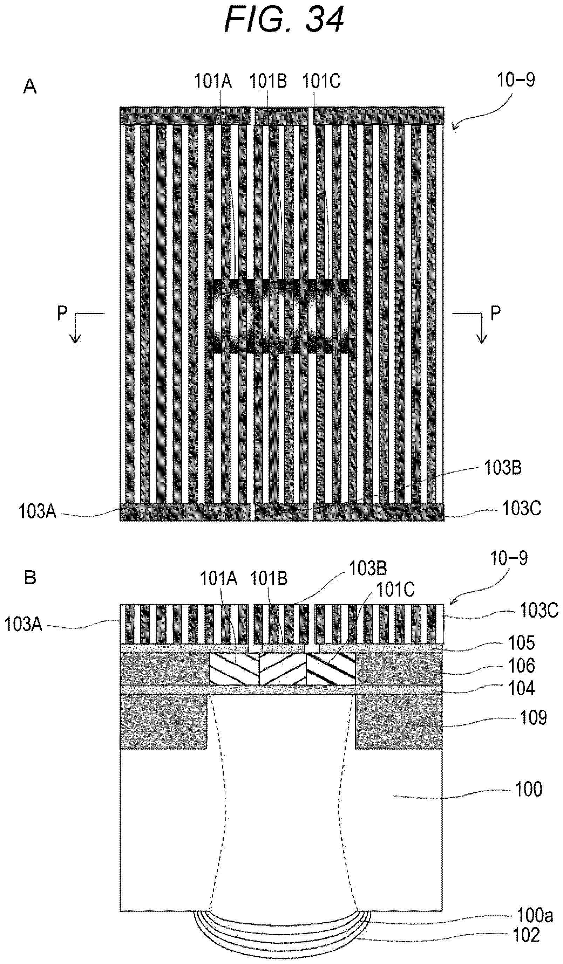

Hereinafter, a surface-emitting element according to Example 9 of the embodiment of the present technology will be described with reference to the drawings. Fig. 34A is a plan view of a surface-emitting element 10-9 according to Example 9 of the embodiment of the present technology. Fig. 34B is a sectional view of the surface-emitting element 10-9 according to Example 9 of the embodiment of the present technology. Fig. 34B is a sectional view taken along line P-P in Fig. 34A.

As illustrated in Figs. 34A and 34B, the surface-emitting element 10-9 has a configuration similar to the surface-emitting element 10-8 according to Example 8 except that each of the plurality of (for example, three) reflectors 103 has a grating structure (diffraction grating structure). In the surface-emitting element 10-9, as an example, a grating pitch of the grating structure is the same between the reflectors 103.

The surface-emitting element 10-9 performs an operation similar to the surface-emitting element 10-8 according to Example 8, and can be manufactured by a manufacturing method similar to the surface-emitting element 10-8 according to Example 8 except that each reflector 103 is formed in the grating structure.

According to the surface-emitting element 10-9, effects similar to the surface-emitting element 10-8 according to Example 8 are obtained, and since each reflector 103 has the grating structure, a high reflectance can be obtained even with a thin film, and a thickness can be reduced while the high reflectance is obtained. Note that, instead of or in addition to the reflector 103 having the grating structure, the concave mirror 102 may have the grating structure.

### <10. Surface-emitting Element according to Example 10 of Embodiment of Present Technology>

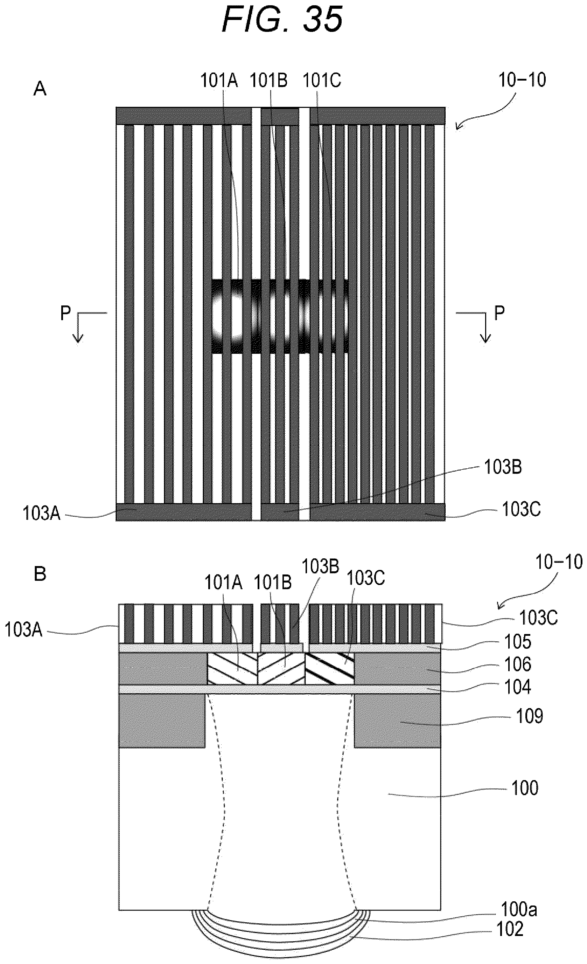

Hereinafter, a surface-emitting element according to Example 10 of the embodiment of the present technology will be described with reference to the drawings. Fig. 35A is a plan view of a surface-emitting element 10-10 according to Example 10 of the embodiment of the present technology. Fig. 35B is a sectional view of the surface-emitting element 10-10 according to Example 10 of the embodiment of the present technology. Fig. 35B is a sectional view taken along line P-P in Fig. 35A.

As illustrated in Figs. 35A and 35B, the surface-emitting element 10-10 has a configuration similar to the surface-emitting element 10-9 according to Example 9 except that the grating pitch of the grating structure (diffraction grating structure) is different between the reflectors 103.

In the surface-emitting element 10-10, the grating pitch of the grating structure is set to be larger for the reflector 103 corresponding to the light on the long wavelength side. Specifically, the grating pitch of the first reflector 103A corresponding to the first organic semiconductor layer 101A that emits red light is set to be the largest, and the grating pitch of the third reflector 103C corresponding to the third organic semiconductor layer 101C that emits blue light is set to be the smallest. Therefore, the reflectance of each reflector 103 is optimized.

The surface-emitting element 10-10 performs an operation similar to the surface-emitting element 10-9 according to Example 9, and can be manufactured by a manufacturing method similar to the surface-emitting element 10-9 according to Example 9 except that each reflector 103 is formed such that the grating pitch of the grating structure is different between the reflectors 103.

According to the surface-emitting element 10-10, effects similar to the surface-emitting element 10-9 according to Example 9 are obtained, and since the grating pitch of each reflector 103 is set to a size corresponding to a wavelength of the corresponding light, it is possible to suppress variation in the reflectance of the corresponding light in each reflector 103.

### <11. Surface-emitting Element according to Example 11 of Embodiment of Present Technology>

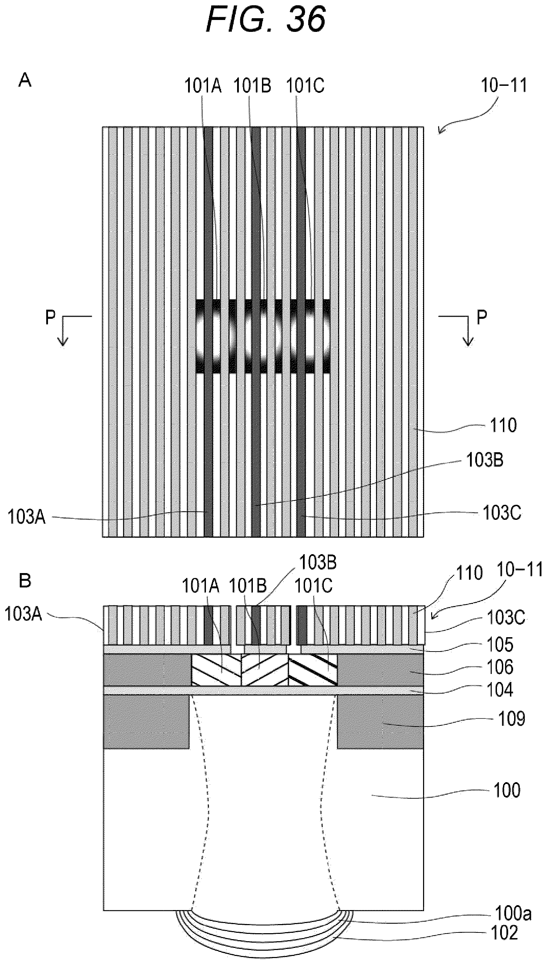

Hereinafter, a surface-emitting element according to Example 11 of the embodiment of the present technology will be described with reference to the drawings. Fig. 36A is a plan view of a surface-emitting element 10-11 according to Example 11 of the embodiment of the present technology. Fig. 36B is a sectional view of the surface-emitting element 10-11 according to Example 11 of the embodiment of the present technology. Fig. 36B is a sectional view taken along line P-P in Fig. 36A.

The surface-emitting element 10-11 has a configuration similar to the surface-emitting element 10-10 according to Example 10 except that the plurality of grating members constituting the grating structure of each reflector 103 includes a material having corrosion resistance except for a part thereof.

The grating structure of each reflector 103 includes at least one metal or alloy grating member (dark gray in Figs. 36A and 36B) positioned on the corresponding organic semiconductor layer 101 and a plurality of grating members (light gray in Figs. 36A and 36B) having corrosion resistance.

The grating member including a metal or an alloy can function as the anode electrode in addition to functioning as a part of the reflector.

The plurality of grating members having corrosion resistance includes, for example, an oxide such as SiO₂ or a nitride such as SiN or SiON.

According to the surface-emitting element 10-11, effects similar to the surface-emitting element 10-9 according to Example 9 are obtained, and since each reflector 103 has corrosion resistance, it is possible to stably operate the surface-emitting element for a long period of time.

### <12. Surface-emitting Element according to Example 12 of Embodiment of Present Technology>

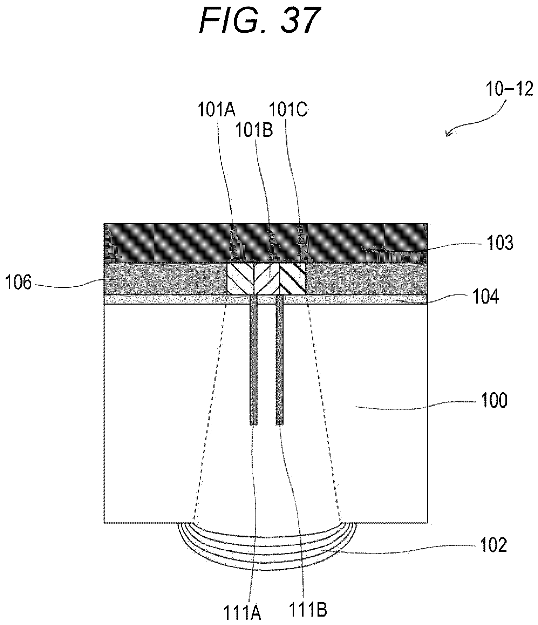

Hereinafter, a surface-emitting element according to Example 12 of the embodiment of the present technology will be described with reference to the drawings. Fig. 37 is a sectional view of a surface-emitting element 10-12 according to Example 12 of the embodiment of the present technology.

As illustrated in Fig. 37, the surface-emitting element 10-12 according to Example 12 has a configuration similar to the surface-emitting element 10-5 according to Example 5 except that drive voltages can be individually applied to the plurality of (for example, three) organic semiconductor layers 101.

In the surface-emitting element 10-12, the first transparent conductive film 104 as the cathode electrode is separated and insulated into three electrode regions corresponding to the plurality of organic semiconductor layers 101 by first and second insulating layers 111A and 111B. The first and second insulating layers 111A and 111B are, for example, ion-injected layers into which high-concentration ions (for example, B⁺⁺, H⁺⁺, and the like) are injected.

Each of the first and second insulating layers 111A and 111B extends from between two adjacent electrode regions of the first transparent conductive film 104 to the inside of the intermediate layer 100. Therefore, it is possible to suppress the current energized to one electrode region from flowing into the other electrode region.

In the surface-emitting element 10-12, the reflector 103 includes a metal or an alloy, and also functions as an anode electrode (common electrode) common to the plurality of organic semiconductor layers 101.

In the surface-emitting element 10-12, at least one of the plurality of organic semiconductor layers 101 can be caused to selectively emit light by selectively applying the drive voltage between the reflector 103 and at least one of the three electrode regions of the first transparent conductive film 104, and thus, laser light of at least one color among a plurality of colors (for example, three colors) can be selectively emitted.

### <<Method for Manufacturing Surface-emitting Element>>

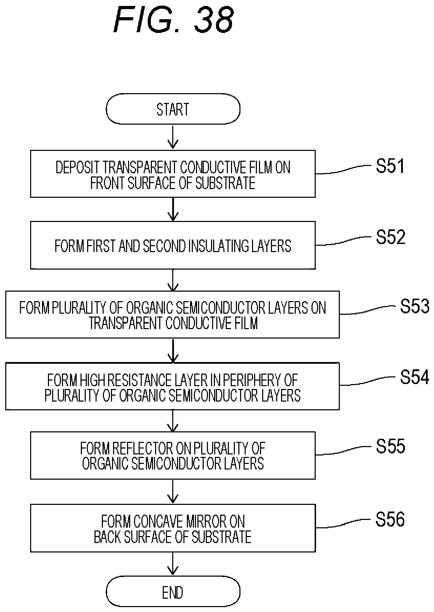

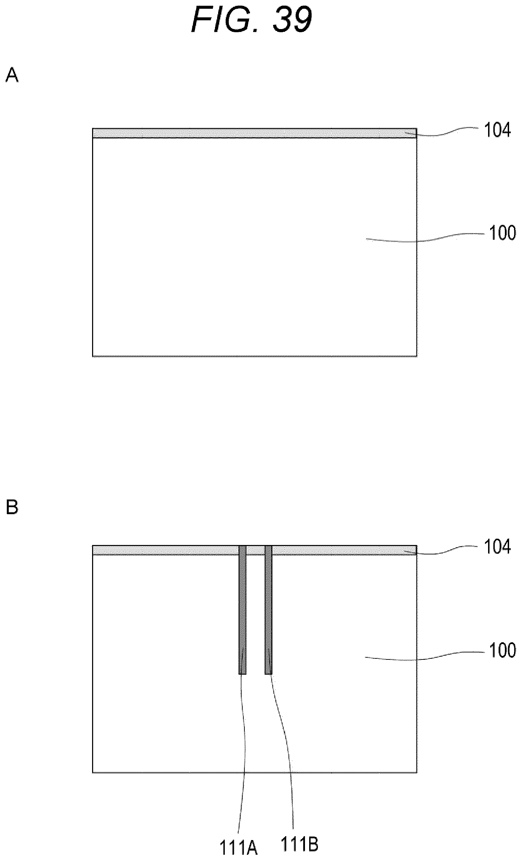

Hereinafter, a method for manufacturing the surface-emitting element 10-12 will be described with reference to the flowchart (steps S51 to S56) in Fig. 38 and the sectional views of Figs. 39A to 41B. Here, as an example, a plurality of surface-emitting elements 10-12 is simultaneously generated on one wafer (for example, GaN substrate) to become the base material of the intermediate layer 100. Subsequently, the plurality of surface-emitting elements 10-12 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-12 is two-dimensionally arranged on one wafer (for example, GaN substrate) to become the base material of the intermediate layer 100 and separating a plurality of integrated surface-emitting element arrays integrated in series from each other.

In first step S51, the first transparent conductive film 104 is deposited on the front surface (upper surface) of the substrate (wafer) to become the intermediate layer 100. Specifically, the first transparent conductive film 104 is deposited on the front surface of the wafer by, for example, a vacuum vapor deposition method, a sputtering method, a chemical vapor deposition (CVD) method, or the like (see Fig. 39A).

In next step S52, the first and second insulating layers 111A and 111B are formed (see Fig. 39B). Specifically, first, a protective film covering a portion other than a portion where the first and second insulating layers 111A and 111B are to be formed is formed on the first transparent conductive film 104. Subsequently, high-concentration ions (for example, B⁺⁺, H⁺⁺, and the like) are injected from the first transparent conductive film 104 side by using the protective film as a mask. An injection depth of ions at this time is, for example, a part until reaching the inside of the intermediate layer 100.

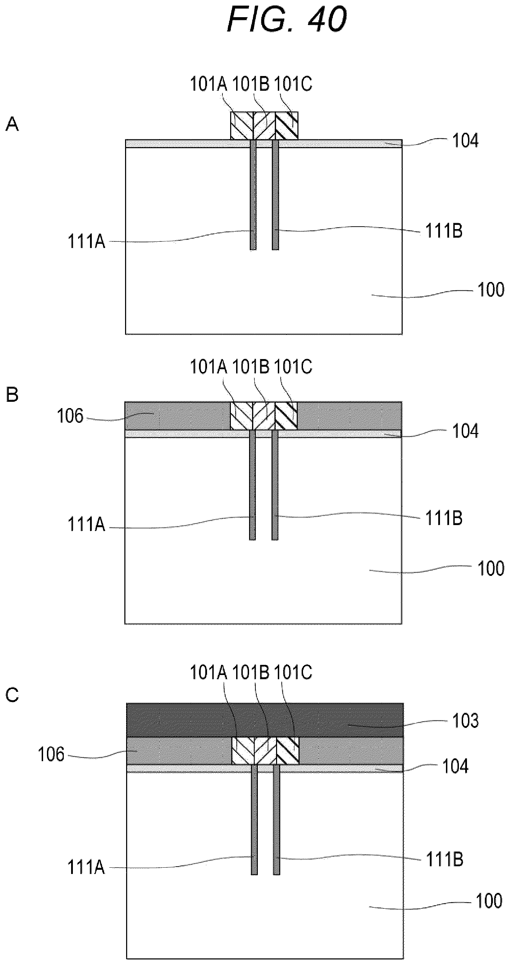

In next step S53, the plurality of (for example, three) organic semiconductor layers 101 (for example, first to third organic semiconductor layers 101A, 101B, and 101C) is formed on the first transparent conductive film 104 (see Fig. 40A). Specifically, the plurality of organic semiconductor layers 101 is formed on the first transparent conductive film 104 in the same manner as in step S24 of the flowchart of Fig. 19.

In next step S54, the high resistance layer 106 is formed in the periphery of the plurality of organic semiconductor layers 101 (see Fig. 40B). Specifically, first, a high resistance material to become the high resistance layer 106 is deposited to cover the plurality of organic semiconductor layers 101 and the first transparent conductive film 104, and then a resist pattern opened at a position corresponding to a portion covering the plurality of organic semiconductors 101 including the high resistance material is formed on the high resistance material. Subsequently, a portion covering the plurality of organic semiconductor layers 101 including the high resistance material is removed by using the resist pattern as a mask to expose the plurality of organic semiconductor layers 101.

In next step S55, the reflector 103 is formed on the plurality of organic semiconductor layers 101. Specifically, the material of the reflector 103 is deposited on the plurality of organic semiconductor layers 101 and the high resistance layer 106 by, for example, a vacuum vapor deposition method, a sputtering method, a CVD method, or the like (see Fig. 40C).

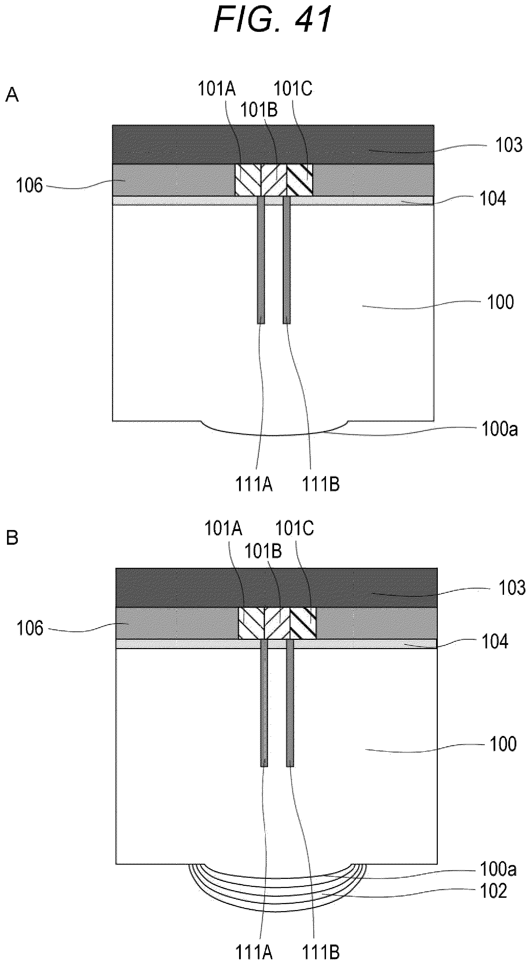

In final step S56, the concave mirror 102 is formed on the back surface (lower surface) of the substrate (wafer). Specifically, first, the back surface of the substrate to become the intermediate layer 100 is polished to be thinned, and then the back surface is etched (for example, dry-etched) to form the convex surface 100a (see Fig. 41A). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 41B). Note that, since heat generated at the time of forming the concave mirror 102 is quickly released to the outside via the intermediate layer 100, the temperature of each organic semiconductor layer 101 can be maintained at, for example, 100°C or lower, and deterioration of the organic semiconductor layer 101 due to heat can be suppressed.

According to the surface-emitting element 10-12, effects similar to the surface-emitting element 10-5 according to Example 5 can be obtained, and since voltages can be individually applied to the plurality of organic semiconductor layers 101, light of desired color can be emitted. Furthermore, in the surface-emitting element 10-12, the color of the emitted light that is the combined light can be adjusted by setting the drive voltages applied to the plurality of organic semiconductor layers 101 to be different.

### <13. Surface-emitting Element according to Example 13 of Embodiment of Present Technology>

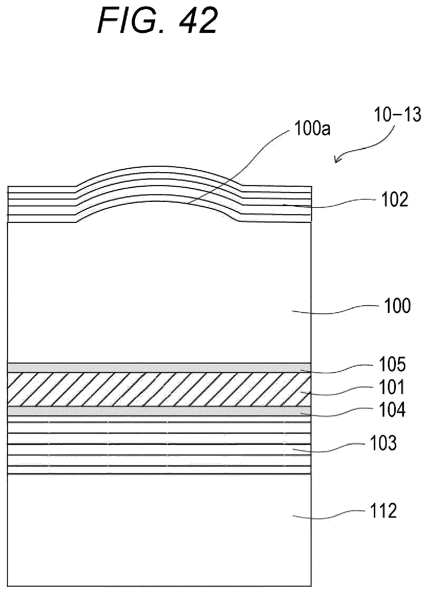

Hereinafter, a surface-emitting element according to Example 13 of the embodiment of the present technology will be described with reference to the drawings. Fig. 42 is a sectional view of a surface-emitting element 10-13 according to Example 13 of the embodiment of the present technology.

As illustrated in Fig. 42, the surface-emitting element 10-13 has a stacked structure in which the reflector 103, the first transparent conductive film 104, the organic semiconductor layer 101, the second transparent conductive film 105, the intermediate layer 100, and the concave mirror 102 are stacked in this order on a substrate 112.

The substrate 112 is, for example, a semiconductor substrate, a semi-insulating substrate, an insulating substrate, or the like.

In the surface-emitting element 10-13, an interval between the organic semiconductor layer 101 and the concave mirror 102 is wider than an interval between the organic semiconductor layer 101 and the reflector 103.

In the surface-emitting element 10-13, as an example, the second transparent conductive film 105 functions as the anode electrode, and the first transparent conductive film 104 functions as the cathode electrode.

The surface-emitting element 10-13 also performs an operation substantially similar to the surface-emitting element 10-1 according to Example 1.

### <<First Example of Method for Manufacturing Surface-emitting Element>>

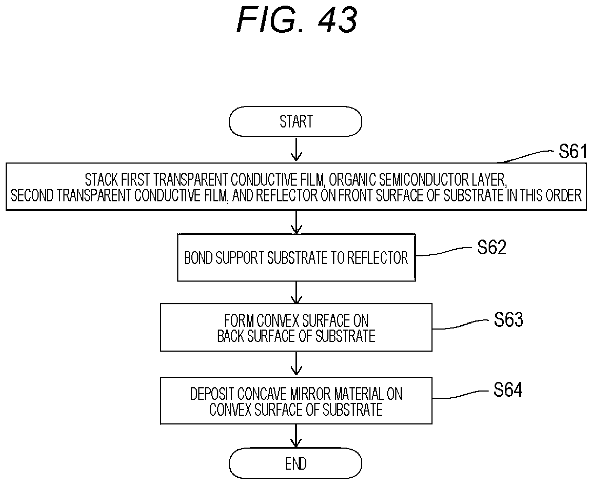

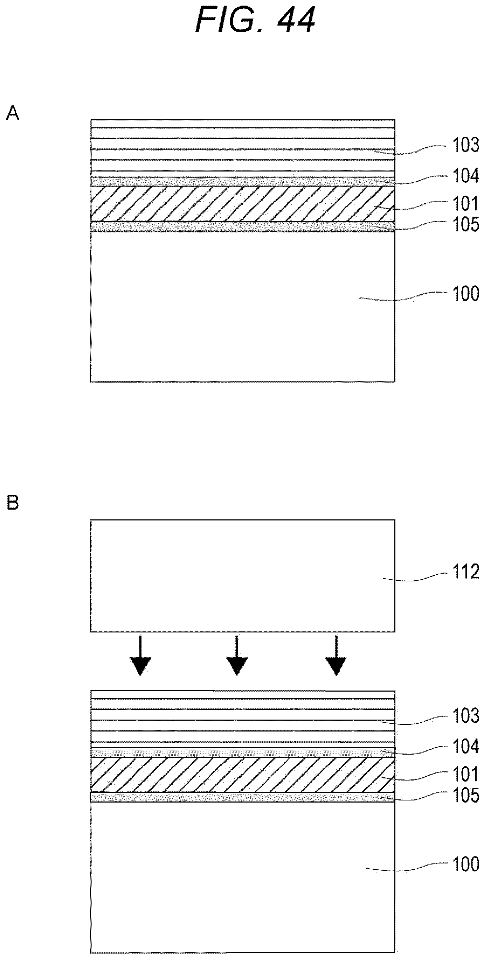

Hereinafter, a first example of a method for manufacturing the surface-emitting element 10-13 will be described with reference to the flowchart (steps S61 to S64) in Fig. 43 and the sectional views of Figs. 44A to 46. Here, as an example, a plurality of surface-emitting elements 10-13 is simultaneously generated on one wafer (for example, GaN substrate) to become the base material of the intermediate layer 100. Subsequently, the plurality of surface-emitting elements 10-13 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-13 is two-dimensionally arranged on one wafer (for example, GaN substrate) to become the base material of the intermediate layer 100 and separating a plurality of integrated surface-emitting element arrays integrated in series from each other.

In first step S61, the first transparent conductive film 104, the organic semiconductor layer 101, the second transparent conductive film 105, and the reflector 103 are stacked in this order on the front surface (upper surface) of the substrate (wafer) to become the intermediate layer 100. Specifically, the layers are sequentially deposited on the front surface of the wafer (for example, GaN substrate) to become the intermediate layer 100 by, for example, a vacuum vapor deposition method, a sputtering method, a chemical vapor deposition (CVD) method, or the like (see Fig. 44A).

In next step S62, the substrate 112 as a support substrate is bonded to the reflector 103 (see Fig. 44B). Specifically, the substrate 112 is attached to the reflector 103.

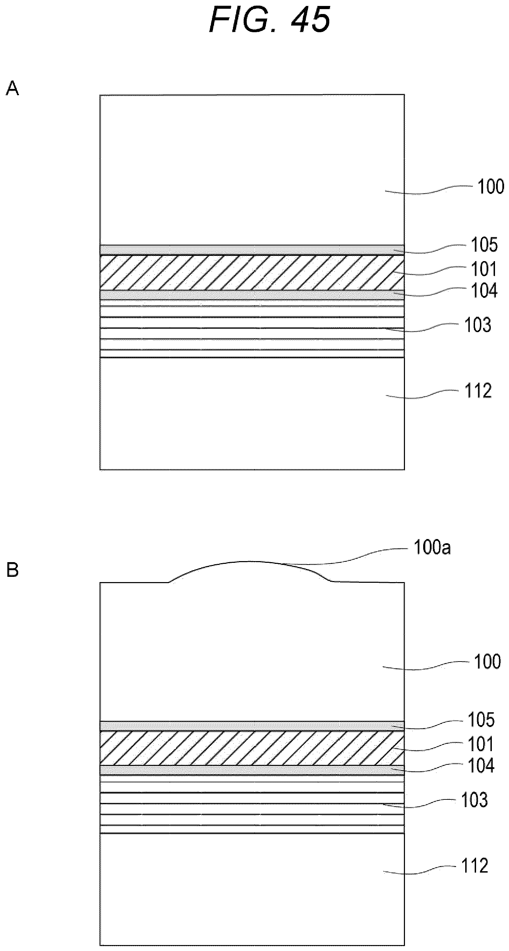

In next step S63, the convex surface 100a is formed on the back surface of the substrate to become the intermediate layer 100. Specifically, the substrate 112 as the support substrate is inverted to become a lowermost layer (see Fig. 45A), the back surface of the substrate to become the intermediate layer 100 is polished to be thinned, and then the back surface is etched (for example, dry-etched) to form the convex surface 100a (see Fig. 45B).

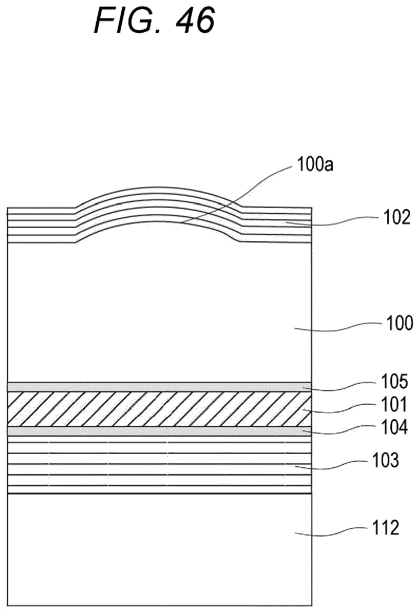

In final step S64, a concave mirror material is deposited on the convex surface 100a of the substrate to become the intermediate layer 100. Specifically, the material of the concave mirror 102 (for example, dielectric multilayer film) is deposited on the convex surface 100a of the substrate to become the intermediate layer 100 by, for example, a vacuum vapor deposition method, a sputtering method, a CVD method, or the like. As a result, the concave mirror 102 having a shape following the convex surface 100a is formed (see Fig. 46). Note that, since heat generated at the time of forming the concave mirror 102 is quickly released to the outside via the intermediate layer 100, the temperature of the organic semiconductor layer 101 can be maintained at, for example, 100°C or lower, and deterioration of the organic semiconductor layer 101 due to heat can be suppressed.

### <<Second Example of Method for Manufacturing Surface-emitting Element>>

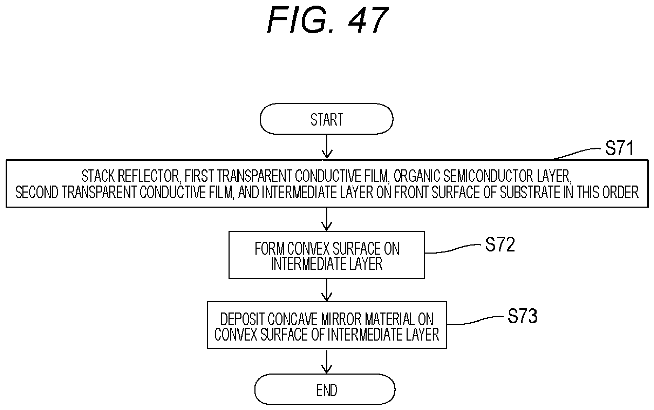

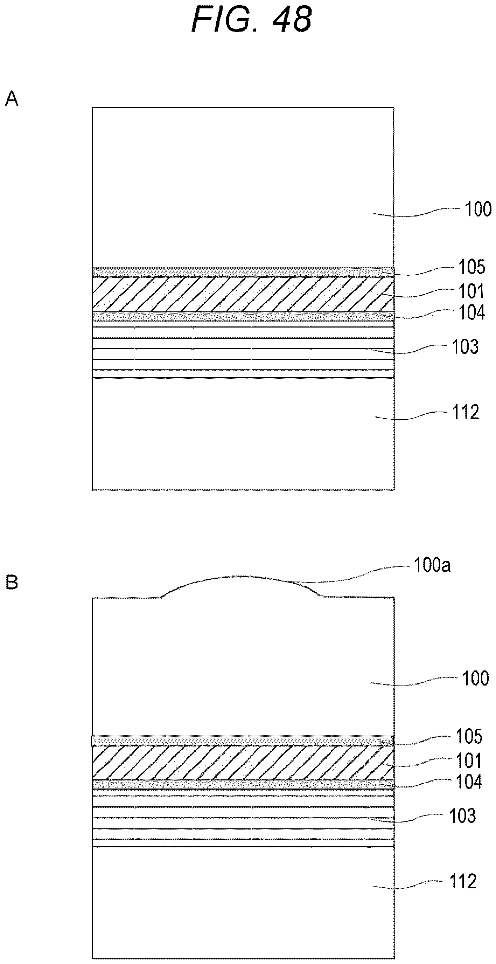

Hereinafter, a second example of a method for manufacturing the surface-emitting element 10-13 will be described with reference to the flowchart (steps S71 to S73) in Fig. 47 and the sectional views of Figs. 48A and 48B. Here, as an example, a plurality of surface-emitting elements 10-13 is simultaneously generated on one wafer (for example, GaN substrate) to become the base material of the intermediate layer 100. Subsequently, the plurality of surface-emitting elements 10-13 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-13 is two-dimensionally arranged on one wafer (for example, GaN substrate) to become the base material of the intermediate layer 100 and separating a plurality of integrated surface-emitting element arrays integrated in series from each other.

In first step S71, the reflector 103, the first transparent conductive film 104, the organic semiconductor layer 101, the second transparent conductive film 105, and the intermediate layer 100 are stacked in this order on the front surface (upper surface) of the wafer to become the substrate 112. Specifically, the layers are sequentially deposited on the front surface of the wafer (for example, GaN substrate) to become the substrate 112 by, for example, a vacuum vapor deposition method, a sputtering method, a chemical vapor deposition (CVD) method, or the like (see Fig. 48A).

In next step S72, the convex surface 100a is formed on the intermediate layer 100 (see Fig. 48B). Specifically, the back surface of the intermediate layer 100 is polished to be thinned, and then the back surface is etched (for example, dry-etched) to form the convex surface 100a (see Fig. 48B).

In final step S73, a concave mirror material is deposited on the convex surface 100a of the intermediate layer 100. Specifically, the material of the concave mirror 102 (for example, dielectric multilayer film) is deposited on the convex surface 100a of the intermediate layer 100 by, for example, a vacuum vapor deposition method, a sputtering method, a CVD method, or the like. As a result, the concave mirror 102 having a shape following the convex surface 100a is formed (see Fig. 46). Note that, since heat generated at the time of forming the concave mirror 102 is quickly released to the outside via the intermediate layer 100, the temperature of the organic semiconductor layer 101 can be maintained at, for example, 100°C or lower, and deterioration of the organic semiconductor layer 101 due to heat can be suppressed.

### <<Third Example of Method for Manufacturing Surface-emitting Element>>

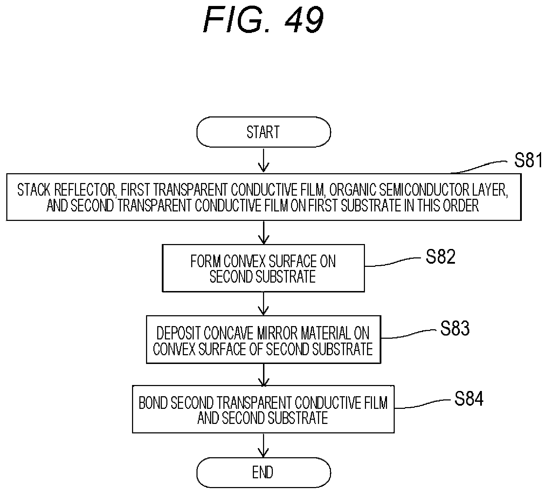

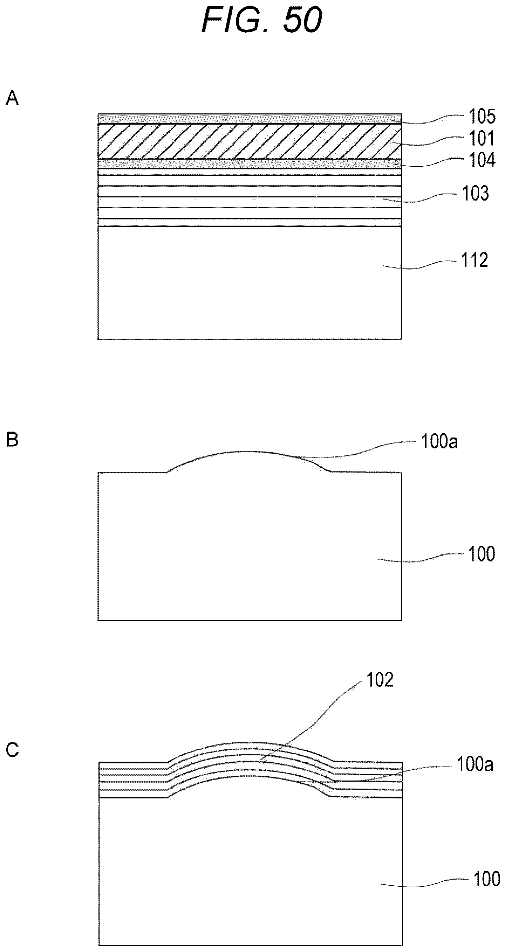

Hereinafter, a third example of a method for manufacturing the surface-emitting element 10-13 will be described with reference to the flowchart (steps S81 to S84) in Fig. 49 and the sectional views of Figs. 50A to 51. Here, as an example, a plurality of surface-emitting elements 10-13 is simultaneously generated on one wafer (for example, GaN substrate) to become the base material of the intermediate layer 100. Subsequently, the plurality of surface-emitting elements 10-13 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-13 is two-dimensionally arranged on one wafer (for example, GaN substrate) to become the base material of the intermediate layer 100 and separating a plurality of integrated surface-emitting element arrays integrated in series from each other.

In first step S81, the reflector 103, the first transparent conductive film 104, the organic semiconductor layer 101, and the second transparent conductive film 105 are stacked in this order on the front surface (upper surface) of the first substrate (wafer) to become the substrate 112 to form a first stacked body. Specifically, the layers are sequentially deposited on the front surface of the first substrate to become the substrate 112 by, for example, a vacuum vapor deposition method, a sputtering method, a chemical vapor deposition (CVD) method, or the like (see Fig. 50A).

In next step S82, the convex surface 100a is formed on the second substrate to become the intermediate layer 100 (see Fig. 50B). Specifically, one surface of the second substrate is etched (for example, dry-etched) to form the convex surface 100a (see Fig. 50B).

In next step S83, a concave mirror material is deposited on the convex surface 100a of the second substrate to become the intermediate layer 100 to generate a second stacked body. Specifically, the material of the concave mirror 102 (for example, dielectric multilayer film) is deposited on the convex surface 100a of the second substrate to become the intermediate layer 100 by, for example, a vacuum vapor deposition method, a sputtering method, a CVD method, or the like. As a result, the concave mirror 102 having a shape following the convex surface 100a is formed (see Fig. 50C).

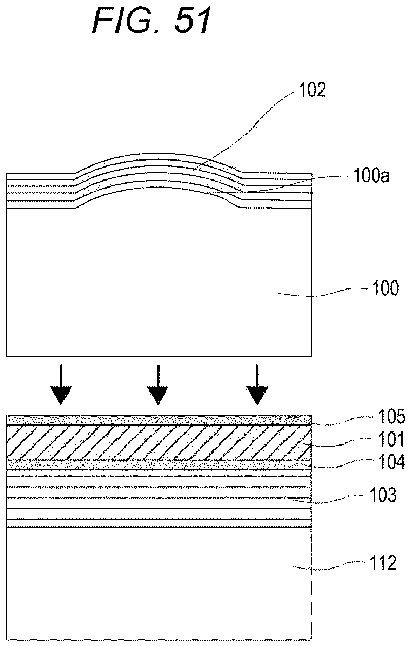

In final step S84, the second transparent conductive film 105 and the second substrate to become the intermediate layer 100 are bonded (see Fig. 51). Specifically, the second substrate to become the intermediate layer 100 is attached to the second transparent conductive film 105.

According to the third example of the method for manufacturing the surface-emitting element 10-13 described above, since the first stacked body including the organic semiconductor layer 101 and the second stacked body including the concave mirror 102 are separately fabricated and the first and second stacked bodies are joined, heat generated at the time of forming the concave mirror 102 is effectively prevented from being transmitted to the organic semiconductor layer 101.

According to the surface-emitting element 10-13 described above, effects similar to the surface-emitting element 10-1 according to Example 1 are obtained, and a surface-emitting element having a simple configuration and capable of being manufactured by various manufacturing methods can be realized.

### <14. Surface-emitting Element according to Example 14 of Embodiment of Present Technology>

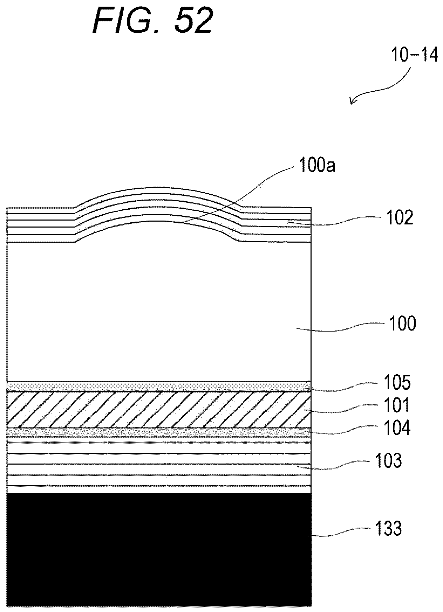

Hereinafter, a surface-emitting element according to Example 14 of the embodiment of the present technology will be described with reference to the drawings. Fig. 52 is a sectional view of a surface-emitting element 10-14 according to Example 14 of the embodiment of the present technology.

As illustrated in Fig. 52, the surface-emitting element 10-14 has a configuration similar to the surface-emitting element 10-14 according to Example 13 except that a transistor 133 is included instead of the substrate 112.

The transistor 133 constitutes a part of the laser driver, and performs switching of a current or a voltage applied to the organic semiconductor layer 101. The laser driver includes a power supply, a capacitor, and the like in addition to the transistor 133.

A circuit element of the laser driver including the transistor 133 is fabricated, for example, on a semiconductor substrate by using a photolithography method.

The surface-emitting element 10-14 can be manufactured by a manufacturing method similar to the surface-emitting element 10-13 of Example 13 except that the transistor 133 is formed.

In the surface-emitting element 10-14, since the organic semiconductor layer 101 can be directly driven by the transistor 133, responsiveness can be improved.

### <15. Surface-emitting Element according to Example 15 of Embodiment of Present Technology>

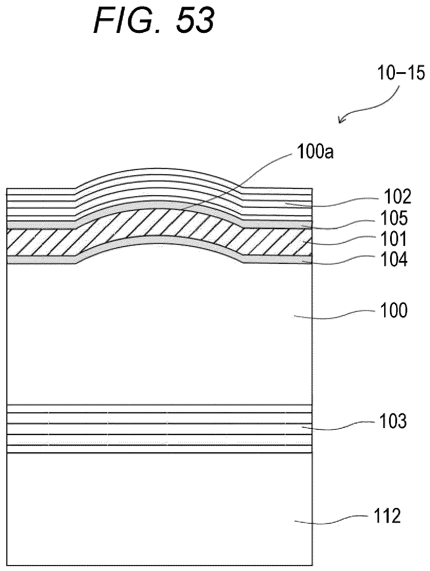

Hereinafter, a surface-emitting element according to Example 15 of the embodiment of the present technology will be described with reference to the drawings. Fig. 53 is a sectional view of a surface-emitting element 10-15 according to Example 15 of the embodiment of the present technology.

The surface-emitting element 10-15 has a configuration similar to the surface-emitting element 13 according to Example 13 except that the first and second transparent conductive films 104 and 105 and the organic semiconductor layer 101 are arranged between the concave mirror 102 and the intermediate layer 100. In the surface-emitting element 10-15, an interval between the organic semiconductor layer 101 and the concave mirror 102 is narrower than an interval between the organic semiconductor layer 101 and the reflector 103.

The surface-emitting element 10-15 also performs an operation substantially similar to the surface-emitting element 10-13 according to Example 13.

### <<Method for Manufacturing Surface-emitting Element>>

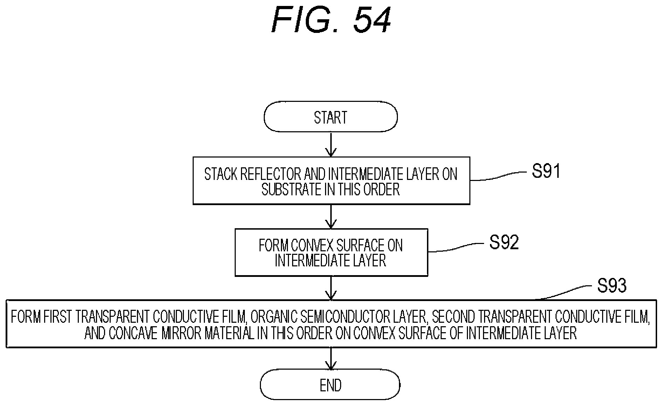

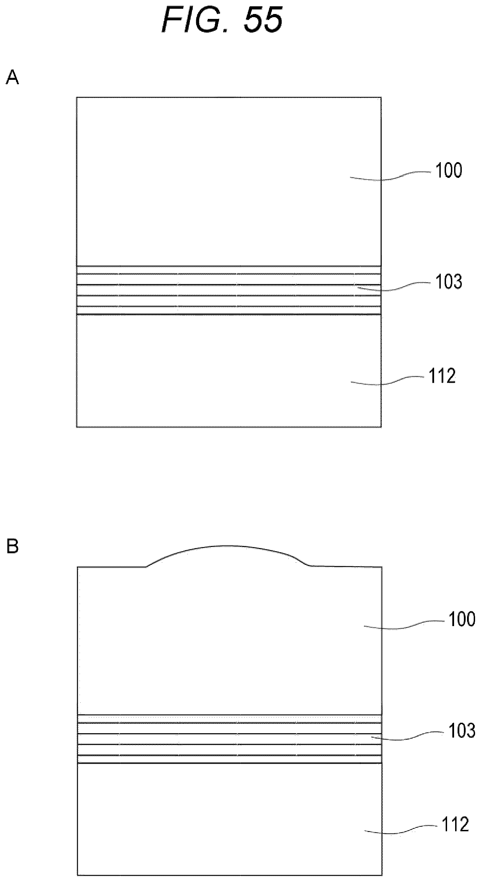

Hereinafter, a method for manufacturing the surface-emitting element 10-15 will be described with reference to the flowchart (steps S91 to S93) in Fig. 54 and the sectional views of Figs. 55A to 56. Here, as an example, a plurality of surface-emitting elements 10-15 is simultaneously generated on one wafer (for example, GaN substrate) to become the base material of the intermediate layer 100. Subsequently, the plurality of surface-emitting elements 10-15 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-15 is two-dimensionally arranged on one wafer (for example, GaN substrate) to become a base material of the intermediate layer 100 and separating a plurality of integrated surface-emitting element arrays integrated in series from each other.

In first step S91, the reflector 103 and the intermediate layer 100 are stacked in this order on the wafer to become the substrate 112. Specifically, the reflector 103 and the intermediate layer 100 are sequentially deposited on the front surface of the wafer to become the substrate 112 by, for example, a vacuum vapor deposition method, a sputtering method, a chemical vapor deposition (CVD) method, or the like (see Fig. 55A) .

In next step S92, the convex surface 100a is formed on the intermediate layer 100 (see Fig. 55B). Specifically, the back surface of the intermediate layer 100 is polished to be thinned, and then the back surface is etched (for example, dry-etched) to form the convex surface 100a.

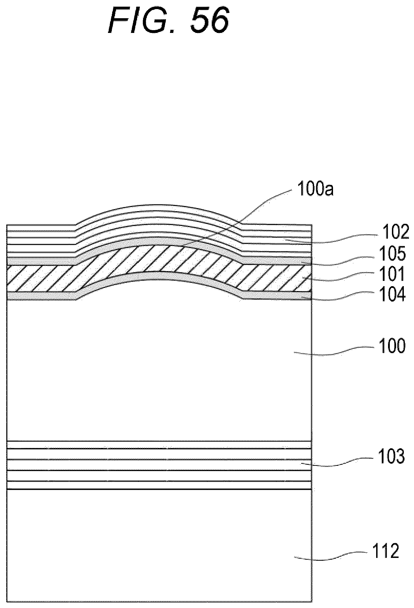

In final step S93, the first transparent conductive film 104, the organic semiconductor layer 101, the second transparent conductive film 105, and the concave mirror material are deposited in this order on the convex surface 100a of the intermediate layer 100. Specifically, materials (for example, dielectric multilayer films) of the first transparent conductive film 104, the organic semiconductor layer 101, the second transparent conductive film 105, and the concave mirror 102 are deposited on the convex surface 100a of the intermediate layer 100 by, for example, a vacuum vapor deposition method, a sputtering method, a CVD method, or the like. As a result, the first transparent conductive film 104, the organic semiconductor layer 101, the second transparent conductive film 105, and the concave mirror 102 are formed in a shape following the convex surface 100a (see Fig. 56).

According to the surface-emitting element 10-15, the light reflected by the concave mirror 102 can be reliably incident on the organic semiconductor layer 101 regardless of the thickness of the intermediate layer 100 and the power of the concave mirror 102. That is, the thickness of the intermediate layer 100 and a degree of freedom in setting the power of the concave mirror 102 are high.

### <16. Surface-emitting Element according to Example 16 of Embodiment of Present Technology>

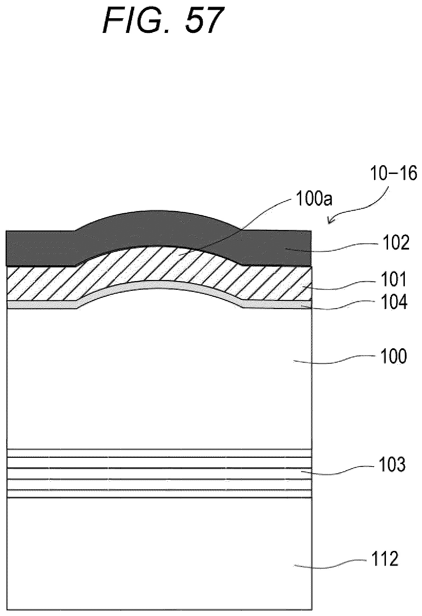

Hereinafter, a surface-emitting element according to Example 16 of the embodiment of the present technology will be described with reference to the drawings. Fig. 57 is a sectional view of a surface-emitting element 10-16 according to Example 16 of the embodiment of the present technology.

As illustrated in Fig. 57, the surface-emitting element 10-16 has a configuration substantially similar to the surface-emitting element 10-15 according to Example 15 except that the second transparent conductive film 105 is not included.

In the surface-emitting element 10-16, as an example, the concave mirror 102 includes a metal or an alloy, and also functions as the anode electrode. The first transparent conductive film 104 functions as the cathode electrode.

In the surface-emitting element 10-16, as an example, the reflector 103 includes a dielectric or a semiconductor and is a reflector on the emission side.

In the surface-emitting element 10-16, the substrate 112 is a substrate transparent to the emission wavelength of the organic semiconductor layer 101. That is, the surface-emitting element 10-16 emits light to the back surface side (lower surface side) of the substrate 112.

The surface-emitting element 10-16 can be manufactured by a manufacturing method substantially similar to the surface-emitting element 10-15 according to Example 15.

According to the surface-emitting element 10-16, effects substantially similar to the surface-emitting element 10-15 according to Example 15 are obtained.

### <17. Surface-emitting Element according to Example 17 of Embodiment of Present Technology>

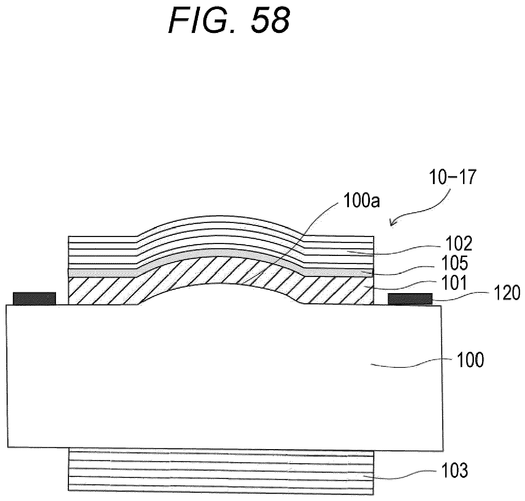

Hereinafter, a surface-emitting element according to Example 17 of the embodiment of the present technology will be described with reference to the drawings. Fig. 58 is a sectional view of a surface-emitting element 10-17 according to Example 17 of the embodiment of the present technology.

As illustrated in Fig. 58, the surface-emitting element 10-17 has a configuration substantially similar to the surface-emitting element 10-15 according to Example 15 except that an electrode member 120 is included instead of the first transparent conductive film 104.

In the surface-emitting element 10-17, the intermediate layer 100 protrudes to both sides in the in-plane direction as compared with other layers, and the frame-shaped (for example, annular) electrode member 120 is provided on a protrusion portion. The intermediate layer 100 includes a material having conductivity. In the surface-emitting element 10-17, a current path of the current injected into the organic semiconductor layer 101 is present in the intermediate layer 100.

The surface-emitting element 10-17 also performs an operation substantially similar to the surface-emitting element 10-15 according to Example 15.

### <<Method for Manufacturing Surface-emitting Element>>

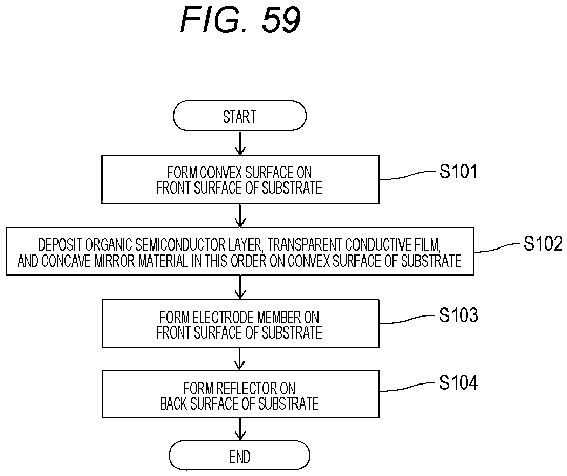

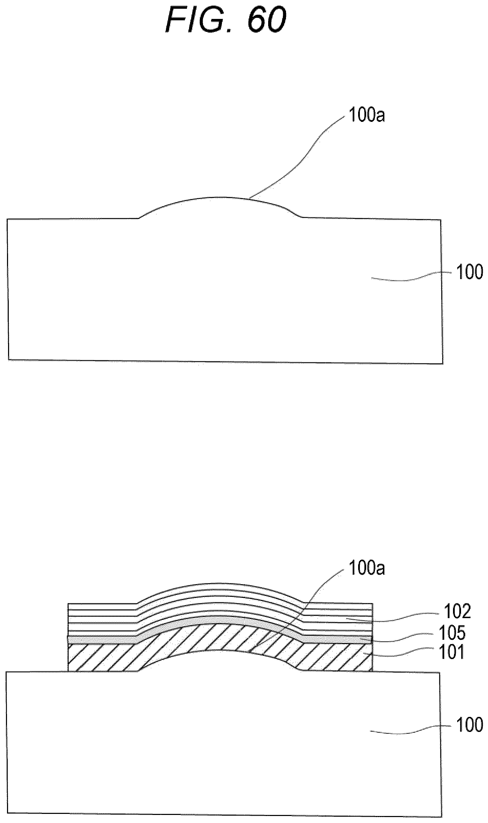

Hereinafter, a method for manufacturing the surface-emitting element 10-17 will be described with reference to the flowchart (steps S101 to S104) in Fig. 59 and the sectional views of Figs. 60A to 61B. Here, as an example, a plurality of surface-emitting elements 10-17 is simultaneously generated on one wafer (for example, GaN substrate) to become the base material of the intermediate layer 100. Subsequently, the plurality of surface-emitting elements 10-17 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-17 is two-dimensionally arranged on one wafer (for example, GaN substrate) to become the base material of the intermediate layer 100 and separating a plurality of integrated surface-emitting element arrays integrated in series from each other.

In first step S101, the convex surface 100a is formed on the front surface of the substrate to become the intermediate layer 100 (see Fig. 60A). Specifically, the front surface of the intermediate layer 100 is polished to be thinned, and then the front surface is etched (for example, dry-etched) to form the convex surface 100a.

In next step S102, the organic semiconductor layer 101, the second transparent conductive film 105 (transparent conductive film), and the concave mirror material are stacked in this order on the convex surface 100a of the substrate to become the intermediate layer 100 (see Fig. 60B). Specifically, the materials (for example, a dielectric multilayer film, a semiconductor multilayer film, or the like) of the organic semiconductor layer 101, the second transparent conductive film 105, and the concave mirror 102 are sequentially deposited on the convex surface 100a of the substrate to become the intermediate layer 100 by, for example, a vacuum vapor deposition method, a sputtering method, a chemical vapor deposition (CVD) method, or the like (see Fig. 60B). As a result, the organic semiconductor layer 101, the second transparent conductive film 105, and the concave mirror 102 are formed in a shape following the convex surface 100a.

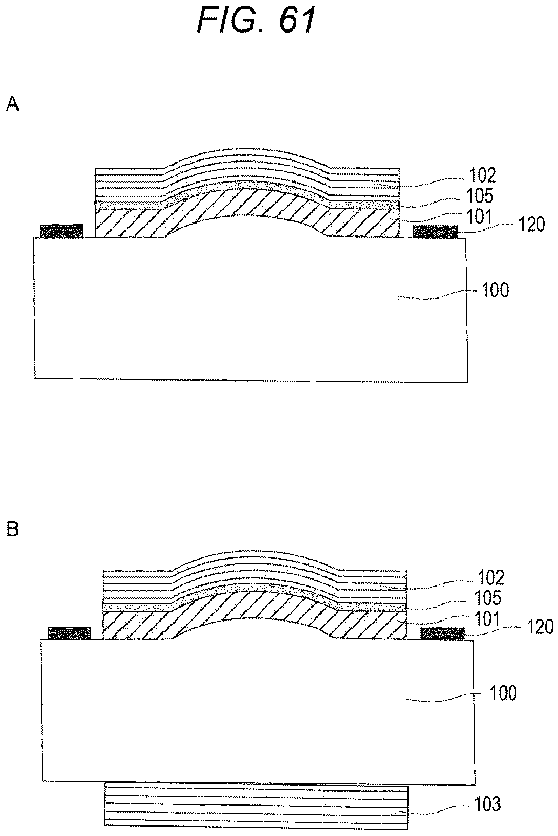

In next step S103, the electrode member 120 is formed on the front surface of the substrate to become the intermediate layer 100 (see Fig. 61A). Specifically, for example, the material of the electrode member 120 is formed on the front surface of the intermediate layer 100 to surround the organic semiconductor layer 101 by using a lift-off method.

In final step S104, the reflector 103 is formed on the back surface of the substrate to become the intermediate layer 100 (see Fig. 61B). Specifically, the material of the reflector 103 (for example, a dielectric multilayer film, a semiconductor multilayer film, or the like) is deposited on the back surface of the intermediate layer 100 by, for example, a vacuum vapor deposition method, a sputtering method, a CVD method, or the like.

According to the surface-emitting element 10-17, effects substantially similar to the surface-emitting element 10-15 according to Example 15 are obtained.

### <18. Surface-emitting Element according to Example 18 of Embodiment of Present Technology>

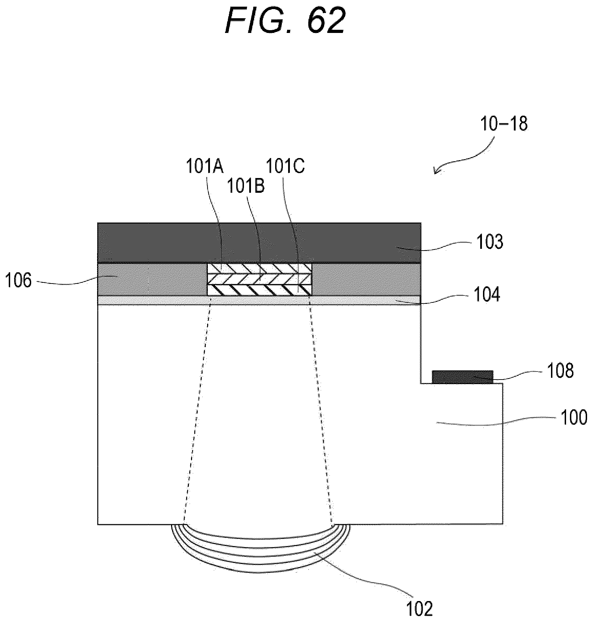

Hereinafter, a surface-emitting element according to Example 18 of the embodiment of the present technology will be described with reference to the drawings. Fig. 62 is a sectional view of a surface-emitting element 10-18 according to Example 18 of the embodiment of the present technology.

As illustrated in Fig. 62, the surface-emitting element 10-18 has a configuration substantially similar to the surface-emitting element 10-3 according to Example 3 and the surface-emitting element 10-5 according to Example 5 except that the plurality of organic semiconductor layers 101 (for example, first to third organic semiconductor layers 101A, 101B, and 101C) is stacked in the up-down direction.

Incidentally, a position of an antinode of a standing wave in the resonator varies depending on the wavelength of the light emitted from the organic semiconductor layer (emission wavelength of the organic semiconductor layer).

Therefore, in the surface-emitting element 10-18, positions of the plurality of organic semiconductor layers 101 in the stacking direction are set such that the position of each organic semiconductor layer 101 in the stacking direction substantially coincides with the position of the antinode of the standing wave of the light emitted from the organic semiconductor layer 101. Therefore, a light amplification effect in each organic semiconductor layer 101 can be improved (high gain can be obtained).

Specifically, as an example, among the first to third organic semiconductor layers 101A, 101B, and 101C, the first organic semiconductor layer 101A that emits red light is arranged at a position closest to the reflector 103, and the third organic semiconductor layer 101C that emits blue light is arranged at a position farthest from the reflector 103. Note that the disposition of the first to third organic semiconductor layers 101A, 101B, and 101C may be reversed upside down depending on the position of the antinode of the standing wave of each color light.

The surface-emitting element 10-18 can also be manufactured by a manufacturing method substantially similar to the surface-emitting element 10-1 of Example 1.

According to the surface-emitting element 10-18, since a high gain can be obtained in each organic semiconductor layer 101, the threshold current can be reduced, and a highly efficient surface-emitting element can be realized.

### <19. Surface-emitting Element according to Example 19 of Embodiment of Present Technology>

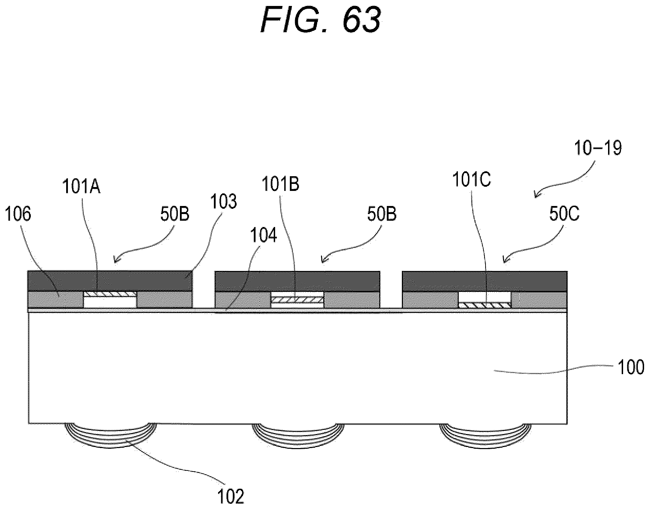

Hereinafter, a surface-emitting element according to Example 19 of the embodiment of the present technology will be described with reference to the drawings. Fig. 63 is a sectional view of a surface-emitting element 10-19 according to Example 19 of the embodiment of the present technology.

As illustrated in Fig. 63, the surface-emitting element 10-19 includes a plurality of light emitting element portions 50 (for example, the plurality of light emitting element portions 50 including the first to third light emitting element portions 50A, 50B, and 50C) arranged in the array shape (for example, two-dimensionally arranged), and constitutes the surface-emitting laser array as a whole.

The organic semiconductor layers 101 of at least two light emitting element portions 50 among the plurality of light emitting element portions 50 may have different emission wavelengths. As an example, the first light emitting element portion 50A has the first organic semiconductor layer 101A that emits red light, the second light emitting element portion 50B has the second organic semiconductor layer 101B that emits green light, and the third light emitting element portion 50C has the third organic semiconductor layer 101 C that emits blue light. That is, the emission wavelengths of the organic semiconductor layers 101 of the first to third light emitting element portions 50A, 50B, and 50C are different from each other.

The positions of the organic semiconductor layers 101 of the at least two light emitting element portions 50 in the stacking direction may be different. As an example, the positions of the first to third organic semiconductor layers 101A, 101B, and 101C in the stacking direction (up-down direction) are different. More specifically, in the stacking direction, the first organic semiconductor layer 101A is arranged at a position farthest from the intermediate layer 100, and the third organic semiconductor layer 101C is arranged at a position closest to the intermediate layer 100. Each organic semiconductor layer 101 is arranged at the position of v antinode of the standing wave of the corresponding light. Note that, the disposition of the plurality of organic semiconductor layers 101 may be reversed upside down depending on the position of the antinode of the standing wave.

In the surface-emitting element 10-19, as an example, the plurality of light emitting element portions 50 has separate reflectors 103 (anode electrodes), and the first transparent conductive film 104 is a cathode electrode common to the plurality of light emitting element portions 50. Accordingly, voltages can be individually applied to the plurality of organic semiconductor layers 101, and the plurality of light emitting element portions 50 can be individually driven.

According to the surface-emitting element 10-19, it is possible to realize a surface-emitting laser array that can individually drive the light emitting element portions 50 and can be driven with high efficiency.

### <20. Surface-emitting Element according to Example 20 of Embodiment of Present Technology>

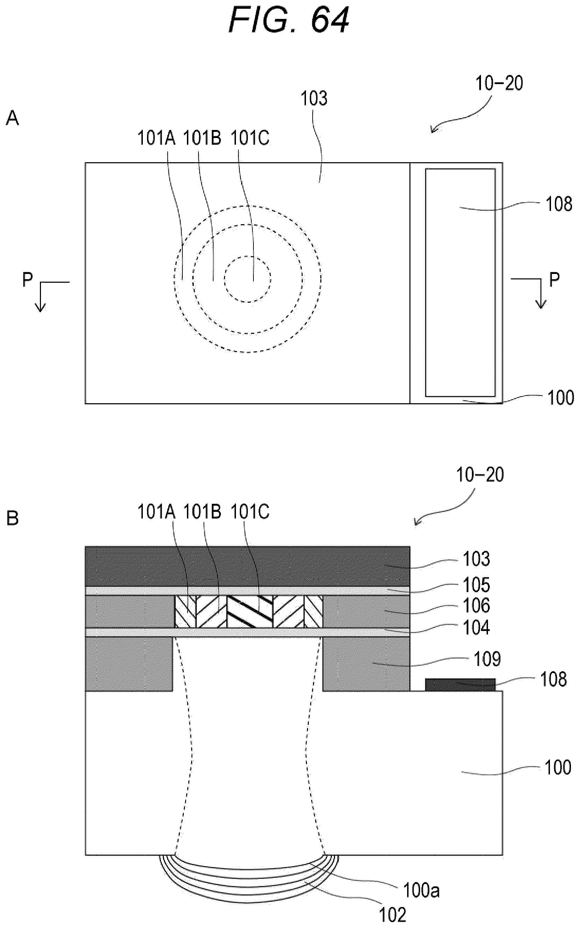

Hereinafter, a surface-emitting element according to Example 20 of the embodiment of the present technology will be described with reference to the drawings. Fig. 64A is a plan view of a surface-emitting element 10-20 according to Example 20 of the embodiment of the present technology. Fig. 64B is a sectional view of the surface-emitting element 10-20 according to Example 20 of the embodiment of the present technology. Fig. 64B is a sectional view taken along line P-P in Fig. 64A.

As illustrated in Figs. 64A and 64B, the surface-emitting element 10-20 has a configuration substantially similar to the surface-emitting element 10-3 according to Example 3 and the surface-emitting element 10-6 according to Example 6 except that the plurality of organic semiconductor layers 101 is concentrically arranged.

The surface-emitting element 10-20 performs an operation similar to the surface-emitting element 10-6 according to Example 6, and can be manufactured by a similar manufacturing method.

In the surface-emitting element 10-20, as an example, the third organic semiconductor layer 101C has a columnar shape, the second organic semiconductor layer 101B has a concentric annular shape surrounding the third organic semiconductor layer 101C, and the first organic semiconductor layer 101A has a concentric annular shape surrounding the second organic semiconductor layer 101B. A center of each organic semiconductor layer 101 is positioned on an optical axis of the concave mirror. The organic semiconductor layers 101 are concentrically positioned in this manner, and thus, the light emitted from each organic semiconductor layer 101 and the light via the organic semiconductor layer 101 can be accurately reflected toward the organic semiconductor layer 101 by the concave mirror 102, and a high gain can be obtained in the organic semiconductor layer 101.

### <21. Surface-emitting Element according to Example 21 of Embodiment of Present Technology>

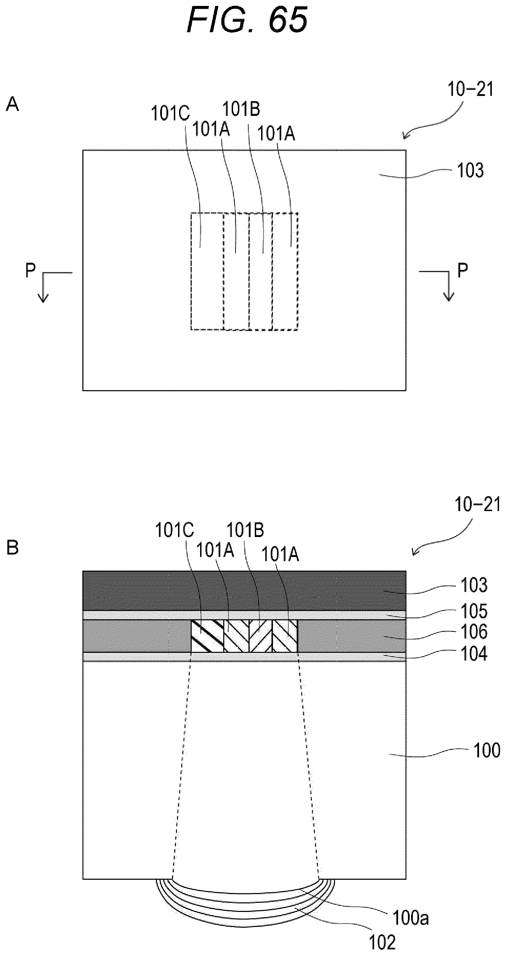

Hereinafter, a surface-emitting element according to Example 21 of the embodiment of the present technology will be described with reference to the drawings. Fig. 65A is a plan view of a surface-emitting element 10-21 according to Example 21 of the embodiment of the present technology. Fig. 65B is a sectional view of the surface-emitting element 10-21 according to Example 21 of the embodiment of the present technology. Fig. 65B is a sectional view taken along line P-P in Fig. 65A.

As illustrated in Figs. 65A and 65B, the surface-emitting element 10-21 has a configuration similar to the surface-emitting element 10-5 according to Example 5 except that the plurality of (for example, two) organic semiconductor layers that emit light rays of the same color is provided.

In the surface-emitting element 10-21, as an example, two first organic semiconductor layers 101A, a second organic semiconductor layer 101B, and a third organic semiconductor layer 101C are arranged side by side in the in-plane direction.

The surface-emitting element 10-21 performs an operation similar to the surface-emitting element 10-5 according to Example 5, and can be manufactured by a similar manufacturing method.

According to the surface-emitting element 10-21, it is possible to emit light of color obtained by mixing one color (for example, red) with white light.

### <22. Surface-emitting Element according to Example 22 of Embodiment of Present Technology>

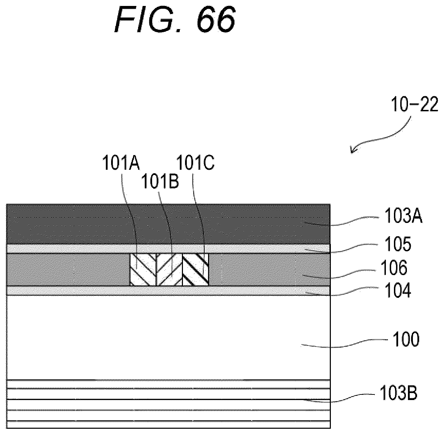

Hereinafter, a surface-emitting element according to Example 22 of the embodiment of the present technology will be described with reference to the drawings. Fig. 66 is a sectional view of a surface-emitting element 10-22 according to Example 22 of the embodiment of the present technology.

As illustrated in Fig. 66, the surface-emitting element 10-22 has a configuration substantially similar to the surface-emitting element 10-5 according to Example 5 except that a second reflector 103B is also a plane mirror in addition to the first reflector 103A. The first reflector 103A is substantially the same as the reflector 103 (for example, plane mirror).

Since the surface-emitting element 10-22 does not use the concave mirror, the intermediate layer 100 cannot be thickened, that is, the resonator length cannot be lengthened. The temperature rise when the surface-emitting element is continuously driven for a long time cannot be sufficiently suppressed, and thus, there is a concern about reliability. However, it is considered that the surface-emitting element can withstand practical use according to applications such as use for short-time driving.

### <<Method for Manufacturing Surface-emitting Element>>

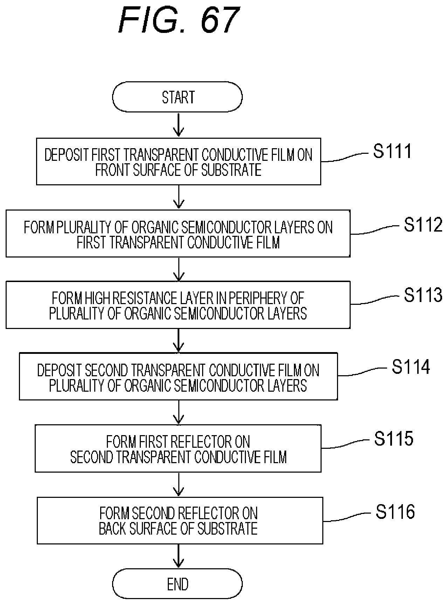

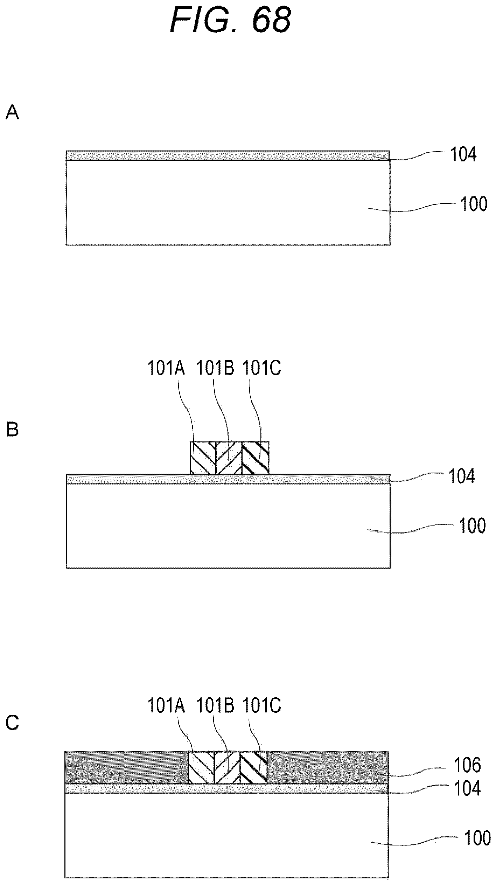

Hereinafter, a method for manufacturing the surface-emitting element 10-22 will be described with reference to the flowchart (steps S111 to S116) in Fig. 67 and the sectional views of Figs. 68A to 69C. Here, as an example, a plurality of surface-emitting elements 10-22 is simultaneously generated on one wafer (for example, GaN substrate) to become the base material of the intermediate layer 100. Subsequently, the plurality of surface-emitting elements 10-22 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-22 is two-dimensionally arranged on one wafer (for example, GaN substrate) to become the base material of the intermediate layer 100 and separating a plurality of integrated surface-emitting element arrays integrated in series from each other.

In first step S111, the first transparent conductive film 104 is stacked on the front surface (upper surface) of the substrate (wafer) to become the intermediate layer 100. Specifically, the first transparent conductive film 104 is deposited on the front surface of the wafer (for example, GaN substrate) to become the intermediate layer 100 by, for example, a vacuum vapor deposition method, a sputtering method, a chemical vapor deposition (CVD) method, or the like (see Fig. 68A).

In next step S112, the plurality of organic semiconductor layers 101 is formed on the first transparent conductive film 104. The plurality of (for example, three) organic semiconductor layers 101 (for example, first to third organic semiconductor layers 101A, 101B, and 101C) is formed on the first transparent conductive film 104 (see Fig. 68B). Specifically, the plurality of organic semiconductor layers 101 is formed on the first transparent conductive film 104 in the same manner as in step S24 of the flowchart of Fig. 19.

In next step S113, the high resistance layer 106 is formed in the periphery of the plurality of organic semiconductor layers 101. Specifically, a high resistance material to become the high resistance layer 106 is deposited to cover the plurality of organic semiconductor layers 101 and the first transparent conductive film 104, and then only a portion covering the plurality of organic semiconductors 101 including the material is removed by etching to expose the plurality of organic semiconductor layers 101 (see Fig. 68C).

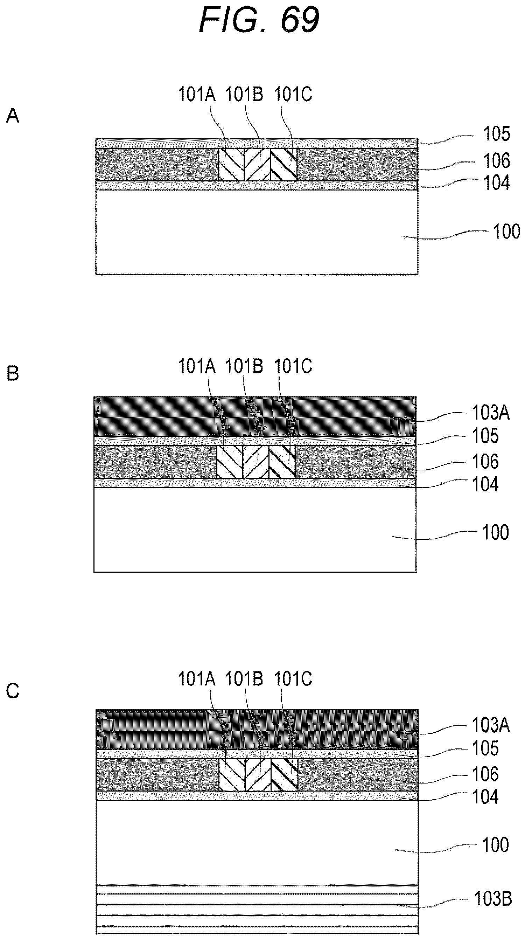

In next step S114, the second transparent conductive film 105 is deposited on the plurality of organic semiconductor layers 101 and the high resistance layer 106. Specifically, the second transparent conductive film 105 is deposited on the plurality of organic semiconductor layers 101 and the high resistance layer 106 by, for example, a vacuum vapor deposition method, sputtering, or the like (see Fig. 69A).

In next step S115, the first reflector 103A is formed on the second transparent conductive film 105. Specifically, the material of the first reflector 103A is deposited on the second transparent conductive film 105 by, for example, a vacuum vapor deposition method, a sputtering method, a CVD method, or the like (see Fig. 69B) .

In final step S116, the second reflector 103B is formed on the back surface (lower surface) of the substrate (wafer). Specifically, first, the back surface of the substrate to become the intermediate layer 100 is polished to be thinned. Subsequently, the material (for example, dielectric multilayer film or semiconductor multilayer film) of the second reflector 103B is deposited on the back surface of the substrate by, for example, a vacuum vapor deposition method, a sputtering method, a CVD method, or the like. As a result, the second reflector 103B is formed (see Fig. 69C).

According to the surface-emitting element 10-22, effects similar to the surface-emitting element 10-5 according to Example 5 can be obtained, and since the intermediate layer 100 cannot be thickened, the heat dissipation is poor, but the thickness can be reduced.

### <23. Surface-emitting Element according to Example 23 of Embodiment of Present Technology>

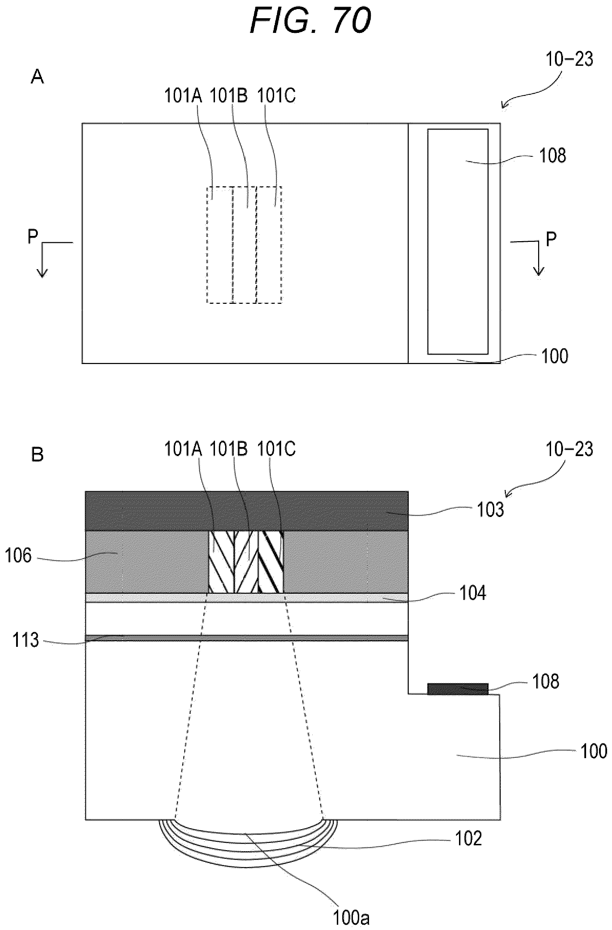

Hereinafter, a surface-emitting element according to Example 23 of the embodiment of the present technology will be described with reference to the drawings. Fig. 70A is a plan view of a surface-emitting element 10-23 according to Example 23 of the embodiment of the present technology, and Fig. 70B is a sectional view of the surface-emitting element 10-23 according to Example 23 of the embodiment of the present technology. Fig. 70B is a sectional view taken along line P-P in Fig. 70A.

The surface-emitting element 10-23 has a configuration substantially similar to the surface-emitting element 10-5 according to Example 5 except that an active layer 113 including an inorganic semiconductor is provided between the plurality of organic semiconductor layers 101 and the concave mirror 102 (for example, in the intermediate layer 100), the active layer 113 is caused to emit light by current excitation, and the plurality of organic semiconductor layers 101 is excited (photoexcited) by the light. Note that, the configuration in which the active layer 113 is arranged between the plurality of organic semiconductor layers 101 and the reflector 103 and the active layer 113 is excited by the current may be adopted.

As an example, the active layer 113 includes a five-layered multiple quantum well structure in which an In_{0.04}Ga_{0.96}N layer (barrier layer) and an In_{0.16}Ga_{0.84}N layer (well layer) are stacked, and is designed such that an emission wavelength is, for example, 405 nm.

In the surface-emitting element 10-23, each of the reflector 103 and the concave mirror 102 is a multilayer film reflector (for example, dielectric multilayer film reflector or semiconductor multilayer film reflector) having a high reflectance for light having a wavelength of, for example, 405 nm.

Note that, the emission wavelength of the active layer 113 may be, for example, a blue band, and each of the reflector 103 and the concave mirror 102 may be, for example, a multilayer film reflector (for example, dielectric multilayer film reflector or semiconductor multilayer film reflector) having a high reflectance for light having a wavelength in the blue band.

### <<Operation of Surface-emitting Element>>

In the surface-emitting element 10-23, a current flowing from the anode electrode (reflector 103) is injected into the active layer 113 through the plurality of organic semiconductor layers 101, the first transparent conductive film 104, and the upper portion of the intermediate layer 100. At this time, the active layer 113 emits light, the plurality of organic semiconductor layers 101 is irradiated with the light, and each organic semiconductor layer 101 is excited. At this time, the organic semiconductor layer 101 emits light, and the light reciprocates between the concave mirror 102 and the reflector 103 while being amplified by the organic semiconductor layer 101, and is emitted as laser light from the concave mirror 102 when the oscillation condition is satisfied. The current injected into the active layer 113 flows out from the cathode electrode (electrode member 108) through the lower portion of the intermediate layer 100.

### <<Method for Manufacturing Surface-emitting Element>>

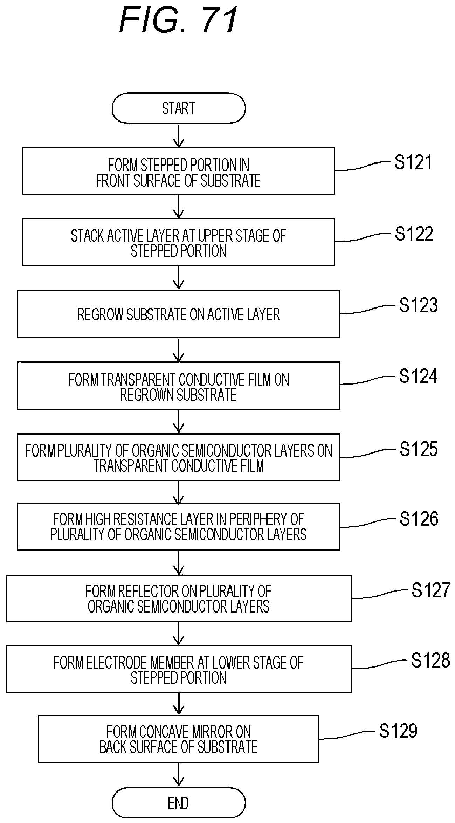

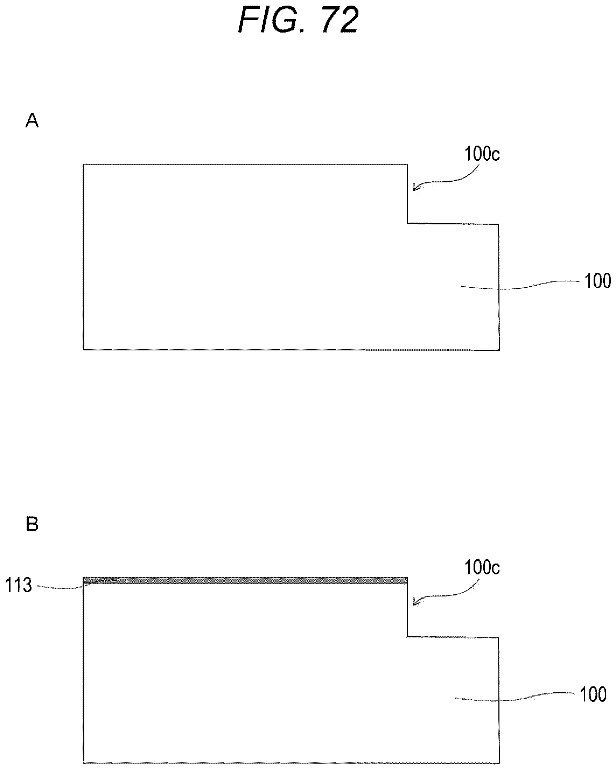

Hereinafter, a method for manufacturing the surface-emitting element 10-23 will be described with reference to the flowchart (steps S121 to S129) in Fig. 71 and the sectional views of Figs. 72A to 76B. Here, as an example, a plurality of surface-emitting elements 10-23 is simultaneously generated on one wafer (for example, GaN substrate) to become the base material of the intermediate layer 100. Subsequently, the plurality of surface-emitting elements 10-23 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-23 is two-dimensionally arranged on one wafer (for example, GaN substrate) to become the base material of the intermediate layer 100 and separating a plurality of integrated surface-emitting element arrays integrated in series from each other.

In first step S121, a stepped portion 100c is formed on the front surface of the substrate to become the intermediate layer 100 (see Fig. 72A). Specifically, a resist pattern covering a portion other than a portion where the stepped portion 100c is to be formed on the front surface of the substrate to become the intermediate layer 100 is formed, and then the intermediate layer 100 is etched by using the resist pattern as a mask to form the stepped portion 100c.

In next step S122, the active layer 113 is stacked at an upper stage of the stepped portion 100c (see Fig. 72B). Specifically, the material of the active layer 113 is deposited at the upper stage of the stepped portion 100c by, for example, a vacuum vapor deposition method, a sputtering method, a CVD method, or the like.

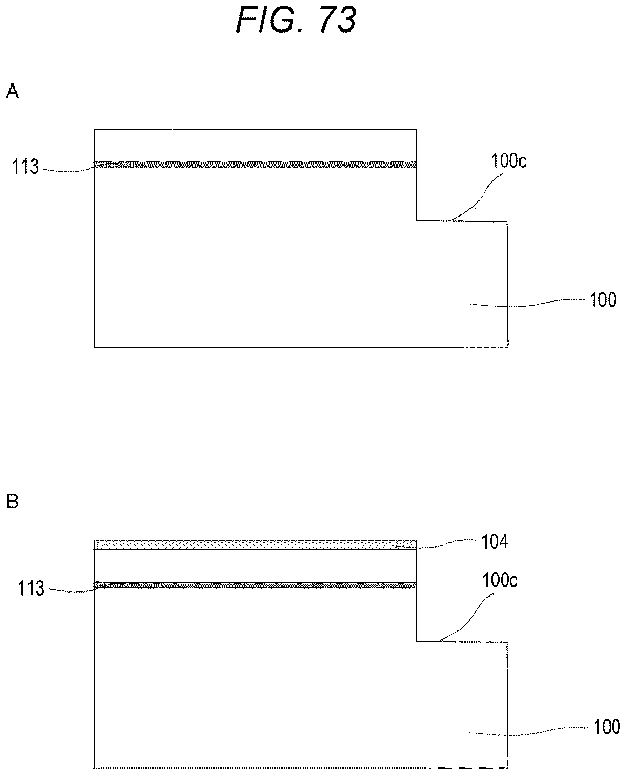

In next step S123, a substrate to become the intermediate layer 100 is regrown on the active layer 113 (see Fig. 73A).

In next step S124, the first transparent conductive film 104 is deposited on the regrown substrate (see Fig. 73B). Specifically, the first transparent conductive film 104 is deposited on the regrown substrate by, for example, a vacuum vapor deposition method, a sputtering method, a chemical vapor deposition (CVD) method, or the like.

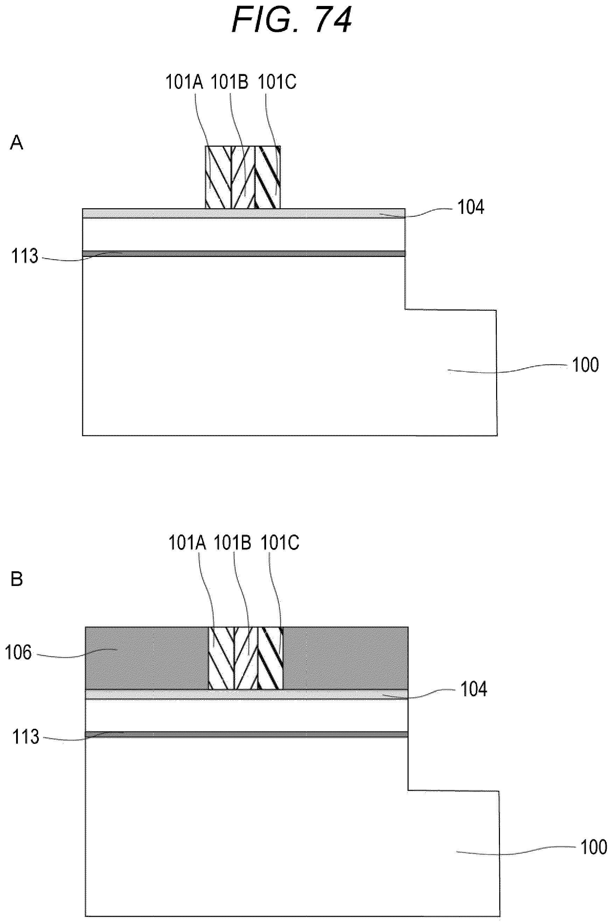

In next step S125, a plurality of organic semiconductor layers 101 is formed on the first transparent conductive film 104 (see Fig. 74A). Specifically, the plurality of organic semiconductor layers 101 is formed on the first transparent conductive film 104 in the same manner as in step S24 of the flowchart of Fig. 19.

In next step S126, the high resistance layer 106 is formed in the periphery of the plurality of organic semiconductor layers 101 (see Fig. 74B). Specifically, a high resistance material to be the high resistance layer 106 is deposited to cover the plurality of organic semiconductor layers 101 and the first transparent conductive film 104, and then only a portion covering the organic semiconductor 101 including the material is removed by etching using a mask to expose the organic semiconductor layer 101.

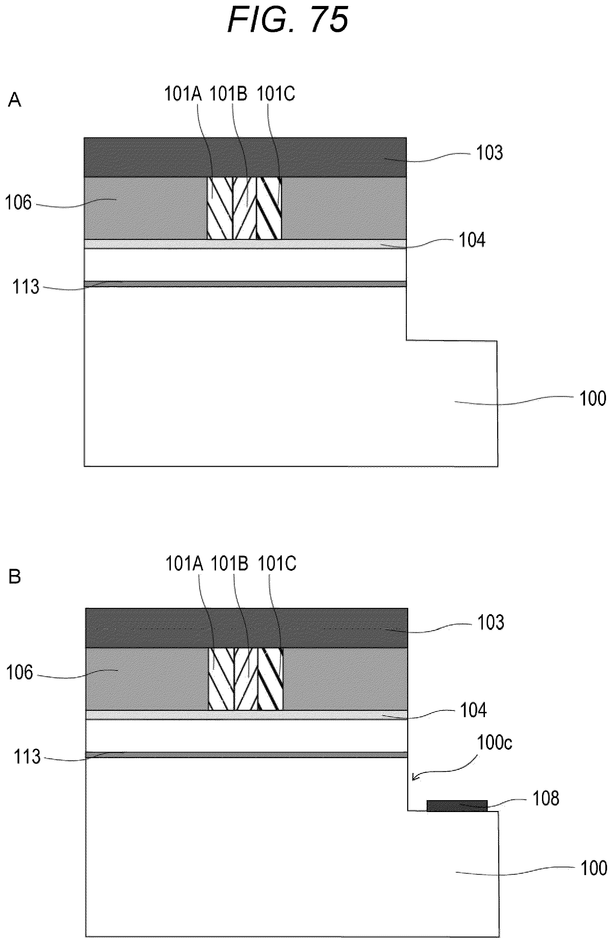

In next step S127, the reflector 103 is formed on the plurality of organic semiconductor layers 101 (see Fig. 75A). Specifically, the material of the reflector 103 is deposited on the plurality of organic semiconductor layers 101 and the high resistance layer 106 by, for example, a vacuum vapor deposition method, a sputtering method, a CVD method, or the like (see Fig. 75A) .

In next step S128, the electrode member 108 is formed at a lower stage of the stepped portion 100c (see Fig. 75B). Specifically, the electrode member 108 is formed at the lower stage of the stepped portion 100c by using, for example, a lift-off method.

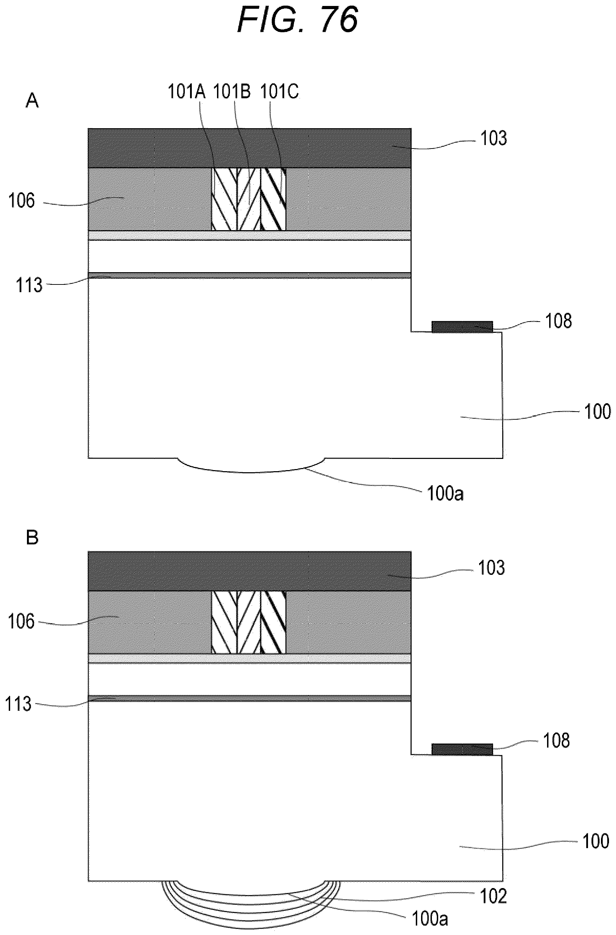

In final step S129, the concave mirror 102 is formed on the back surface (lower surface) of the substrate (wafer). Specifically, first, the back surface of the substrate to become the intermediate layer 100 is polished to be thinned, and then the back surface is etched (for example, dry-etched) to form the convex surface 100a (see Fig. 76A). Subsequently, a material (for example, a dielectric multilayer film) of the concave mirror 102 is deposited on the convex surface 100a by, for example, a vacuum vapor deposition method, a sputtering method, a CVD method, or the like. As a result, the concave mirror 102 having a shape following the convex surface 100a is formed (see Fig. 76B). Note that, since heat generated at the time of forming the concave mirror 102 is quickly released to the outside via the intermediate layer 100, the temperature of each organic semiconductor layer 101 can be maintained at, for example, 100°C or lower, and deterioration of each organic semiconductor layer 101 due to heat can be suppressed.

According to the surface-emitting element 10-23, effects similar to the surface-emitting element 10-5 according to Example 5 are obtained, and since each organic semiconductor layer 101 is caused to emit light by photoexcitation, an electrode (for example, second transparent conductive film 105) for applying a voltage to the organic semiconductor layer 101 is unnecessary, and thus, it is possible to suppress the occurrence of damage to each organic semiconductor layer 101 due to heat at the time of manufacturing.

### <24. Surface-emitting Element according to Example 24 of Embodiment of Present Technology>

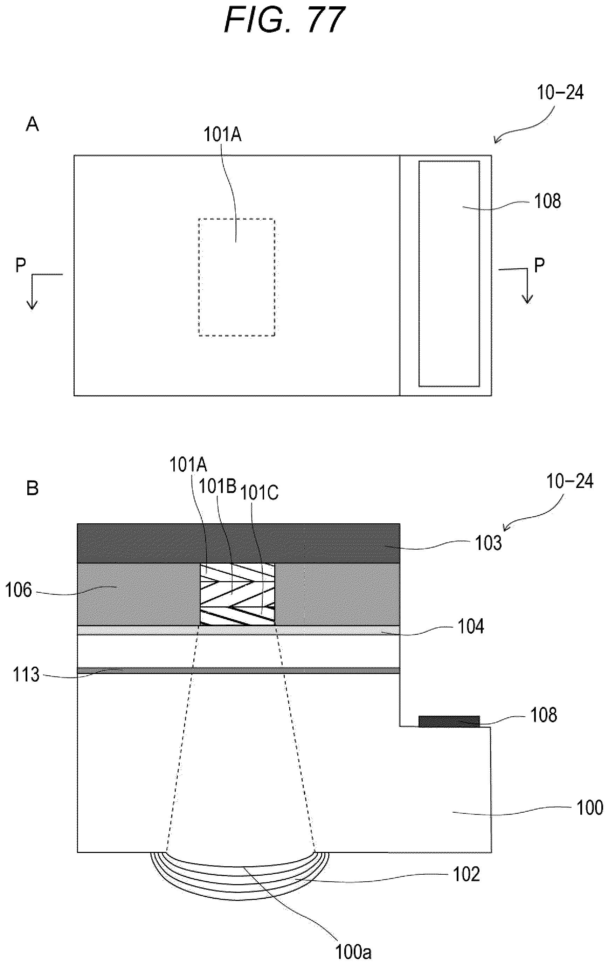

Hereinafter, a surface-emitting element according to Example 24 of the embodiment of the present technology will be described with reference to the drawings. Fig. 77A is a plan view of a surface-emitting element 10-24 according to Example 24 of the embodiment of the present technology, and Fig. 77B is a sectional view of the surface-emitting element 10-24 according to Example 24 of the embodiment of the present technology. Fig. 77B is a sectional view taken along line P-P in Fig. 77A.

The surface-emitting element 10-24 has a configuration similar to the surface-emitting element 10-23 according to Example 23 except that the plurality of organic semiconductor layers 101 (for example, first to third organic semiconductor layers 101A, 101B, and 101C) is stacked in the up-down direction.

In the surface-emitting element 10-24, the first organic semiconductor layer 101A that emits red light, the second organic semiconductor layer 101B that emits green light, and the third organic semiconductor layer 101C that emits blue light are arranged in this order from the reflector 103 side (upper side). Therefore, each organic semiconductor layer 101 is arranged to substantially coincide with the position of the antinode of the standing wave of the corresponding light, and the light amplification effect can be enhanced. Note that, the disposition of the plurality of organic semiconductor layers 101 may be reversed upside down depending on the position of the antinode of the standing wave.

The surface-emitting element 10-24 can be manufactured by a substantially manufacturing method by performing an operation similar to the surface-emitting element 10-23 according to Example 23.

According to the surface-emitting element 10-24, effects similar to the surface-emitting element 10-23 can be obtained, and a highly efficient surface-emitting element can be realized.

### <25. Surface-emitting Element according to Example 25 of Embodiment of Present Technology>

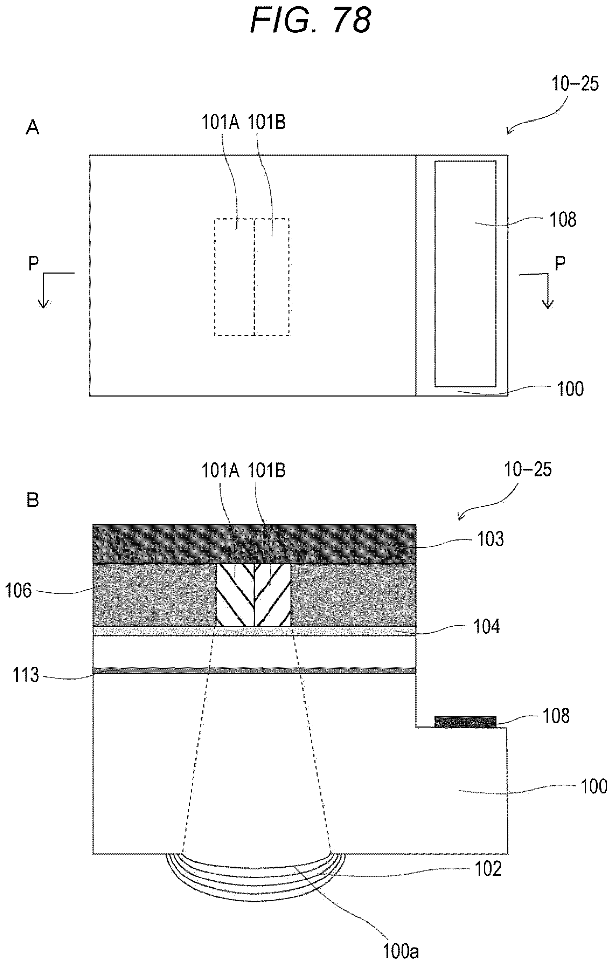

Hereinafter, a surface-emitting element according to Example 25 of the embodiment of the present technology will be described with reference to the drawings. Fig. 78A is a plan view of a surface-emitting element 10-25 according to Example 25 of the embodiment of the present technology, and Fig. 78B is a sectional view of the surface-emitting element 10-25 according to Example 25 of the embodiment of the present technology. Fig. 78B is a sectional view taken along line P-P in Fig. 78A.

The surface-emitting element 10-25 has a configuration similar to the surface-emitting element 10-23 according to Example 23 except that the plurality of organic semiconductor layers 101 is two organic semiconductor layers 101 (for example, first and second organic semiconductor layers 101A and 101B), that is, the third organic semiconductor layer 101C is not included.

The surface-emitting element 10-25 can be manufactured by a substantially similar manufacturing method by performing an operation similar to the surface-emitting element 10-23 according to Example 23.

According to the surface-emitting element 10-25, combined light of two colors of light (for example, red light and green light) can be emitted.

### <26. Surface-emitting Element according to Example 26 of Embodiment of Present Technology>

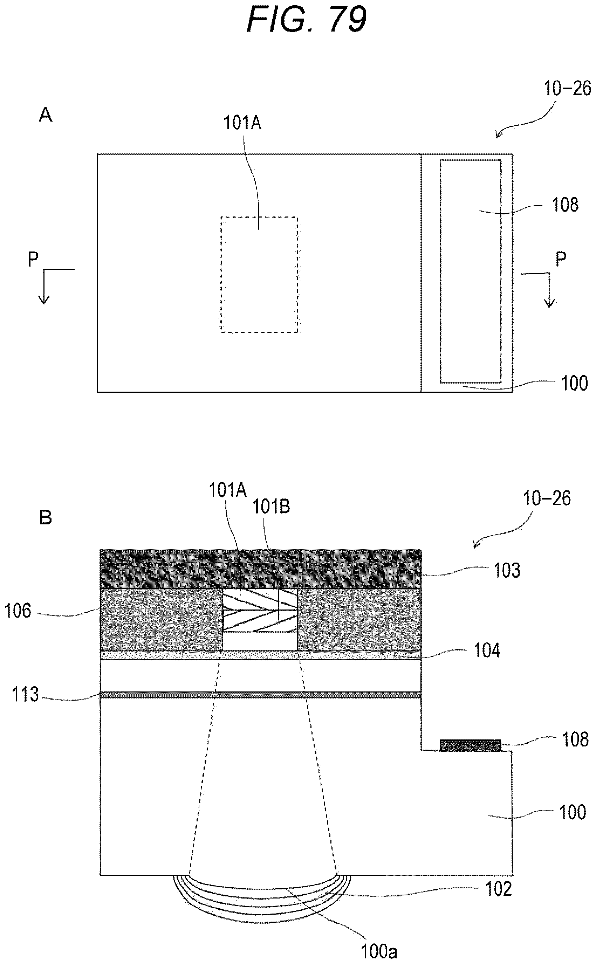

Hereinafter, a surface-emitting element according to Example 26 of the embodiment of the present technology will be described with reference to the drawings. Fig. 79A is a plan view of a surface-emitting element 10-26 according to Example 26 of the embodiment of the present technology, and Fig. 79B is a sectional view of the surface-emitting element 10-26 according to Example 26 of the embodiment of the present technology. Fig. 79B is a sectional view taken along line P-P in Fig. 79A.

The surface-emitting element 10-26 has a configuration similar to the surface-emitting element 10-24 according to Example 24 except that the plurality of organic semiconductor layers 101 is two stacked organic semiconductor layers 101 (for example, first and second organic semiconductor layers 101A and 101B), that is, the third organic semiconductor layer 101C is not included.

In the surface-emitting element 10-26, a portion where the third organic semiconductor layer 101C is provided in the surface-emitting element 10-24 according to Example 24 is, for example, a part (regrowth portion) of the intermediate layer 100. In this case, for example, if the first transparent conductive film 104 is not provided, the number of times of regrowth of the intermediate layer 100 can be set to 1.

The surface-emitting element 10-26 can be manufactured by a substantially similar manufacturing method by performing an operation similar to the surface-emitting element 10-24 according to Example 24.

According to the surface-emitting element 10-26, combined light of two colors of light (for example, red light and green light) can be emitted with high efficiency.

### <27. Surface-emitting Element according to Example 27 of Embodiment of Present Technology>

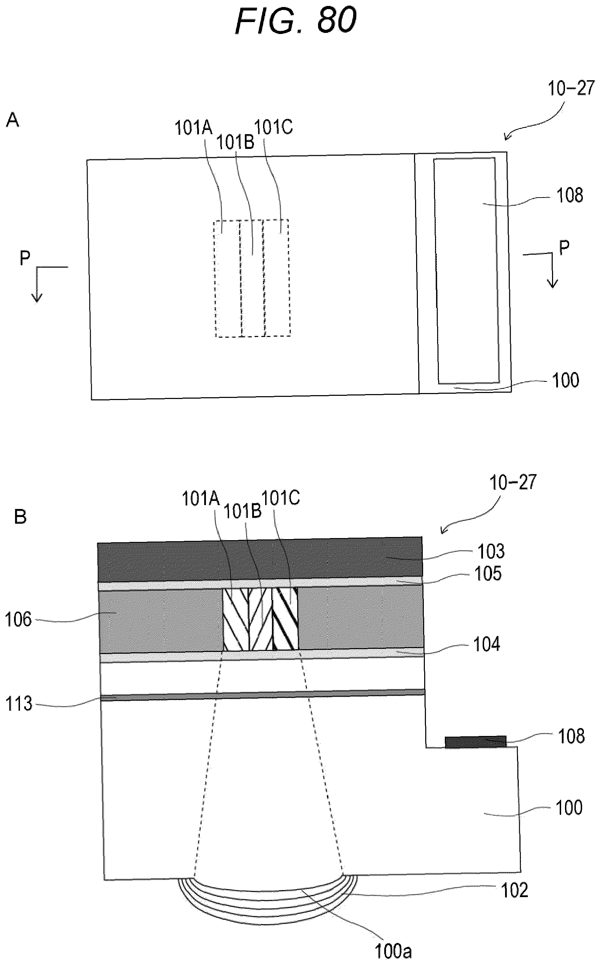

Hereinafter, a surface-emitting element according to Example 27 of the embodiment of the present technology will be described with reference to the drawings. Fig. 80A is a plan view of a surface-emitting element 10-27 according to Example 27 of the embodiment of the present technology, and Fig. 80B is a sectional view of the surface-emitting element 10-27 according to Example 27 of the embodiment of the present technology. Fig. 80B is a sectional view taken along line P-P in Fig. 80A.

The surface-emitting element 10-27 has a configuration similar to the surface-emitting element 10-23 according to Example 23 except that the second transparent conductive film 105 is included.

The surface-emitting element 10-27 can be manufactured by a substantially similar manufacturing method by performing an operation similar to the surface-emitting element 10-23 according to Example 23.

### <<Effects of Surface-emitting Element>>

According to the surface-emitting element 10-27, effects similar to the surface-emitting element 10-23 according to Example 23 can be obtained, and the injection efficiency of the carriers (for example, holes) into the plurality of organic semiconductor layers 101 can be increased, and the light emission intensity of each organic semiconductor layer 101 can be increased.

### <28. Surface-emitting Element according to Example 28 of Embodiment of Present Technology>

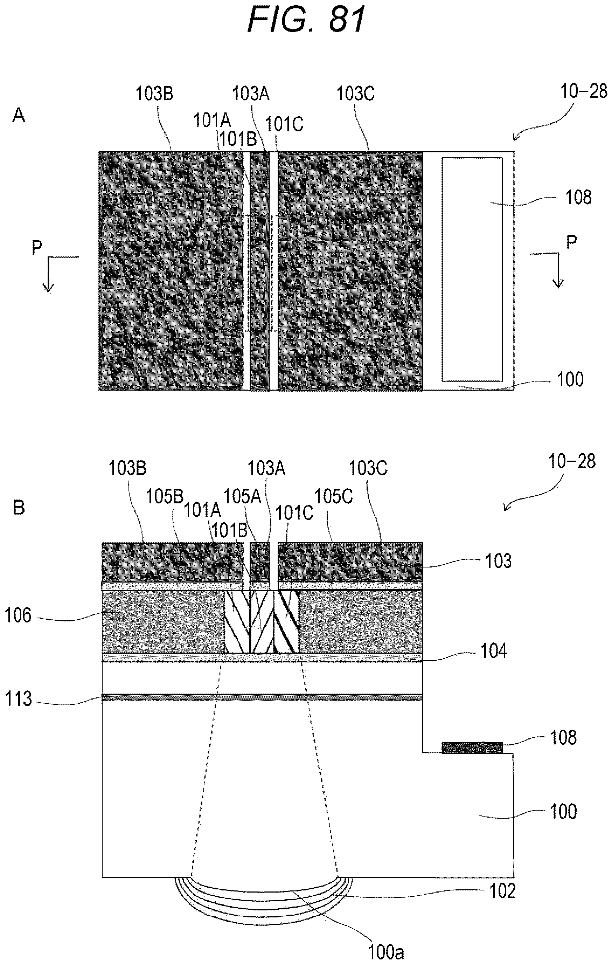

Hereinafter, a surface-emitting element according to Example 28 of the embodiment of the present technology will be described with reference to the drawings. Fig. 81 is a plan view of a surface-emitting element 10-28 according to Example 28 of the embodiment of the present technology, and Fig. 81B is a sectional view of the surface-emitting element 10-28 according to Example 28 of the embodiment of the present technology. Fig. 81B is a sectional view taken along line P-P in Fig. 81A.

As illustrated in Figs. 81A and 81B, the surface-emitting element 10-28 has a configuration similar to the surface-emitting element 10-27 according to Example 27 except that voltages can be individually applied to the plurality of organic semiconductor layers 101 (for example, first to third organic semiconductor layers 101A, 101B, and 101C).

The surface-emitting element 10-28 includes first to third reflectors 103A, 103B, and 103C corresponding to the first to third organic semiconductor layers 101A, 101B, and 101C, and three second transparent conductive films 105A, 105B, and 105C corresponding to the first to third organic semiconductor layers 101A, 101B, and 101C.

The surface-emitting element 10-28 can be manufactured by a substantially similar manufacturing method by performing an operation similar to the surface-emitting element 10-27 according to Example 27.

According to the surface-emitting element 10-28, effects similar to the surface-emitting element 10-27 according to Example 27 are obtained, and since the voltages can be individually applied to the plurality of organic semiconductor layers 101, light of desired color (for example, any one of red light, green light and blue light, or combined light of at least two light rays) can be emitted. Furthermore, in the surface-emitting element 10-8, the color of the emitted light that is the combined light can be adjusted by setting the drive voltages applied to the plurality of organic semiconductor layers 101 to be different.

### <29. Surface-emitting Element according to Example 29 of Embodiment of Present Technology>

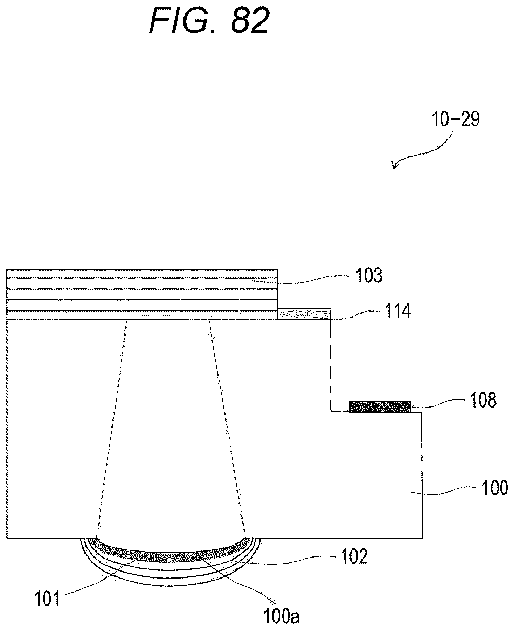

Hereinafter, a surface-emitting element according to Example 29 of the embodiment of the present technology will be described with reference to the drawings. Fig. 82 is a sectional view of a surface-emitting element 10-29 according to Example 29 of the embodiment of the present technology.

As illustrated in Fig. 82, the surface-emitting element 10-29 has a configuration substantially similar to the surface-emitting element 10-3 according to Example 3 except that the organic semiconductor layer 101 is arranged between the intermediate layer 100 and the concave mirror 102 and the high resistance layer 106 is not included.

In the surface-emitting element 10-29, an interval between the organic semiconductor layer 101 and the concave mirror 102 is narrower than an interval between the organic semiconductor layer 101 and the reflector 103.

In the surface-emitting element 10-29, as an example, a multilayer film reflector (dielectric multilayer film reflector or semiconductor multilayer film reflector) as the reflector 103 is provided at the upper stage of the stepped portion provided in the intermediate layer 100, and a transparent electrode member 114 to become an anode electrode is provided on a side surface side of the reflector 103. The electrode member 108 to become as a cathode electrode is provided at the lower stage of the stepped portion of the intermediate layer 100. The transparent electrode member 114 includes a transparent conductive film.

The multilayer film reflector as the reflector 103 is designed to have a reflectance slightly lower than the concave mirror 102, and is a reflector on the emission side. Note that, the reflectance of the reflector 103 may be slightly higher than the reflectance of the concave mirror 102, and the concave mirror 102 may be used as a reflector on the emission side.

### <<Operation of Surface-emitting Element>>

In the surface-emitting element 10-29, a current flowing from the transparent electrode member 114 as the anode electrode is injected into the organic semiconductor layer 101 via the intermediate layer 100. At this time, the organic semiconductor layer 101 emits light, and the light reciprocates between the concave mirror 102 and the reflector 103 while being amplified by the organic semiconductor layer 101, and is emitted as laser light from the reflector 103 when the oscillation condition is satisfied. The current injected into the organic semiconductor layer 101 flows out from the electrode member 108 as the cathode electrode via the intermediate layer 100.

### <<Method for Manufacturing Surface-emitting Element>>

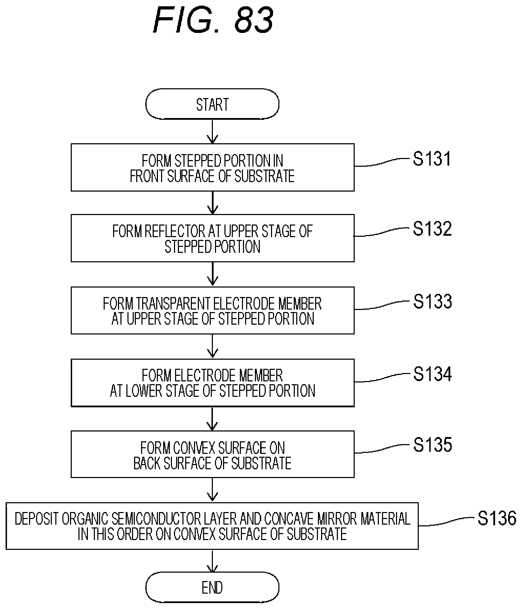

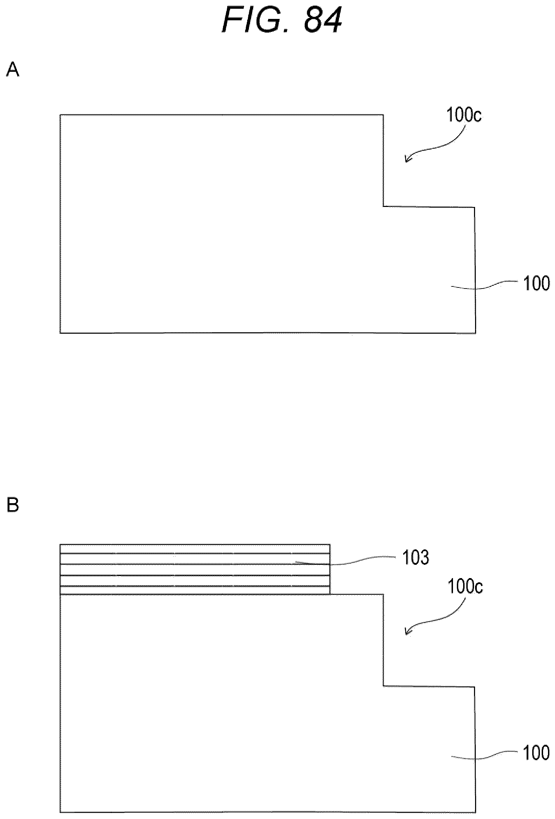

Hereinafter, a method for manufacturing the surface-emitting element 10-29 will be described with reference to the flowchart (steps S131 to S135) in Fig. 83 and the sectional views of Figs. 84A to 86B. Here, as an example, a plurality of surface-emitting elements 10-29 is simultaneously generated on one wafer (for example, GaN substrate) to become the base material of the intermediate layer 100. Subsequently, the plurality of surface-emitting elements 10-29 integrated in series is separated from each other to obtain the plurality of chip-shaped surface-emitting elements (surface-emitting element chips). Note that, it is also possible to simultaneously generate a plurality of chip-shaped surface-emitting element arrays (surface-emitting element array chips) by simultaneously generating the plurality of surface-emitting element arrays in which the plurality of surface-emitting elements 10-29 is two-dimensionally arranged on one wafer (for example, GaN substrate) to become a base material of the intermediate layer 100 and separating a plurality of integrated surface-emitting element arrays integrated in series from each other.

In first step S131, the stepped portion 100c is formed on the front surface of the substrate to become the intermediate layer 100 (see Fig. 84A). Specifically, a resist pattern covering a portion other than a portion where the stepped portion 100c is to be formed on the front surface of the substrate to become the intermediate layer 100 is formed, and then the intermediate layer 100 is etched by using the resist pattern as a mask to form the stepped portion 100c.

In next step S132, the reflector 103 is formed at the upper stage of the stepped portion 100c (see Fig. 84B). Specifically, the material (dielectric or semiconductor) of the reflector 103 is deposited at the upper stage of the stepped portion 100c by, for example, a vacuum vapor deposition method, a sputtering method, a CVD method, or the like.

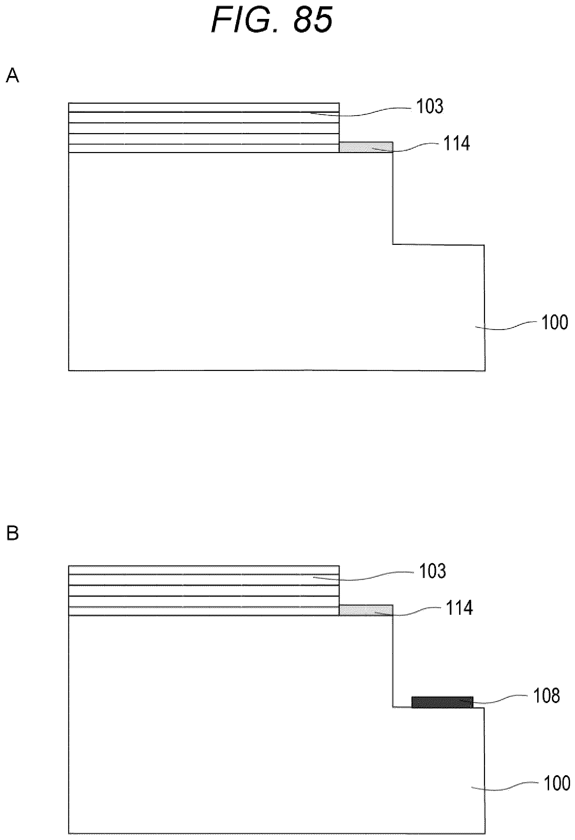

In next step S133, the transparent electrode member 114 is formed at the upper stage of the stepped portion 100c (see Fig. 85A). Specifically, the transparent electrode member 114 is patterned on the side surface side of the reflector 103 by using, for example, a photolithography method.

In next step S134, the electrode member 108 is formed at the lower stage of the stepped portion 100c by using, for example, a lift-off method (see Fig. 85B).

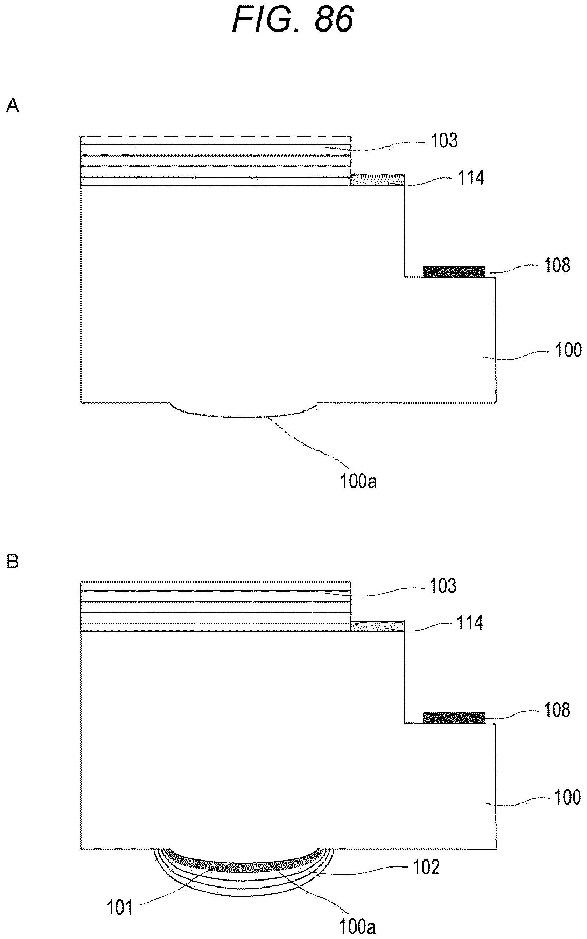

In next step S135, the convex surface 100a is formed on the back surface of the substrate to become the intermediate layer 100. Specifically, first, the back surface of the substrate to become the intermediate layer 100 is polished to be thinned, and then the back surface is etched (for example, dry-etched) to form the convex surface 100a (see Fig. 86A).

In final step S136, the organic semiconductor layer 101 and the concave mirror material are deposited in this order on the convex surface 100a of the substrate to become the intermediate layer 100. Specifically, the organic semiconductor layer 101 is deposited on the convex surface 100a by, for example, vacuum deposition, coating, or the like. Subsequently, the material (for example, dielectric multilayer film) of the concave mirror 102 is deposited on the organic semiconductor layer 101 by, for example, a vacuum vapor deposition method, a sputtering method, a CVD method, or the like. As a result, the organic semiconductor layer 101 and the concave mirror 102 having shapes following the convex surface 100a are formed (see Fig. 86B).

### <<Effects of Surface-emitting Element>>

According to the surface-emitting element 10-29, since the organic semiconductor layer 101 is arranged between the intermediate layer 100 and the concave mirror 102, the light reflected by the concave mirror 102 can be reliably incident on the organic semiconductor layer 101 regardless of the thickness of the intermediate layer 100 and the power of the concave mirror 102. In this case, the degree of freedom in selecting the thickness of the intermediate layer 100 and the power of the concave mirror 102 is high. Furthermore, in the surface-emitting element 10-29, since a current density of the current injected into the organic semiconductor layer 101 is not high, a high output cannot be expected, but damage caused by heat applied to the organic semiconductor layer 101 at the time of driving is small, and long lifespan can be expected.

### <30. Surface-emitting Element according to Example 30 of Embodiment of Present Technology>

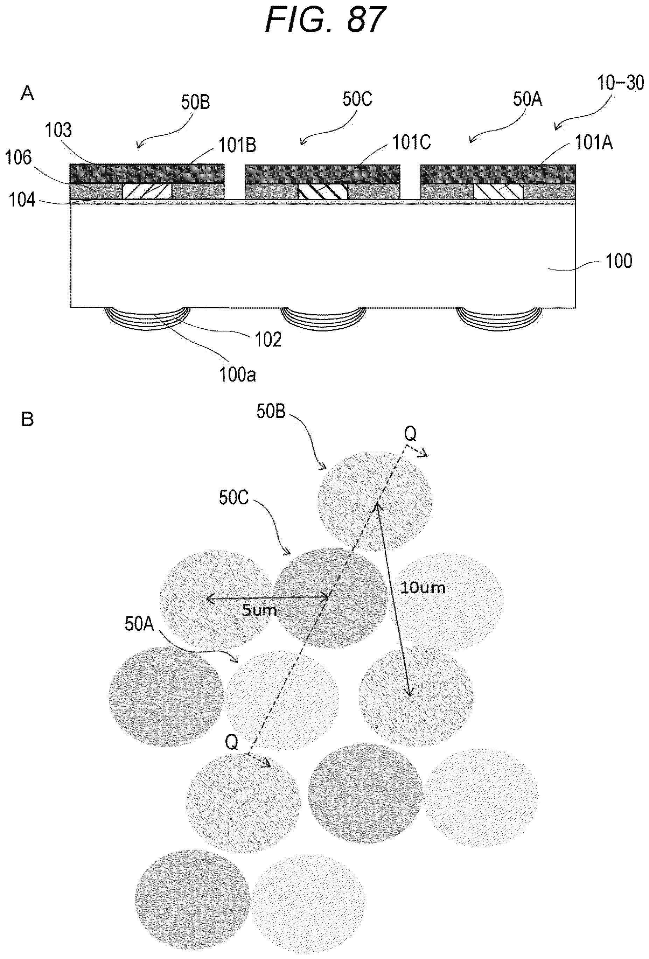

Hereinafter, a surface-emitting element according to Example 30 of the embodiment of the present technology will be described with reference to the drawings. Fig. 87A is a sectional view of a surface-emitting element 10-30 according to Example 30 of the embodiment of the present technology. Fig. 87B is a plan view of the surface-emitting element 10-30 according to Example 30 of the embodiment of the present technology. Fig. 87A is a sectional view taken along line Q-Q in Fig. 87B.

As illustrated in Figs. 87A and 87B, the surface-emitting element 10-30 includes a plurality of light emitting element portions 50 (for example, the plurality of light emitting element portions 50 including the first to third light emitting element portions 50A, 50B, and 50C) arranged in the array shape (for example, two-dimensionally arranged), and constitutes the surface-emitting laser array as a whole.

The organic semiconductor layers 101 of at least two light emitting element portions 50 among the plurality of light emitting element portions 50 may have different emission wavelengths. As an example, the first light emitting element portion 50A has the first organic semiconductor layer 101A that emits red light, the second light emitting element portion 50B has the second organic semiconductor layer 101B that emits green light, and the third light emitting element portion 50C has the third organic semiconductor layer 101 C that emits blue light. That is, the emission wavelengths of the organic semiconductor layers 101 of the first to third light emitting element portions 50A, 50B, and 50C are different.

In the surface-emitting element 10-30, as an example, the plurality of light emitting element portions 50 has separate reflectors 103 to become the anode electrodes, and the first transparent conductive film 104 is a cathode electrode common to the plurality of light emitting element portions 50. Accordingly, voltages can be individually applied to the plurality of organic semiconductor layers 101, and the plurality of light emitting element portions 50 can be individually driven.

In the surface-emitting element 10-30, as an example, as illustrated in Fig. 87B, in a case where the plurality of light emitting element portions 50 is arranged in a staggered arrangement, for example, three light emitting element portions 50 that, respectively, emit light rays of three colors are arranged in order at a pitch of, for example, 5 µm, and thus, the pitch of the light emitting element portions 50 that emit the same color can be set to, for example, 10 µm.

The surface-emitting element 10-30 can be manufactured by a manufacturing method similar to the surface-emitting element 10-1 according to Example 1.

### <<Effects of Surface-emitting Element>>

According to the surface-emitting element 10-30, since the plurality of light emitting element portions 50 that emits light rays of different colors shares the same substrate as the intermediate layer 100, it is possible to realize a surface-emitting laser array formed in a monolithic manner capable of emitting laser light rays of different colors (for example, R, G, and B) or combined light of at least two colors.

### <31. Modification of Present Technology>

The present technology is not limited to each example described above, and various modifications can be made.

The number, shape, disposition, and emission wavelength of the organic semiconductor layers can be appropriately changed.

For example, the surface-emitting element according to the present technology may include the plurality of organic semiconductor layers having different emission wavelengths, may include the plurality of organic semiconductor layers having different volumes, may include the plurality of organic semiconductor layers arranged in the in-plane direction, or may include the plurality of organic semiconductor layers arranged in the stacking direction. Moreover, the organic semiconductor layer may include the plurality of layers having different emission wavelengths, may include the plurality of layers having different volumes, may include the plurality of layers arranged in the in-plane direction, or may include the plurality of layers arranged in the stacking direction. In a case where the organic semiconductor layer has the plurality of layers as described above, at least two layers among the plurality of layers may be provided in the same element portion or may be provided in different element portions.

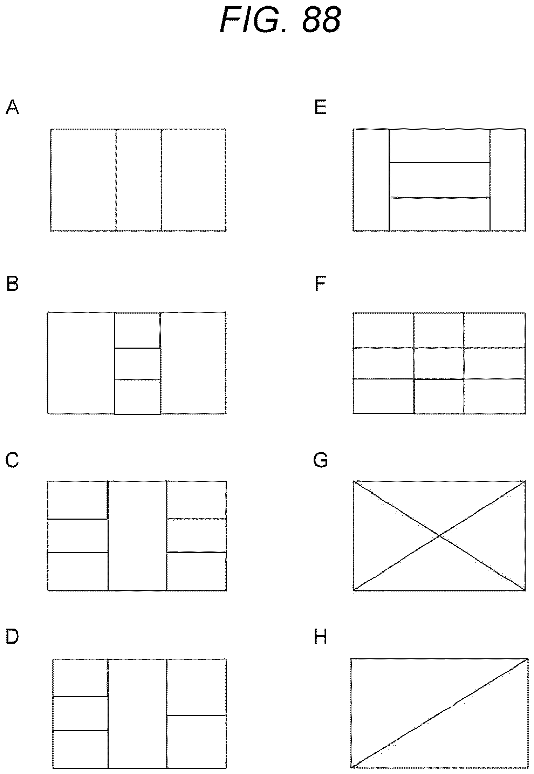

For example, each of Figs. 88A to 88H illustrates a planar configuration example of the plurality of organic semiconductor layers. In each drawing of Figs. 88A to 88H, a line inside a largest figure (rectangle) indicates a boundary between adjacent organic semiconductor layers.

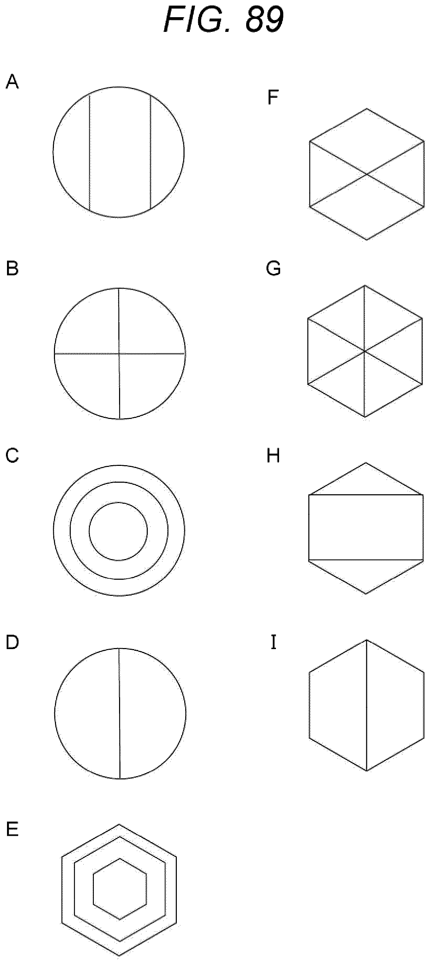

For example, each of Figs. 89A to 89I illustrates a planar configuration example of the plurality of organic semiconductor layers. In each drawing of Figs. 89A to 89I, a line inside a largest figure (circle or regular hexagon) indicates a boundary between adjacent organic semiconductor layers.

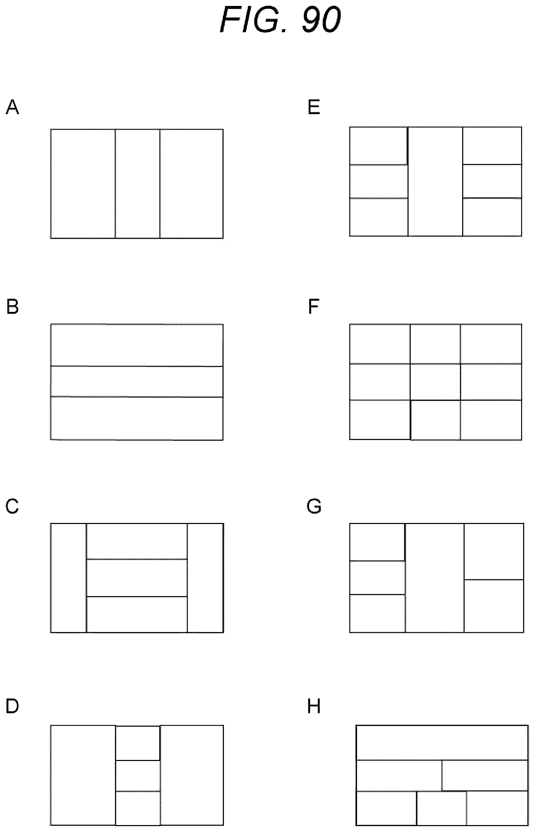

For example, each of Figs. 90A to 90H illustrates a sectional configuration example of the plurality of organic semiconductor layers. In each drawing of Figs. 90A to 90H, a line inside a largest figure (rectangle) indicates a boundary between adjacent organic semiconductor layers.

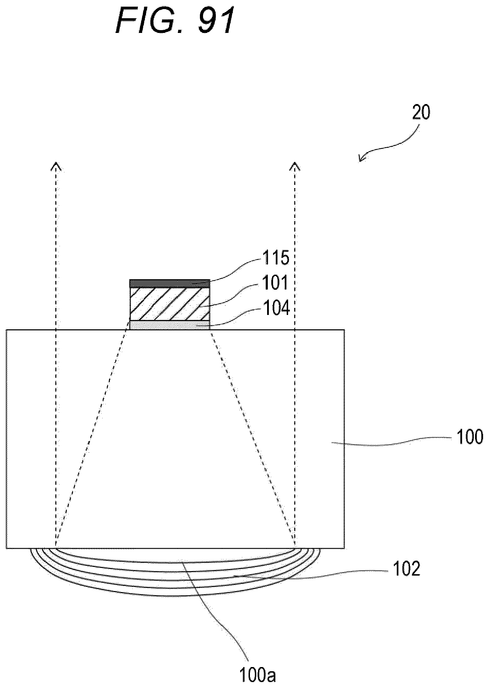

The surface-emitting element according to the present technology is not limited to the surface-emitting laser, and can be applied to, for example, a light emitting diode (LED). For example, the surface-emitting element 20 of the modification illustrated in Fig. 91 has a configuration substantially similar to the surface-emitting element 10-1 according to Example 1 except that the reflector 103 and the high resistance layer 106 are not included and the electrode member 115 including a metal or an alloy is included instead of the second transparent conductive film 105. The surface-emitting element 20 functions as an LED or a superluminescent diode (SLD). In the surface-emitting element 20, when a current is injected into the organic semiconductor layer 101 via the electrode member 115 as the anode electrode, light is emitted from the organic semiconductor layer 101 to the intermediate layer 100 side. This light is emitted to the outside from the front surface (upper surface) of the intermediate layer 100, as light (for example, weakly diffused light, parallel light, or focused light) suppressed from spreading by the concave mirror 102. In the surface-emitting element 20, a sufficient heat dissipation effect by the intermediate layer 100 is obtained. Furthermore, in the present structure in which the organic semiconductor layer 101 and the concave mirror 102 are coupled, it is possible to enhance light emission by a parcel effect or the like, control a polarization direction, control a radiation angle of an emission beam, and the like. In particular, in a case where a diffraction grating is used for the concave mirror, polarization control can be performed.

In the surface-emitting element according to each of the examples and modifications described above, the concave mirror 102 and the organic semiconductor layer 101 are integrally formed, but may be separately formed. That is, the concave mirror 102 may be an external reflector. For example, the concave mirror 102 and the intermediate layer 100 may be integrally formed, and the organic semiconductor layer 101 may be provided on a substrate different from the intermediate layer 100.

Some of the configurations of the surface-emitting elements in each of the examples and the modifications described above may be combined in a range not inconsistent with each other.

In each of the examples and modifications described above, the material, thickness, width, length, shape, size, disposition, and the like of each component constituting the surface-emitting element can be appropriately changed within a range functioning as the surface-emitting element.

### <32. Application Example to Electronic Device>

The technology according to the present disclosure (the present technology) can be applied to various products (electronic devices). For example, the technology according to the present disclosure may further be realized as a device (for example, a distance measuring device, a shape recognition device, or the like) to be mounted on any type of mobile bodies such as vehicles, electric vehicles, hybrid electric vehicles, motorcycles, bicycles, personal mobilities, airplanes, drones, ships, and robots.

The surface-emitting element and the light source device including the surface-emitting element according to the present technology can also be applied as, for example, a light source or a display of a device that forms or displays an image by laser light (for example, laser printer, laser copier, projector, head-mounted display, head-up display, or the like).

### <33. Example in which Light Source Device having Surface-Emitting Element is applied to Distance Measuring Device>

Hereinafter, application examples of the surface-emitting element according to each of the embodiments and modifications described above will be described.

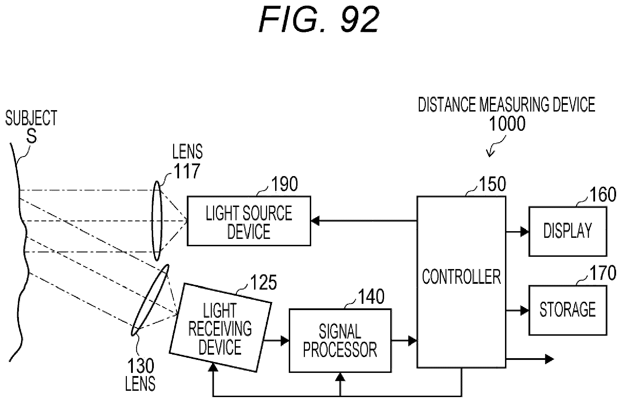

Fig. 92 illustrates an example of a schematic configuration of a distance measuring device 1000 including a light source device 190 having the surface-emitting element 10-1 as an example of an electronic device according to the present technology. The distance measuring device 1000 measures a distance to a subject S by a time of flight (TOF) method. The distance measuring device 1000 includes the light source device 190 as a light source. The distance measuring device 1000 includes, for example, the light source device 190, a light receiving device 125, lenses 117 and 130, a signal processor 140, a controller 150, a display 160, and a storage 170.

In addition to the surface-emitting element 10-1, the light source device 190 includes a laser driver (driver) that drives the light emitting element portion 50 of the surface-emitting element 10-1. The laser driver has an anode terminal and a cathode terminal connected to an anode electrode and a cathode electrode of the surface-emitting element 10-1, respectively, via a wiring. The laser driver includes, for example, circuit elements such as a capacitor and a transistor.

The light receiving device 125 detects light reflected by the subject S. The lens 117 is a lens for collimating the light emitted from the surface-emitting element 10-1, and is a collimating lens. The lens 130 is a lens for condensing light reflected by the subject S and guiding the light to the light receiving device 125, and is a condenser lens.

The signal processor 140 is a circuit for generating a signal corresponding to a difference between a signal input from the light receiving device 125 and a reference signal input from the controller 150. The controller 150 includes, for example, a time-to-digital converter (TDC). The reference signal may be a signal input from the controller 150, or may be an output signal of a detector that directly detects an output of the surface-emitting element 10-1. The controller 150 is, for example, a processor that controls the light source device 190, the light receiving device 125, the signal processor 140, the display 160, and the storage 170. The controller 150 is a circuit that measures a distance to the subject S on the basis of a signal generated by the signal processor 140. The controller 150 generates a video signal for displaying information about the distance to the subject S, and outputs the video signal to the display 160. The display 160 displays the information about the distance to the subject S on the basis of the video signal input from the controller 150. The controller 150 stores the information about the distance to the subject S in the storage 170.

In the present application example, instead of the surface-emitting element 10-1, any one of the surface-emitting elements 10-2 to 10-30, and 20 described above can be applied to the distance measuring device 1000. Note that, in a case where the surface-emitting element having the plurality of light emitting element portions 50 is applied to the distance measuring device 1000, a driver capable of individually driving the plurality of light emitting element portions 50 can also be used.

### <34. Example in which Distance Measuring Device is Mounted on Mobile Body>

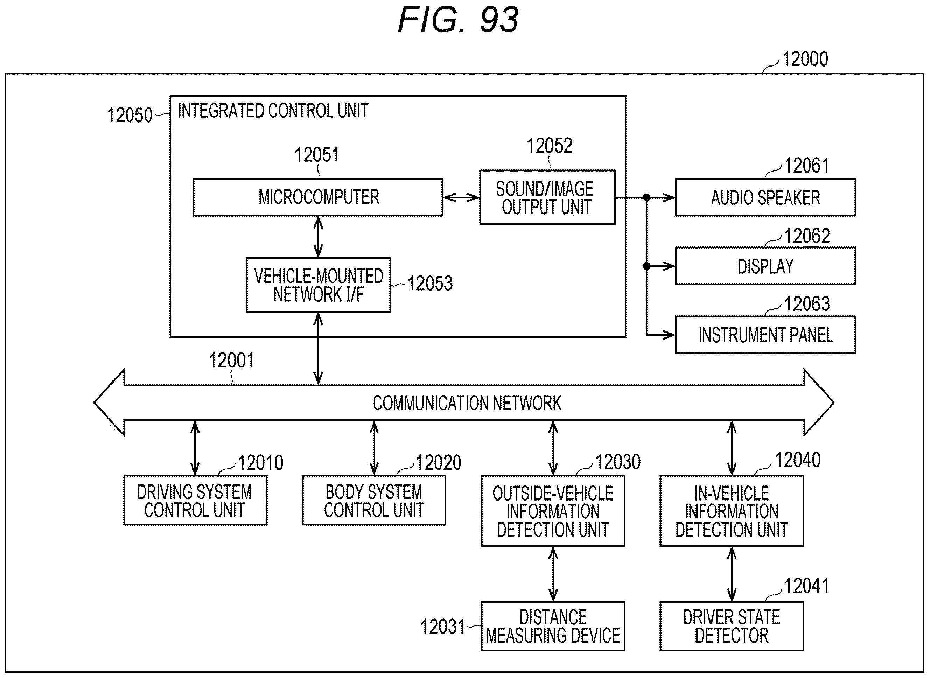

Fig. 93 is a block diagram illustrating a schematic configuration example of a vehicle control system being an example of a mobile body control system to which the technology according to the present disclosure can be applied.

A vehicle control system 12000 includes a plurality of electronic control units connected to each other via a communication network 12001. In the example illustrated in Fig. 93, the vehicle control system 12000 includes a driving system control unit 12010, a body system control unit 12020, an outside-vehicle information detection unit 12030, an in-vehicle information detection unit 12040, and an integrated control unit 12050. Furthermore, a microcomputer 12051, a sound/image output unit 12052, and a vehicle-mounted network interface (I/F) 12053 are illustrated as a functional configuration of the integrated control unit 12050.

The driving system control unit 12010 controls operations of devices related to a driving system of the vehicle in accordance with various kinds of programs. For example, the driving system control unit 12010 functions as a control device for a driving force generating device for generating a driving force of the vehicle, such as an internal combustion engine, a driving motor, or the like, a driving force transmitting mechanism for transmitting the driving force to wheels, a steering mechanism for adjusting a steering angle of the vehicle, a braking device for generating a braking force of the vehicle, and the like.

The body system control unit 12020 controls operations of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detection unit 12030 detects information about the outside of the vehicle including the vehicle control system 12000. For example, a distance measuring device 12031 is connected to the outside-vehicle information detection unit 12030. The distance measuring device 12031 includes the above-described distance measuring device 1000. The outside-vehicle information detection unit 12030 causes the distance measuring device 12031 to measure a distance to an object (subject S) outside the vehicle, and acquires distance data obtained by the measurement. The outside-vehicle information detection unit 12030 may perform object detection processing of a person, a car, an obstacle, a sign, or the like on the basis of the acquired distance data.

The in-vehicle information detection unit 12040 detects information about the inside of the vehicle. The in-vehicle information detection unit 12040 is, for example, connected with a driver state detector 12041 that detects a state of a driver. The driver state detector 12041 includes, for example, a camera that images the driver. On the basis of detection information input from the driver state detector 12041, the in-vehicle information detection unit 12040 may calculate a degree of fatigue of the driver or a degree of concentration of the driver, or may discriminate whether the driver is dozing.

The microcomputer 12051 can calculate a control target value for the driving force generating device, the steering mechanism, or the braking device on the basis of the information about the inside or outside of the vehicle obtained by the outside-vehicle information detection unit 12030 or the in-vehicle information detection unit 12040, and can output a control command to the driving system control unit 12010. For example, the microcomputer 12051 can perform cooperative control intended to realize functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

Furthermore, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detection unit 12030 or the in-vehicle information detection unit 12040.

Furthermore, the microcomputer 12051 can output a control command to the body system control unit 12020 on the basis of the information about the outside of the vehicle obtained by the outside-vehicle information detection unit 12030. For example, the microcomputer 12051 can perform cooperative control intended to prevent a glare by controlling the headlamp to change from a high beam to a low beam, for example, in accordance with the position of a preceding vehicle or an oncoming vehicle detected by the outside-vehicle information detection unit 12030.

The sound/image output unit 12052 transmits an output signal of at least one of a sound or an image to an output device capable of visually or auditorily notifying an occupant of the vehicle or the outside of the vehicle of information. In the example of Fig. 93, an audio speaker 12061, a display 12062, and an instrument panel 12063 are illustrated as the output device. The display 12062 may, for example, include at least one of an on-board display or a head-up display.

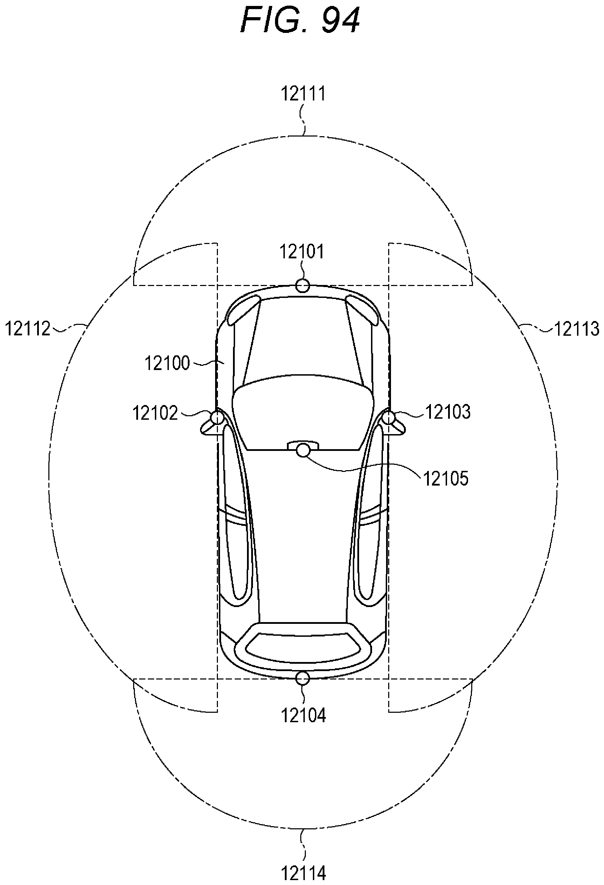

Fig. 94 is a diagram illustrating an example of an installation position of the distance measuring device 12031.

In Fig. 94, a vehicle 12100 includes distance measuring devices 12101, 12102, 12103, 12104, and 12105 as the distance measuring device 12031.

The distance measuring devices 12101, 12102, 12103, 12104, and 12105 are provided, for example, at positions such as a front nose, sideview mirrors, a rear bumper, a back door, and an upper portion of a windshield in a vehicle interior of the vehicle 12100. The distance measuring device 12101 provided on the front nose and the distance measuring device 12105 provided on the upper portion of the windshield in the vehicle cabin mainly acquire data of the front side of the vehicle 12100. The distance measuring devices 12102 and 12103 provided at the sideview mirrors mainly acquire data on the sides of the vehicle 12100. The distance measuring device 12104 provided on the rear bumper or the back door mainly acquires data behind the vehicle 12100. The data of the front acquired by the distance measuring devices 12101 and 12105 is mainly used for detecting a preceding vehicle, a pedestrian, an obstacle, a traffic light, a traffic sign, or the like.

Note that, Fig. 94 illustrates an example of detection ranges of the distance measuring devices 12101 to 12104. A detection range 12111 indicates a detection range of the distance measuring device 12101 provided on the front nose, detection ranges 12112 and 12113 indicate detection ranges of the distance measuring devices 12102 and 12103 provided at the sideview mirrors, respectively, and a detection range 12114 indicates a detection range of the distance measuring device 12104 provided on the rear bumper or the back door.

For example, the microcomputer 12051 can determine a distance to each three-dimensional object within the detection ranges 12111 to 12114 and a temporal change in the distance (a relative speed with respect to the vehicle 12100) on the basis of the distance data obtained from the distance measuring devices 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Moreover, the microcomputer 12051 can set a following distance to be maintained in front of a preceding vehicle in advance, and perform automated brake control (including following stop control), automated acceleration control (including following start control), or the like. It is thus possible to perform cooperative control intended for automated driving that makes the vehicle travel automatedly without depending on the operation of the driver or the like.

For example, on the basis of the distance data obtained from the distance measuring devices 12101 to 12104, the microcomputer 12051 can classify three-dimensional object data regarding three-dimensional objects into two-wheeled vehicles, standard-sized vehicles, large-sized vehicles, pedestrians, and other three-dimensional objects such as utility poles, extract the three-dimensional object data, and use the three-dimensional object data for automated avoidance of obstacles. For example, the microcomputer 12051 identifies obstacles in the periphery of the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display 12062, and performs forced deceleration or avoidance steering via the driving system control unit 12010. The microcomputer 12051 can thereby assist in driving to avoid collision.

An example of the mobile body control system to which the technology according to the present disclosure can be applied has been described above. The technology according to the present disclosure can be applied to the distance measuring device 12031 among the configurations described above.

Furthermore, the present technology can also have the following configurations.
(1) A surface-emitting element includes at least one light emitting element portion that includes
   at least one organic semiconductor layer, and
   a concave mirror arranged on one side of the organic semiconductor layer.
(2) In the surface-emitting element according to (1), the light emitting element portion further includes a reflector arranged on the other side of the organic semiconductor layer.
(3) In the surface-emitting element according to (2), an interval between the organic semiconductor layer and the concave mirror is wider than an interval between the organic semiconductor layer and the reflector.
(4) In the surface-emitting element according to (2), an interval between the organic semiconductor layer and the concave mirror is narrower than an interval between the organic semiconductor layer and the reflector.
(5) In the surface-emitting element according to any one of (1) to (4), the at least one organic semiconductor layer includes a plurality of organic semiconductor layers having different emission wavelengths.
(6) In the surface-emitting element according to any one of (1) to (5), the at least one organic semiconductor layer includes a plurality of organic semiconductor layers having different volumes.
(7) In the surface-emitting element according to any one of (1) to (6), the at least one organic semiconductor layer includes a plurality of organic semiconductor layers arranged in an in-plane direction.
(8) In the surface-emitting element according to any one of (1) to (7), the at least one organic semiconductor layer includes a plurality of organic semiconductor layers arranged in a stacking direction.
(9) In the surface-emitting element according to any one of (1) to (8), the at least one light emitting element portion includes a plurality of light emitting element portions arranged in an array shape, and the organic semiconductor layers of at least two light emitting element portions among the plurality of light emitting element portions have different emission wavelengths.
(10) In the surface-emitting element according to any one of (1) to (9), the at least one light emitting element portion includes a plurality of light emitting element portions arranged in an array shape, and the organic semiconductor layers of at least two light emitting element portions among the plurality of light emitting element portions have different positions in a stacking direction.
(11) In the surface-emitting element according to any one of (1) to (10), the concave mirror includes a metal and/or a dielectric.
(12) In the surface-emitting element according to any one of (1) to (11), the concave mirror includes a diffraction grating.
(13) In the surface-emitting element according to any one of (2) to (12), the reflector includes a diffraction grating.
(14) In the surface-emitting element according to any one of (1) to (13), the concave mirror has a structure in which a plurality of multilayer film reflectors corresponding to a plurality of wavelengths is stacked.
(15) In the surface-emitting element according to any one of (2) to (14), the reflector has a structure in which a plurality of multilayer film reflectors corresponding to a plurality of wavelengths is stacked.
(16) In the surface-emitting element according to any one of (1) to (15), the light emitting element portion further includes an intermediate layer arranged between the organic semiconductor layer and the concave mirror.
(17) In the surface-emitting element according to (16), the intermediate layer contains a nitride, an oxide, resin, a semiconductor, or an insulator.
(18) In the surface-emitting element according to (16) or (17), the intermediate layer has a mesa structure.
(19) In the surface-emitting element according to any one of (2) to (18) further includes an active layer that is arranged between the organic semiconductor layer and the concave mirror and/or between the organic semiconductor layer and the reflector, and emits excitation light that excites the organic semiconductor layer.
(20) In the surface-emitting element according to any one of (2) to (19), the light emitting element portion further includes a transparent conductive film arranged between the reflector and the organic semiconductor layer and/or between the concave mirror and the organic semiconductor layer.
(21) In the surface-emitting element according to any one of (1) to (20), the at least one light emitting element portion includes a plurality of light emitting element portions arranged in an array shape.
(22) A light source device includes the surface-emitting element according to any one of (1) to (21), and a driver that drives the light emitting element portion.
(23) A light source device includes the surface-emitting element according to (21), and drivers that individually drive the plurality of light emitting element portions.
(24) An electronic device includes the surface-emitting element according to any one of (1) to (21).
(25) An electronic device includes the light source device according to (22) or (23).

### REFERENCE SIGNS LIST

10-1 to 10-30, 20 Surface-emitting element
100 Intermediate layer
101 Organic semiconductor layer
101A First organic semiconductor layer (organic semiconductor layer)
101B Second organic semiconductor layer (organic semiconductor layer)
101C Third organic semiconductor layer (organic semiconductor layer)
102 Concave mirror
103 Reflector
104 First transparent conductive film (transparent conductive film)
105 Second transparent conductive film (transparent conductive film)
113 Active layer
190 Light source device

## Claims

1. A surface-emitting element comprising
at least one light emitting element portion that includes
at least one organic semiconductor layer, and
a concave mirror arranged on one side of the organic semiconductor layer.

2. The surface-emitting element according to claim 1, wherein the light emitting element portion further includes a reflector arranged on the other side of the organic semiconductor layer.

3. The surface-emitting element according to claim 2, wherein an interval between the organic semiconductor layer and the concave mirror is wider than an interval between the organic semiconductor layer and the reflector.

4. The surface-emitting element according to claim 2, wherein an interval between the organic semiconductor layer and the concave mirror is narrower than an interval between the organic semiconductor layer and the reflector.

5. The surface-emitting element according to claim 1, wherein the at least one organic semiconductor layer includes a plurality of organic semiconductor layers having different emission wavelengths.

6. The surface-emitting element according to claim 1, wherein the at least one organic semiconductor layer includes a plurality of organic semiconductor layers having different volumes.

7. The surface-emitting element according to claim 1, wherein the at least one organic semiconductor layer includes a plurality of organic semiconductor layers arranged in an in-plane direction.

8. The surface-emitting element according to claim 1, wherein the at least one organic semiconductor layer includes a plurality of organic semiconductor layers arranged in a stacking direction.

9. The surface-emitting element according to claim 1,
wherein the at least one light emitting element portion includes a plurality of light emitting element portions arranged in an array shape, and
the organic semiconductor layers of at least two light emitting element portions among the plurality of light emitting element portions have different emission wavelengths.

10. The surface-emitting element according to claim 1,
wherein the at least one light emitting element portion includes a plurality of light emitting element portions arranged in an array shape, and
the organic semiconductor layers of at least two light emitting element portions among the plurality of light emitting element portions have different positions in a stacking direction.

11. The surface-emitting element according to claim 1, wherein the concave mirror includes a metal and/or a dielectric.

12. The surface-emitting element according to claim 2, wherein the concave mirror and/or the reflector includes a diffraction grating.

13. The surface-emitting element according to claim 1, wherein the concave mirror has a structure in which a plurality of multilayer film reflectors corresponding to a plurality of wavelengths is stacked.

14. The surface-emitting element according to claim 1, wherein the light emitting element portion further includes an intermediate layer arranged between the organic semiconductor layer and the concave mirror.

15. The surface-emitting element according to claim 14, wherein the intermediate layer contains a nitride, an oxide, resin, a semiconductor, or an insulator.

16. The surface-emitting element according to claim 14, wherein the intermediate layer has a mesa structure.

17. The surface-emitting element according to claim 2, further comprising
an active layer that is arranged between the organic semiconductor layer and the concave mirror and/or between the organic semiconductor layer and the reflector, and emits excitation light that excites the organic semiconductor layer.

18. The surface-emitting element according to claim 2, wherein the light emitting element portion further includes a transparent conductive film arranged between the reflector and the organic semiconductor layer and/or between the concave mirror and the organic semiconductor layer.

19. The surface-emitting element according to claim 1, wherein the at least one light emitting element portion includes a plurality of light emitting element portions arranged in an array shape.

20. A light source device comprising:
the surface-emitting element according to claim 1; and
a driver that drives the light emitting element portion.
